# EUROPEAN PATENT APPLICATION

(11) **EP 4 665 126 A1**
(43) Date of publication of application: **17.12.2025**
(21) Application number: 23957124.3
(22) Date of filing: 31.10.2023
(51) Int. Cl.: H10K 59/121

(54) **DISPLAY PANEL AND MANUFACTURING METHOD THEREFOR, AND DISPLAY APPARATUS**

(71) Applicant: BOE TECHNOLOGY GROUP CO., LTD., Beijing 100015 (CN); Beijing BOE Technology Development Co., Ltd., Beijing 100176 (CN)
(72) Inventor: LI, Liuqing, Beijing 100176 (CN); LI, Xiaohu, Beijing 100176 (CN); LIU, Wenqi, Beijing 100176 (CN); LIU, Xiaoyun, Beijing 100176 (CN); WANG, Hongli, Beijing 100176 (CN); LIU, Xu, Beijing 100176 (CN); WU, Tong, Beijing 100176 (CN); LU, Xinhong, Beijing 100176 (CN); CAO, Zhanfeng, Beijing 100176 (CN)
(74) Representative: Brötz, Helmut
(86) International application number: PCT/CN2023/128501
(87) International publication number: WO 2025/091247

(57) **Abstract**

A display panel and a manufacturing method therefor, and a display apparatus. The display panel has a pixel region comprising a plurality of sub-pixel regions and a pixel spacing region located between adjacent sub-pixel regions, and comprises : a plurality of sub-pixels provided on a base substrate, each sub-pixel comprising a light-emitting device and a sub-pixel circuit configured to drive the light-emitting device to emit light, and each light-emitting device comprising a first electrode, a charge generation layer and a second electrode which are sequentially stacked; a pixel defining structure provided on the base substrate and having a plurality of sub-pixel openings to define light-emitting regions of the plurality of sub-pixels; and an isolation structure located in at least one of the pixel region and the pixel spacing region and comprising a portion having a first isolation height and a portion having a second isolation height, the second isolation height being greater than the first isolation height, and the charge generation layers of adjacent sub-pixels being disconnected from each other by at least one of the portion having the first isolation height and the portion having the second isolation height in the isolation structure.

## Description

### TECHNICAL FIELD

Embodiments of the present disclosure relate to a display panel, a manufacturing method thereof, and a display device.

### BACKGROUND

Organic Light-Emitting Diode (OLED) display panel is widely used in fields such as mobile phones and tablet computers as well as flexible wearable fields such as smart watches for its advantages such as self-luminescence, wide color gamut, high contrast, light weight and smaller thickness, etc., as compared with traditional liquid crystal display (LCD) panels. Compared with traditional OLED devices, Tandem OLED devices have been significantly improved in their luminous efficiency and service life, and have great application prospects in many display fields such as vehicle-mounted computers and notebook computers. Tandem OLED device has a high-mobility film such as charge generation layer. In an OLED display panel, an organic insulating material is usually used to form a pixel definition layer (PDL) to define light-emitting regions and separate sub-pixels of different colors. However, the traditional pixel definition layer may not be able to effectively separate different sub-pixels, and hence cannot effectively solve the cross-color problem. On the other hand, the traditional pixel definition layer may cause the cathodes of light-emitting devices of a plurality of sub-pixels to be disconnected, which, in turn, will lead to the disadvantages such as uneven brightness and high-power consumption of the display panel, and cannot meet the higher requirements of products.

### SUMMARY

At least one embodiment of the present disclosure provides a display panel, having a pixel region including a plurality of sub-pixel regions and a pixel spacing region between adjacent sub-pixel regions, and including: a base substrate; a plurality of sub-pixels, disposed on the base substrate and located in the plurality of sub-pixel regions respectively, wherein each of the plurality of sub-pixels includes a light-emitting device and a sub-pixel circuit configured to drive the light-emitting device to emit light, each light-emitting device includes a first electrode, a charge generation layer and a second electrode which are sequentially stacked, and the plurality of sub-pixels include a first sub-pixel, a second sub-pixel and a third sub-pixel which are adjacent to each other and configured to display different colors; a pixel definition structure, disposed on the base substrate and having a plurality of sub-pixel openings to define light-emitting regions of the plurality of sub-pixels, wherein each of the light-emitting devices has at least a portion located in a corresponding one of the plurality of sub-pixel openings; and an isolation structure, located in at least one of the pixel region and the pixel spacing region, and including a portion with a first isolation height and a portion with a second isolation height, wherein the second isolation height is larger than the first isolation height, and wherein charge generation layers of adjacent sub-pixels among the plurality of sub-pixels are disconnected from each other by at least one of the portion with the first isolation height and the portion with the second isolation height in the isolation structure.

In the display panel provided by at least one embodiment of the present disclosure, the light-emitting device of the first sub-pixel further includes a first light-emitting layer located on a side of the charge generation layer thereof close to the base substrate, the light-emitting device of the second sub-pixel further includes a second light-emitting layer located on a side of the charge generation layer thereof close to the base substrate, and the light-emitting device of the third sub-pixel further includes a third light-emitting layer located on a side of the charge generation layer thereof close to the base substrate; a thickness of the second light-emitting layer and a thickness of the third light-emitting layer are larger than a thickness of the first light-emitting layer; and the charge generation layer of the first sub-pixel and the charge generation layer of the second sub-pixel or the third sub-pixel adjacent to the first sub-pixel are disconnected from each other at least by the portion with the first isolation height in the isolation structure, and the charge generation layer of the second sub-pixel and the charge generation layer of the third sub-pixel are disconnected from each other by the portion with the second isolation height in the isolation structure.

In the display panel provided by at least one embodiment of the present disclosure, the portion with the first isolation height in the isolation structure includes an isolation part, which is disposed in at least one of a first sub-pixel region where the first sub-pixel is located and the pixel spacing region between the first sub-pixel and an adjacent sub-pixel; the portion with the second isolation height in the isolation structure at least includes an isolation part, which is disposed in the pixel spacing region between the second sub-pixel and the third sub-pixel.

In the display panel provided by at least one embodiment of the present disclosure, the portion with the second isolation height in the isolation structure further includes an isolation part, which is disposed in the pixel spacing region between the second sub-pixel and the first sub-pixel or disposed in the pixel spacing region between the third sub-pixel and the first sub-pixel.

In the display panel provided by at least one embodiment of the present disclosure, the isolation structure includes a plurality of pixel region isolation parts respectively located in the plurality of sub-pixel regions, and at least a first pixel region isolation part located in a first sub-pixel region among the plurality of pixel region isolation parts has the first isolation height.

In the display panel provided by at least one embodiment of the present disclosure, the plurality of pixel region isolation parts include a second pixel region isolation part and a third pixel region isolation part, which are respectively located in sub-pixel regions where the second sub-pixel and the third sub-pixel are located; and the second pixel region isolation part and the third pixel region isolation part each have the first isolation height, or at least a portion of the second pixel region isolation part and at least a portion of the third pixel region isolation part have the second isolation height.

In the display panel provided by at least one embodiment of the present disclosure, the isolation structure includes inter-pixel isolation parts located between adjacent sub-pixels, and the inter-pixel isolation parts include: a first inter-pixel isolation part, located between the first sub-pixel and the second sub-pixel or located in the pixel spacing region between the first sub-pixel and the third sub-pixel; and a second inter-pixel isolation part, located in the pixel spacing region between the second sub-pixel and the third sub-pixel.

In the display panel provided by at least one embodiment of the present disclosure, the first inter-pixel isolation part and the second inter-pixel isolation part have a same isolation height which is the second isolation height.

In the display panel provided by at least one embodiment of the present disclosure, the first inter-pixel isolation part has the first isolation height, and the second inter-pixel isolation part has the second isolation height.

In the display panel provided by at least one embodiment of the present disclosure, the first inter-pixel isolation part and the second inter-pixel isolation part are connected to each other or disconnected from each other, and the inter-pixel isolation parts include an annular portion in a closed ring shape or an open ring shape, and the light-emitting regions of one or more sub-pixels among the plurality of sub-pixels are surrounded by the annular portion in a direction parallel to a main surface of the base substrate.

In the display panel provided by at least one embodiment of the present disclosure, at least one of the first inter-pixel isolation part and the second inter-pixel isolation part each includes a plurality of isolation sub-parts arranged side by side between adjacent sub-pixels along an arrangement direction of the adjacent sub-pixels.

In the display panel provided by at least one embodiment of the present disclosure, the isolation structure includes: a first annular part, surrounding the light-emitting region of a corresponding one sub-pixel among the plurality of sub-pixels in a direction parallel to a main surface of the base substrate; and a second annular part, located on a side of the first annular part away from the corresponding one sub-pixel and surrounding the first annular part and the corresponding one sub-pixel in a direction parallel to the main surface of the base substrate.

In the display panel provided by at least one embodiment of the present disclosure, the plurality of sub-pixels include a plurality of pixel units arranged in an array and include: a first pixel column, including a plurality first sub-pixels arranged in a first direction; and a second pixel column, including a plurality of second sub-pixels and a plurality of third sub-pixels alternately arranged along the first direction, wherein one or more first pixel columns and one or more second pixel columns are alternately arranged along a second direction intersecting with the first direction, wherein each first sub-pixel in the first pixel column as well as one second sub-pixel and one third sub-pixel in the second pixel column are adjacent to each other and constitute one pixel unit, wherein each of the light-emitting regions of the plurality of sub-pixels is surrounded by a corresponding isolation part in the isolation structure in an arrangement direction of the plurality of sub-pixels.

In the display panel provided by at least one embodiment of the present disclosure, the isolation structure includes at least one of a plurality of pixel region isolation parts and inter-pixel isolation parts; the plurality of pixel region isolation parts respectively surround the light-emitting regions of the plurality of sub-pixels in a direction parallel to a main surface of the base substrate; the inter-pixel isolation parts include: a first inter-pixel isolation part, extending along the first direction and located, in the second direction, between the first pixel column and second pixel column that are adjacent to each other; and a second inter-pixel isolation part, extending along the second direction and located, in the first direction, between a second sub-pixel and a third sub-pixel that are adjacent to each other.

In the display panel provided by at least one embodiment of the present disclosure, the first inter-pixel isolation part continuously extends along the first direction and is connected to a plurality of second inter-pixel isolation parts; or the first inter-pixel isolation part and the second inter-pixel isolation part are disconnected from each other, and the first inter-pixel isolation part has an opening and includes a plurality of first inter-pixel isolation sub-parts disconnected from each other, and each first inter-pixel isolation sub-part is located between a corresponding first sub-pixel and an adjacent second sub-pixel and/or between the corresponding first sub-pixel and an adjacent third sub-pixel.

In the display panel provided by at least one embodiment of the present disclosure, an orthographic projection of the first sub-pixel on a first reference plane extending along the first direction and an orthographic projection of the second sub-pixel on the first reference plane have a first overlapping portion, and the orthographic projection of the first sub-pixel on the first reference plane and an orthographic projection of the third sub-pixel on the first reference plane have a second overlapping portion; an orthographic projection of the opening of the first inter-pixel isolation part on the first reference plane is offset from the first overlapping portion and the second overlapping portion, and the first overlapping portion and the second overlapping portion are respectively located in orthographic projections of corresponding first inter-pixel isolation sub-parts on the first reference plane.

In the display panel provided by at least one embodiment of the present disclosure, an overlapping portion of orthographic projections, on a second reference plane extending along the second direction, of adjacent second and third sub-pixels located in a same second pixel column, is located within an orthographic projection of the second inter-pixel isolation part on the second reference plane.

In the display panel provided by at least one embodiment of the present disclosure, further including a common electrode structure, and the second electrodes of the plurality of sub-pixels share the common electrode structure, wherein the common electrode structure includes: a second electrode layer, disposed on a side of the charge generation layer away from the base substrate; and an auxiliary electrode layer, disposed on a side of the second electrode layer away from the base substrate and electrically connected to the second electrode layer, wherein an orthographic projection of the auxiliary electrode layer on the base substrate overlaps with an orthographic projection of the isolation structure on the base substrate.

In the display panel provided by at least one embodiment of the present disclosure, an orthographic projection of at least a portion of the isolation structure on the base substrate is located within the orthographic projection of the auxiliary electrode layer on the base substrate.

In the display panel provided by at least one embodiment of the present disclosure, the second electrode layer includes portions disconnected at the isolation structure, and the portions of the second electrode layer that are disconnected are electrically connected to each other through the auxiliary electrode layer.

In the display panel provided by at least one embodiment of the present disclosure, the auxiliary electrode layer includes at least one of a first auxiliary electrode layer and a second auxiliary electrode layer; the first auxiliary electrode layer extends in the pixel region and the pixel spacing region, and an orthographic projection of the second electrode layer on the base substrate is located within an orthographic projection of the first auxiliary electrode layer on the base substrate; and an orthographic projection of the second auxiliary electrode layer on the base substrate overlaps with an orthographic projection of at least a portion of the isolation structure on the base substrate, and is offset from an orthographic projection of at least a portion of the light-emitting regions of the plurality of sub-pixels on the base substrate.

In the display panel provided by at least one embodiment of the present disclosure, including a light-emitting stacked layer, the light-emitting stacked layer including: a first light-emitting stack part, at least including the charge generation layer of the first sub-pixel; a second light-emitting stack part, at least including the charge generation layer of the second sub-pixel; a third light-emitting stack part, at least including the charge generation layer of the third sub-pixel; and a dummy stack part, located between adjacent light-emitting stack parts among the first light-emitting stack part, the second light-emitting stack part and the third light-emitting stack part, wherein the first light-emitting stack part, the second light-emitting stack part and the third light-emitting stack part each include a first stack sub-part and a second stack sub-part; in each light-emitting stack part, the first stack sub-part is located in the light-emitting region defined by a sub-pixel opening of the pixel definition structure, and the second stack sub-part is located on a side, away from the base substrate, of a portion of the pixel definition structure that defines the sub-pixel opening.

In the display panel provided by at least one embodiment of the present disclosure, the charge generation layers of the first stack sub-part and the second stack sub-part of the first light-emitting stack part are disconnected from each other by a first pixel region isolation part of the isolation structure.

In the display panel provided by at least one embodiment of the present disclosure, a height difference between the charge generation layers of the first stack sub-part and the second stack sub-part of the first light-emitting stack part in a direction perpendicular to a main surface of the base substrate is defined by the first isolation height.

In the display panel provided by at least one embodiment of the present disclosure, the charge generation layers of the first stack sub-part and the second stack sub-part of the first light-emitting stack part are connected to each other.

In the display panel provided by at least one embodiment of the present disclosure, the charge generation layers of the first stack sub-part and the second stack sub-part of the second light-emitting stack part are connected to each other or disconnected from each other; the charge generation layers of the first stack sub-part and the second stack sub-part of the third light-emitting stack part are connected to each other or disconnected from each other.

In the display panel provided by at least one embodiment of the present disclosure, the dummy stack part includes: a first dummy stack part, located in the pixel spacing region between the first sub-pixel and the second sub-pixel adjacent to each other and including a first dummy charge generation layer, wherein the first dummy charge generation layer is disconnected from the charge generation layers in the first light-emitting stack part and the second light-emitting stack part by a first inter-pixel isolation part of the isolation structure.

In the display panel provided by at least one embodiment of the present disclosure, a height difference between the first dummy charge generation layer and the charge generation layer of the second stack sub-part in the first light-emitting stack part or in the second light-emitting stack part in a direction perpendicular to a main surface of the base substrate is defined by the first isolation height or the second isolation height.

In the display panel provided by at least one embodiment of the present disclosure, the dummy stack part includes: a second dummy stack part, located in the pixel spacing region between the second sub-pixel and the third sub-pixel adjacent to each other and including a second dummy charge generation layer, wherein the second dummy charge generation layer is disconnected from the charge generation layers in the second light-emitting stack part and the third light-emitting stack part by a second inter-pixel isolation part of the isolation structure.

In the display panel provided by at least one embodiment of the present disclosure, a height difference between the second dummy charge generation layer and the charge generation layer of the second stack sub-part in the second light-emitting stack part or in the third light-emitting stack part in a direction perpendicular to a main surface of the base substrate is defined by the second isolation height.

In the display panel provided by at least one embodiment of the present disclosure, at least one dummy stack part is connected to a dummy electrode, and the dummy electrode and the first electrode are arranged in a same electrode layer and are electrically isolated from each other.

In the display panel provided by at least one embodiment of the present disclosure, the pixel definition structure at least includes a first pixel definition layer and a second pixel definition layer, wherein the second pixel definition layer is located on a side of the first pixel definition layer away from the base substrate and includes an extension part which extends beyond an edge of the first pixel definition layer in a direction parallel to a main surface of the base substrate, and an undercut structure is disposed between the extension part and a material layer located at a side of the first pixel definition layer close to the base substrate, the isolation structure at least includes the extension part and the undercut structure.

In the display panel provided by at least one embodiment of the present disclosure, further including: a planarization structure, disposed on the base substrate, wherein a plurality of first electrodes of the plurality of sub-pixels are located on a side of the planarization structure away from the base substrate; the pixel definition structure is located on a side of the planarization structure and the plurality of first electrodes away from the base substrate, and the plurality of sub-pixel openings respectively expose portions of the plurality of first electrodes, wherein the pixel definition structure further includes an isolation opening, which is located in the pixel spacing region between adjacent sub-pixels and exposes a portion of a surface of the planarization structure.

In the display panel provided by at least one embodiment of the present disclosure, the pixel definition structure includes: a sub-pixel opening definition part, defining a sub-pixel opening and serving as a pixel region isolation part of the isolation structure, wherein the sub-pixel opening definition part includes a first extension part, and a first undercut structure is disposed between the first extension part and the first electrode; and an isolation opening definition part, defining the isolation opening and serving as an inter-pixel isolation part of the isolation structure, wherein the isolation opening definition part includes a second extension part, and a second undercut structure is disposed between the second extension part and the planarization structure.

In the display panel provided by at least one embodiment of the present disclosure, the planarization structure has a recess which is in spatial communication with the isolation opening, and the second isolation height is defined by a sum of a depth of the isolation opening and a depth of the recess.

In the display panel provided by at least one embodiment of the present disclosure, further including a dummy electrode, located between the planarization structure and the isolation opening definition part, wherein the dummy electrode has an electrode opening which is in spatial communication with the isolation opening, and the second isolation height is defined by a sum of a depth of the isolation opening and a depth of the electrode opening.

In the display panel provided by at least one embodiment of the present disclosure, the pixel definition structure further includes: a pixel definition body layer, located at a side of the first pixel definition layer close to the base substrate, defining the plurality of sub-pixel openings, and including a first body part located between the first sub-pixel and the second sub-pixel adjacent to the first sub-pixel or between the first sub-pixel and the third sub-pixel adjacent to the first sub-pixel, and a second body part located between the second sub-pixel and the third sub-pixel, wherein the first pixel definition layer and the second pixel definition layer include a first isolation part and a second isolation part respectively located on the first body part and the second body part, each of the first isolation part and the second isolation part includes the extension part of the second pixel definition layer, and the undercut structure is disposed between the extension part and the pixel definition body layer.

In the display panel provided by at least one embodiment of the present disclosure, the first isolation part has a first isolation opening which exposes a portion of a surface of the first body part, and the first isolation height is defined by a depth of the first isolation opening; and the second isolation part has a second isolation opening which exposes a portion of a surface of the second body part, and the second body part has a body recess which is in spatial communication with the second isolation opening, and the second isolation height is defined by a sum of a depth of the second isolation opening and a depth of the body recess.

In the display panel provided by at least one embodiment of the present disclosure, the pixel definition structure includes a plurality of pixel definition layers stacked in sequence in a direction perpendicular to a main surface of the base substrate, and the second pixel definition layer is a farthest layer from the base substrate among the plurality of pixel definition layers, and the pixel definition structure includes a sub-pixel opening definition part and an isolation opening definition part; in the sub-pixel opening definition part, sidewalls of the plurality of pixel definition layers are connected to each other and together constitute a sidewall defining the sub-pixel opening; the isolation opening definition part includes the extension part and the undercut structure that constitute the isolation structure.

In the display panel provided by at least one embodiment of the present disclosure, the pixel definition structure includes: a first pixel stack part, located between the first sub-pixel and the second sub-pixel and having a first recess, wherein the first recess includes one or more first isolation openings; and a second pixel stack part, located between the second sub-pixel and the third sub-pixel and having a second recess, wherein the second recess includes one or more second isolation openings; wherein each of the first pixel stack part and the second pixel stack part has an edge portion being served as a sub-pixel opening definition part to define a portion of a corresponding sub-pixel opening, and has a portion defining a recess being served as an isolation opening definition part, and the isolation opening definition part includes an extension part of one or more pixel definition layers and one or more undercut structures.

In the display panel provided by at least one embodiment of the present disclosure, a depth of the first recess is smaller than a depth of the second recess.

In the display panel provided by at least one embodiment of the present disclosure, the pixel definition structure includes a plurality of first pixel definition layers and a plurality of second pixel definition layers alternately stacked in a direction perpendicular to a main surface of the base substrate, and includes a plurality of undercut structures, and wherein each of the plurality of undercut structures is located at a side of an extension part of a corresponding second pixel definition layer close to the base substrate.

In the display panel provided by at least one embodiment of the present disclosure, the first pixel definition layer and the second pixel definition layer include different materials.

In the display panel provided by at least one embodiment of the present disclosure, at least one of the first pixel definition layer and the second pixel definition layer includes an inorganic material.

In the display panel provided by at least one embodiment of the present disclosure, one of the first pixel definition layer and the second pixel definition layer includes aluminum oxide, and the other one of the first pixel definition layer and the second pixel definition layer includes silicon nitride or silicon oxide; or one of the first pixel definition layer and the second pixel definition layer includes silicon oxide, and the other one of the first pixel definition layer and the second pixel definition layer includes silicon carbonitride; or one of the first pixel definition layer and the second pixel definition layer includes titanium oxide, and the other one of the first pixel definition layer and the second pixel definition layer includes niobium oxide.

In the display panel provided by at least one embodiment of the present disclosure, a width of the undercut structure in a direction parallel to a main surface of the base substrate ranges from 0.05 µm to 0.5 µm.

In the display panel provided by at least one embodiment of the present disclosure, the first isolation height ranges from 300 angstroms to 1250 angstroms, and the second isolation height ranges from 600 angstroms to 1650 angstroms.

At least one embodiment of the present disclosure provides a display device, including any one of the above-mentioned display panels.

At least one embodiment of the present disclosure provides a manufacturing method of a display panel, wherein the display panel has a pixel region including a plurality of sub-pixel regions and a pixel spacing region located between adjacent sub-pixel regions, and the manufacturing method includes: providing a base substrate; forming a plurality of sub-pixels on the base substrate, wherein the plurality of sub-pixels are respectively located in the plurality of sub-pixel regions, each of the plurality of sub-pixels includes a light-emitting device and a sub-pixel circuit configured to drive the light-emitting device to emit light, each light-emitting device includes a first electrode, a charge generation layer and a second electrode which are sequentially stacked, and the plurality of sub-pixels include a first sub-pixel, a second sub-pixel and a third sub-pixel which are adjacent to each other and configured to display different colors; forming a pixel definition structure having a plurality of sub-pixel openings to define light-emitting regions of the plurality of sub-pixels, wherein each of the light-emitting devices has at least a portion located in a corresponding one of the plurality of sub-pixel openings; and forming an isolation structure in at least one of the pixel region and the pixel spacing region, wherein the isolation structure includes a portion with a first isolation height and a portion with a second isolation height, and the second isolation height is larger than the first isolation height, and wherein charge generation layers of adjacent sub-pixels among the plurality of sub-pixels are disconnected from each other by the isolation structure.

In the manufacturing method of the display panel provided by at least one embodiment of the present disclosure, forming the pixel definition structure and the isolation structure includes: sequentially forming a first pixel definition layer and a second pixel definition layer on a side of a planarization structure on the base substrate; performing a first removal process to remove a portion of the second pixel definition layer, and forming an opening in the second pixel definition layer, wherein the opening is defined by an extension part of the second pixel definition layer and exposes a portion of a surface of the first pixel definition layer; and performing a second removal process to remove a portion of the first pixel definition layer exposed by the opening and a portion of the first pixel definition layer covered by the extension part of the second pixel definition layer, and an undercut structure is formed at a side of the extension part close to the base substrate, wherein the isolation structure includes the extension part and the undercut structure.

In the manufacturing method of the display panel provided by at least one embodiment of the present disclosure, after performing the second removal process, an isolation opening that exposes a portion of a surface of the planarization structure is formed in the first pixel definition layer and the second pixel definition layer.

In the manufacturing method of the display panel provided by at least one embodiment of the present disclosure, further including: performing a third removal process to remove a portion of the planarization structure exposed by the isolation opening, and forming a recess in the planarization structure.

In the manufacturing method of the display panel provided by at least one embodiment of the present disclosure, forming the pixel definition structure further includes: forming a pixel definition body layer before forming the first pixel definition layer, wherein after performing the second removal process, a plurality of openings in the first pixel definition layer and the second pixel definition layer expose a portion of a surface of the pixel definition body layer; and performing a third removal process to remove a portion of the pixel definition body layer exposed by part of the plurality of openings, so as to form a recess in a partial region of the pixel definition body layer.

In the manufacturing method of the display panel provided by at least one embodiment of the present disclosure, forming the pixel definition structure and the isolation structure includes: sequentially forming a plurality of pixel definition layers on the base substrate; performing a first removal process on a first pixel stack part of the plurality of pixel definition layers located in a first pixel spacing region, so as to remove portions of at least two pixel definition layers among the plurality of pixel definition layers, and forming a first recess including one or more first isolation openings in the first pixel stack part; and performing a second removal process on a second pixel stack part of the plurality of pixel definition layers located in a second pixel spacing region, so as to remove portions of at least three pixel definition layers among the plurality of pixel definition layers, and forming a second recess including one or more second isolation openings in the second pixel stack part.

### BRIEF DESCRIPTION OF DRAWINGS

In order to clearly illustrate the technical solution of the embodiments of the present disclosure, the drawings of the embodiments will be briefly described. It is obvious that the described drawings in the following are only related to some embodiments of the present disclosure and thus are not limitative of the present disclosure.
FIG. 1A illustrates a schematic plan view of a plurality of sub-pixels and an isolation structure in a display panel according to some embodiments of the present disclosure; FIG. 1B and FIG. 1C illustrate schematic cross-sectional views of a display panel according to some embodiments of the present disclosure taken along lines I-I' and II-II' of FIG. 1A, respectively.
FIG. 2A to FIG. 2G respectively illustrate schematic plan views of a plurality of sub-pixels and an isolation structure in a display panel according to some embodiments of the present disclosure.
FIG. 3A and FIG. 3B illustrate schematic cross-sectional views of a display panel according to some embodiments of the present disclosure.
FIG. 4A to FIG. 4G illustrate schematic cross-sectional views of intermediate structures of respective steps in a manufacturing method of a display panel according to some embodiments of the present disclosure.
FIG. 5 illustrates a schematic cross-sectional view of a display panel according to some other embodiments of the present disclosure.
FIG. 6A to FIG. 6D illustrate schematic cross-sectional views of intermediate structures of respective steps in a manufacturing method of a display panel according to some other embodiments of the present disclosure.
FIG. 7 illustrates a schematic cross-sectional view of a display panel according to some further embodiments of the present disclosure.
FIG. 8A to FIG. 8C illustrate schematic cross-sectional views of intermediate structures of respective steps in a manufacturing method of a display panel according to still some other embodiments of the present disclosure.
FIG. 9 illustrates a schematic cross-sectional view of a display panel according to still some further embodiments of the present disclosure.
FIG. 10A to FIG. 10E illustrate schematic cross-sectional views of intermediate structures of respective steps in a manufacturing method of a display panel according to further embodiments of the present disclosure.
FIG. 11 illustrates a schematic cross-sectional view of a display panel according to still other embodiments of the present disclosure.
FIG. 12A to FIG. 12G illustrate schematic cross-sectional views of intermediate structures of respective steps in a manufacturing method of a display panel according to still other embodiments of the present disclosure.
FIG. 13 illustrates a schematic cross-sectional view of an isolation structure in a display panel according to some embodiments of the present disclosure.

### DETAILED DESCRIPTION

In order to make objects, technical details and advantages of the embodiments of the present disclosure apparent, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment(s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., used in the present disclosure are not intended to indicate any sequence, amount or importance, but distinguish different components. The terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not limited to a physical connection or mechanical connection, but may also include an electrical connection, directly or indirectly.

In the display panel of various embodiments of the present disclosure, the separation between different sub-pixels is realized by providing an isolation structure with various isolation heights, so that the separation between high-mobility film layers such as charge generation layers of different sub-pixels can be effectively realized, electrical crosstalk between different sub-pixels is avoided, and the color gamut of the display panel is further improved. Moreover, by providing isolation parts with smaller isolation heights in some regions, the possibility that the second electrode layer (e.g., cathode) in the corresponding light-emitting devices is also disconnected by the isolation structure can be avoided or reduced, while the pixel isolation is realized, so as to avoid or reduce the defects such as poor brightness uniformity and high power consumption of the light-emitting device caused by the voltage drop due to the disconnection of the second electrode layer. In some embodiments, the disconnection of the second electrode layer can be further prevented by accurately controlling the isolation heights of various isolation parts of the isolation structure, or by designing, for example, the shape of the isolation structure and/or providing an auxiliary electrode layer, thereby improving the brightness uniformity and display quality of the display panel and reducing the power consumption of the light-emitting device.

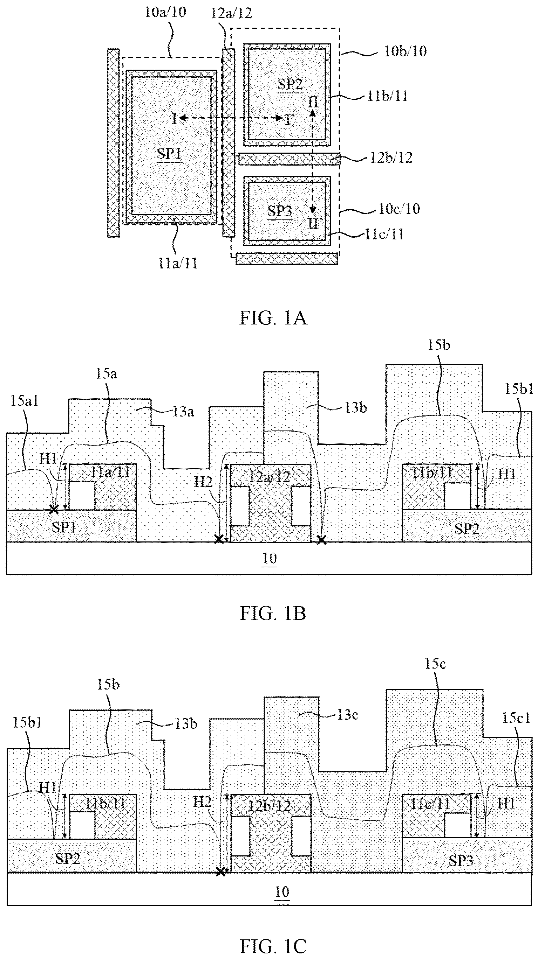

FIG. 1A illustrates a schematic plan view of a plurality of sub-pixels and an isolation structure in a display panel according to some embodiments of the present disclosure; FIG. 1B and FIG. 1C illustrate schematic cross-sectional views of a display panel according to some embodiments of the present disclosure taken along lines I-I' and II-II' of FIG. 1A, respectively.

Referring to FIG. 1A, in some embodiments, a display panel may have a pixel region including a plurality of sub-pixel regions 10 and pixel spacing regions between adjacent sub-pixel regions 10, and include a plurality of sub-pixels disposed on a base substrate and located in the plurality of sub-pixel regions 10, respectively. Each sub-pixel may include a light-emitting device and a sub-pixel circuit for driving the light-emitting device to emit light. In some embodiments, each light-emitting device includes a first electrode, a light-emitting material layer and a second electrode, and the light-emitting material layer may include a light-emitting layer, a charge generation layer and the like, and the charge generation layer is, for example, disposed on a side of the light-emitting layer away from the base substrate. The first electrode and the second electrode may be used as the anode and the cathode of the light-emitting device, respectively. In some embodiments, the display panel includes an isolation structure for disconnecting high-mobility film layers such as charge generation layers of adjacent sub-pixels, thereby avoiding electrical crosstalk between adjacent sub-pixels.

In some embodiments, the isolation structure may be located in at least one of the pixel region and the pixel spacing region, and includes a portion with a first isolation height and a portion with a second isolation height, the second isolation height is larger than the first isolation height, and the charge generation layers of adjacent sub-pixels among a plurality of sub-pixels are disconnected from each other by at least one of the portion with the first isolation height and the portion with the second isolation height in the isolation structure. In some embodiments, the light-emitting layers of different sub-pixels have different thicknesses, and the charge generation layers of different sub-pixels may be located at different level heights. For example, at least a portion of the light-emitting layer is located on a side of the charge generation layer close to the base substrate; and to a certain extent, the greater the thickness of the light-emitting layer is, the higher where the location of the corresponding charge generation layer is. The isolation height of the isolation structure can be set according to the height of the charge generation layer of the corresponding sub-pixel. Here, the height of the charge generation layer refers to a height of the charge generation layer with respect to a surface of the light-emitting material layer at a side closest to the base substrate, or a distance between the charge generation layer and a main surface of the base substrate.

In some embodiments, the plurality of sub-pixels includes a first sub-pixel, a second sub-pixel and a third sub-pixel for displaying different colors. The portion with the first isolation height in the isolation structure may include an isolation part disposed in at least one of a first sub-pixel region where the first sub-pixel is located and a pixel spacing region between the first sub-pixel and an adjacent sub-pixel; the portion with the second isolation height of the isolation structure at least includes an isolation part disposed in the pixel spacing region between the second sub-pixel and the third sub-pixel, or may further include an isolation part disposed in the pixel spacing region between the first sub-pixel and an adjacent second sub-pixel or between the first sub-pixel and an adjacent third sub-pixel.

For example, the plurality of sub-pixels may include sub-pixels SP1, SP2 and SP3 located in sub-pixel regions 10a, 10b and 10c, respectively. The sub-pixel regions 10a, 10b, 10c may be referred to as a first sub-pixel region, a second sub-pixel region, and a third sub-pixel region, respectively; the sub-pixels SP1, SP2 and SP3 may be referred to as a first sub-pixel, a second sub-pixel and a third sub-pixel, respectively. In some embodiments, the isolation structure IS may include a pixel region isolation part 11 and an inter-pixel isolation part 12 respectively located in a pixel region and a pixel spacing region, and the pixel region isolation part 11 and the inter-pixel isolation part 12 may each have the first isolation height and/or the second isolation height. In some embodiments, each sub-pixel region may be provided with a pixel region isolation part; for example, the pixel region isolation part 11 may include pixel region isolation parts 11a, 11b and 11c respectively provided in the sub-pixel regions 10a, 10b, 10c; the inter-pixel isolation part 12 may include portions provided between different adjacent sub-pixels, and may include, for example, an inter-pixel isolation part 12a provided between sub-pixels SP1 and SP2 and/or between sub-pixels SP1 and SP3, and an inter-pixel isolation part 12b provided between sub-pixels SP2 and SP3. In some embodiments, a plurality of pixel region isolation parts 11a-11c may have the same first isolation height, and a plurality of inter-pixel isolation parts 12a, 12b may have the same second isolation height; alternatively, a portion of the pixel region isolation parts (e.g., the pixel region isolation part 11a) has a first isolation height, while another portion of the pixel region isolation parts (e.g., the pixel region isolation part 11b or 11c) has a second isolation height; alternatively, a portion of the inter-pixel isolation parts (e.g., the inter-pixel isolation part 12a) has the first isolation height, while another portion of the inter-pixel isolation parts (e.g., the inter-pixel isolation part 12b) has the second isolation height. However, the present disclosure is not limited thereto.

FIG. 1B and FIG. 1C are schematic views illustrating the principle of charge generation layers of adjacent sub-pixels among a plurality of sub-pixels being disconnected by the isolation structure.

Referring to FIGs. 1A to 1C, a first sub-pixel SP1, a second sub-pixel SP2 and a third sub-pixel SP3 are disposed over a base substrate 10. It should be understood that, FIGs. 1B and 1C only schematically illustrate the principle of the charge generation layers of adjacent sub-pixels being disconnected, and do not specifically illustrate all components in the display panel. In some embodiments, the first sub-pixel SP1 includes a first light-emitting layer 13a and a charge generation layer 15a embedded in the first light-emitting layer 13a, the second sub-pixel SP2 includes a second light-emitting layer 13b and a charge generation layer 15b embedded in the second light-emitting layer 13b, and the third sub-pixel SP3 includes a third light-emitting layer 13c and a charge generation layer 15c embedded in the third light-emitting layer 13c. At least a portion of each light-emitting layer is located on a side of the charge generation layer close to the base substrate. In some embodiments, the light-emitting layers of different sub-pixels may have different thicknesses; for example, the thicknesses of the second light-emitting layer 13b and the third light-emitting layer 13c may be larger than the thickness of the first light-emitting layer 13a. In some embodiments, the charge generation layers of the first sub-pixel SP1 and the adjacent second sub-pixel SP2 or third sub-pixel SP3 may be disconnected from each other by at least a portion with a first isolation height in the isolation structure, and the charge generation layers of the second sub-pixel SP2 and the third sub-pixel SP3 may be disconnected from each other by a portion with a second isolation height in the isolation structure.

For example, a plurality of pixel region isolation parts 11a, 11b, 11c may each have a first isolation height H1, and inter-pixel isolation parts 12a, 12b may each have a second isolation height H2. Herein, the first isolation height refers to a smaller isolation height which is smaller than the second isolation height. The charge generation layers illustrated in FIGs. 1B and 1C schematically illustrate the conductive paths of the respective charge generation layers, and a cross symbol (×) indicates that the charge generation layer is disconnected there. For example, as illustrated in FIG. 1B, for the first sub-pixel SP1 with a relatively smaller thickness of the light-emitting layer (i.e., the height of the position where the charge generation layer is located is relatively lower), the charge generation layer 15a can be disconnected at the pixel region isolation part 11a with the first isolation height H1 and can also be disconnected at the inter-pixel isolation part 12a with the second isolation height, so that the portion 15a1 of the charge generation layer 15a located in the light-emitting region can be disconnected from the charge generation layers of other adjacent sub-pixels. For the second sub-pixel SP2 and the third sub-pixel SP3 with relatively larger thickness of the light-emitting layer (i.e., the height of the position where the charge generation layer is located is relatively higher), the charge generation layers 15b and 15c may not be disconnected at the pixel region isolation parts 11b and 11c with the first isolation height H1, but can be respectively disconnected at the inter-pixel isolation parts 12a and 12b with the second isolation height, so that the charge generation layers in the light-emitting regions of the second sub-pixel and the third sub-pixel are disconnected from each other. In this way, the charge generation layers of the respective adjacent sub-pixels are disconnected from each other, thereby avoiding electrical crosstalk between adjacent sub-pixels.

It should be understood that, the positions of the two types of isolation heights illustrated in FIGs. 1B and 1C are only for illustration, and the present disclosure is not limited thereto. The two types of isolation heights of the isolation structure can be adjusted according to the arrangement of sub-pixels, the evaporation region of light-emitting materials in the pixel regions and other related product designs and requirements, as long as the high-mobility film layers such as the charge generation layers of adjacent sub-pixels can be disconnected through the two types of isolation heights.

In the embodiment of the present disclosure, the isolation structure is provided with different isolation heights for different sub-pixels, and the different isolation heights correspond to the heights of charge generation layers in different light-emitting material layers, so that accurate isolation for different adjacent sub-pixels can be realized. On the other hand, the isolation height for the sub-pixel with a smaller thickness of the light-emitting layer is disposed to be smaller, thereby avoiding or reducing the possibility of disconnection of the second electrode layer above the light-emitting material layers.

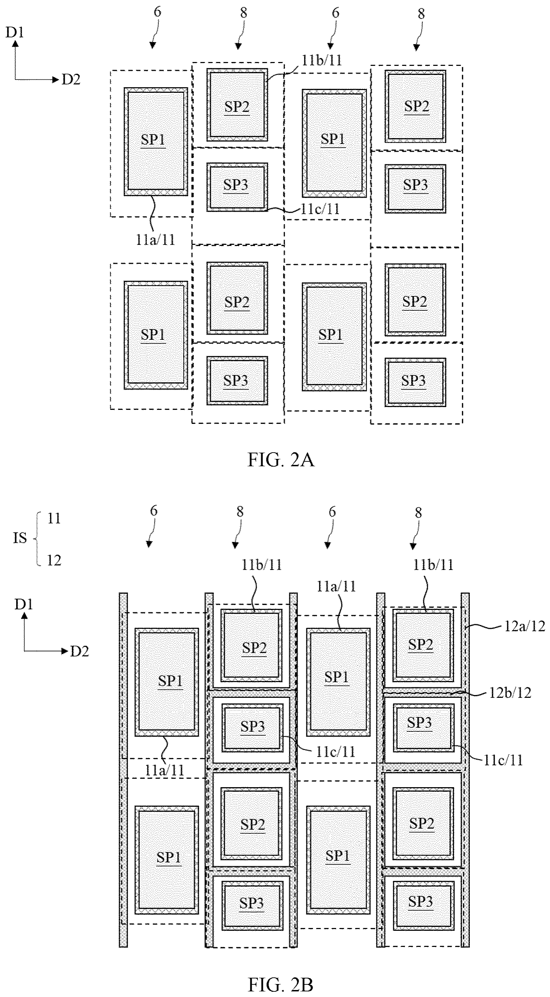

FIGs. 2A to 2F illustrate schematic plan views of a plurality of sub-pixels and an isolation structure in a display panel according to some embodiments of the present disclosure. The regions surrounded by the isolation structure 11 in FIGs. 2A to 2F are the light-emitting regions of the respective sub-pixels, and the dashed boxs in FIGs. 2A and 2B illustrate the evaporation regions of the light-emitting material layers of the respective sub-pixels.

Referring to FIGs. 2A to 2F, in some embodiments, the display panel includes a plurality of pixel units, and each pixel unit may include a first sub-pixel SP1, a second sub-pixel SP2 and a third sub-pixel SP3 adjacent to each other. The plurality of pixel units may be arranged in an array, for example, arranged in an array including a plurality of rows and a plurality of columns along a first direction D1 and a second direction D2. For example, the plurality of sub-pixels may include a first pixel column 6 and a second pixel column 8. The first pixel column 6 includes a plurality of first sub-pixels SP1 arranged in a first direction (e.g., direction D1); the second pixel column 8 includes a plurality of second sub-pixels SP2 and a plurality of third sub-pixels SP3 alternately arranged in a first direction (e.g., direction D1). In some embodiments, one or more first pixel columns 6 and one or more second pixel columns 8 may be alternately arranged along a second direction (e.g., direction D2) intersecting with the first direction. Each first sub-pixel SP1 in the first pixel column 6, together with one second sub-pixel SP2 and one third sub-pixel SP3 adjacent thereto in an adjacent second pixel column 8, constitute one pixel unit. That is to say, in the same one pixel unit, the second sub-pixel SP2 and the third sub-pixel SP3 may be located at the same side of the first sub-pixel SP1 in the direction D2 and located in the same pixel column; each of the second sub-pixel SP2 and the third sub-pixel SP3 may partially overlap with the first sub-pixel SP1 in the direction D2, and the second sub-pixel SP2 and the third sub-pixel SP3 overlap with each other in the direction D1.

In some embodiments, each of the light-emitting regions of a plurality of sub-pixels is surrounded by a corresponding isolation part of the isolation structure in an arrangement direction of the sub-pixels. The isolation structure may include at least one of the plurality of pixel region isolation parts and the inter-pixel isolation parts. For example, the isolation structure may at least include a plurality of pixel region isolation parts 11a, 11b and 11c.

In some embodiments, as illustrated in FIG. 2A, the charge generation layers in the respective sub-pixel regions can be disconnected only by the pixel region isolation part(s), so that the charge generation layer of each sub-pixel is disconnected from the charge generation layer of the adjacent sub-pixel. In some embodiments, it may be unnecessary to provide an inter-pixel isolation part in the pixel spacing region between sub-pixels, but the present disclosure is not limited thereto.

In some embodiments, a plurality of pixel region isolation parts respectively surrounds the light-emitting regions of a plurality of sub-pixels in a direction parallel to the main surface of the base substrate; one or more of the plurality of pixel region isolation parts may disconnect the charge generation layer located in the light-emitting region (i.e., the effective charge generation layer of the light-emitting device) from the charge generation layer located outside the light-emitting region, in the corresponding sub-pixel region. For example, the pixel region isolation part may be in a closed ring shape, but the present disclosure is not limited thereto.

Referring to FIG. 2A, in this embodiment, a plurality of pixel region isolation parts may have the same isolation height, and the effective charge generation layer of each sub-pixel may be isolated from the charge generation layers of other sub-pixels by corresponding pixel region isolation part. In some other embodiments, the plurality of pixel region isolation parts may have different isolation heights; for example, the pixel region isolation part 11a corresponding to the first sub-pixel SP1 may have a smaller first isolation height, and the pixel region isolation part 11b or 11c corresponding to the second sub-pixel SP2 and/or the third sub-pixel SP3 may have a larger second isolation height.

Referring to FIGs. 2B to 2F, in some embodiments, the isolation structure IS includes a pixel region isolation part 11 and further includes an inter-pixel isolation part 12. For example, the inter-pixel isolation part 12 may include a first inter-pixel isolation part 12a and a second inter-pixel isolation part 12b; the first inter-pixel isolation part 12a may extend in the direction D1, and may be located between the adjacent first and second pixel columns 6 and 8 in the direction D2. That is, the first inter-pixel isolation part 12a is located in the pixel spacing region between the sub-pixel SP1 and the sub-pixels SP2 and/or SP3. The second inter-pixel isolation part 12b may extend in the direction D2, and may be located in the pixel spacing region between adjacent sub-pixels SP2 and SP3 in the direction D1. In some embodiments, the forming regions (e.g., evaporation regions) of light-emitting material layers of sub-pixels SP1 adjacent in the direction D1 may be spaced apart from each other, that is, do not border or overlap each other, therefore, the isolation structure may not be provided in the pixel spacing region between the adjacent sub-pixels SP1, but the present disclosure is not limited thereto. In some other examples, the inter-pixel isolation part may also be provided between sub-pixels SP1 that are adjacent in the direction D1.

In some embodiments, the first inter-pixel isolation part 12a and the second inter-pixel isolation part 12b may have the same isolation height or different isolation heights. For example, in some examples, the pixel region isolation part 11 may have the first isolation height, and the first inter-pixel isolation part 12a and the second inter-pixel isolation part 12b may have the same second isolation height. In some other examples, the pixel region isolation part 11 has the first isolation height, the first inter-pixel isolation part 12a has the first isolation height, and the second inter-pixel isolation part 12b has the second isolation height.

In some embodiments, the first inter-pixel isolation part and the second inter-pixel isolation part are connected to each other or disconnected from each other, and the inter-pixel isolation part includes an annular portion in a closed ring shape or an open ring shape, and the light-emitting regions of one or more sub-pixels among a plurality of sub-pixels are surrounded by the annular portion in a direction parallel to the main surface of the base substrate.

In some embodiments, the isolation structure may include a first annular part and a second annular part, the first annular part surrounds the light-emitting region of a corresponding one of a plurality of sub-pixels in a direction parallel to the main surface of the base substrate; the second annular part is located on a side of the first annular part away from the sub-pixel and surrounds the first annular part and the sub-pixel in the direction parallel to the main surface of the base substrate. The first annular part may be or include a pixel region isolation part, and the second annular part may be constituted by a first inter-pixel isolation part and a second inter-pixel isolation part. Each of the first annular part and the second annular part may be in a closed ring shape or an open ring shape (i.e., a ring shape with an opening).

In some embodiments, as illustrated in FIG. 2B, the first inter-pixel isolation part 12a and the second inter-pixel isolation part 12b may be connected to each other, and form an annular portion in a closed ring shape, so that one or more sub-pixels among a plurality of sub-pixels are surrounded by the annular portion in a direction parallel to the main surface of the base substrate. For example, the first inter-pixel isolation part 12a may extend continuously in the direction D1, and a plurality of second inter-pixel isolation parts 12b located in the same pixel column may be connected to an adjacent first inter-pixel isolation part 12a, so as to form an annular portion, so that the corresponding sub-pixels SP2 and/or SP3 are surrounded by the annular portion.

In the example illustrated in FIG. 2B, the inter-pixel isolation parts extend continuously between a plurality of sub-pixels, and adjacent sub-pixels are completely separated by the inter-pixel isolation parts, thereby ensuring that the charge generation layers of adjacent sub-pixels can be effectively disconnected by the inter-pixel isolation parts. However, the present disclosure is not limited thereto.

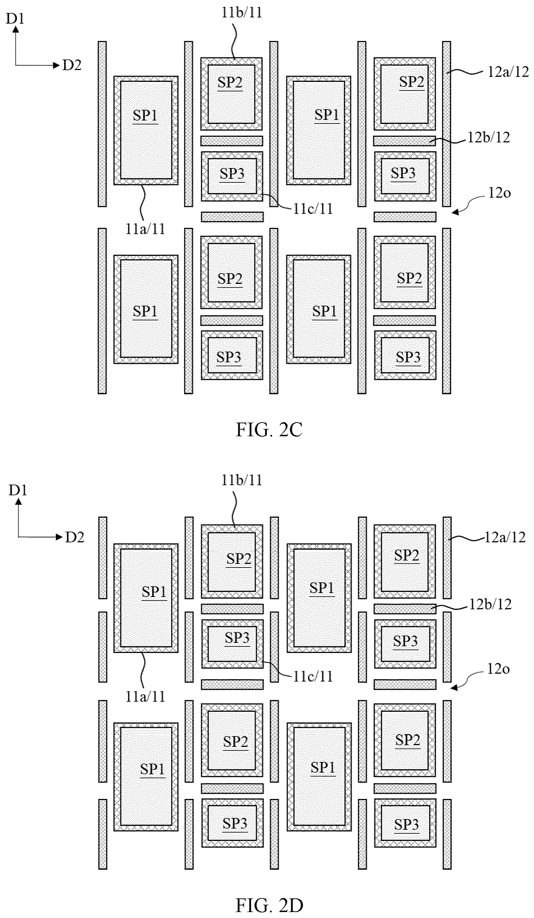

Referring to FIGs. 2C and 2D, in some examples, the first inter-pixel isolation part 12a and the second inter-pixel isolation part 12b may be disconnected from each other; each first inter-pixel isolation part 12a may include a plurality of first inter-pixel isolation sub-parts disconnected from each other, and each first inter-pixel isolation sub-part is located between a corresponding first sub-pixel and a second sub-pixel adjacent to the corresponding first sub-pixel and/or between the corresponding first sub-pixel and a third sub-pixel adjacent to the corresponding first sub-pixel. That is, the first inter-pixel isolation part 12a has one or more openings 12o, and an opening is provided between the first inter-pixel isolation part 12a and the second inter-pixel isolation part 12b.

Still referring to FIG. 2C and FIG. 2D, in some embodiments, the orthographic projection of the first sub-pixel SP1 on a first reference plane extending along the first direction D1 and the orthographic projection of the second sub-pixel SP2 on the first reference plane have a first overlapping portion, and the orthographic projection of the first sub-pixel SP1 on the first reference plane and the orthographic projection of the third sub-pixel SP3 on the first reference plane have a second overlapping portion; the orthographic projection of the opening 12o of the first inter-pixel isolation part 12a on the first reference plane is offset from the first overlapping portion and the second overlapping portion, and the first overlapping portion and the second overlapping portion are respectively located in the orthographic projection(s) of the corresponding first inter-pixel isolation sub-part(s) on the first reference plane. In some embodiments, the overlapping portions of the orthographic projections, on a second reference plane extending along the second direction D2, of the adjacent second sub-pixel SP2 and third sub-pixel SP3 located in the same second pixel column 8, is located in the orthographic projection of the second inter-pixel isolation part 12b on the second reference plane.

In such embodiments, the inter-pixel isolation part is disposed between portions of adjacent sub-pixels overlapping with each other in the direction parallel to the main surface of the base substrate, and the opening of the inter-pixel isolation part is disposed in the region where adjacent sub-pixels do not overlap. In this way, the possibility that the second electrode material (e.g., cathode) on the light-emitting material layer is also disconnected by the isolation structure can be avoided or reduced, while ensuring that the charge generation layers of adjacent sub-pixels are effectively disconnected.

In the above example, a single inter-pixel isolation part is provided between two adjacent sub-pixels to avoid electrical crosstalk between the adjacent sub-pixels, but the present disclosure is not limited thereto. In some other examples, the inter-pixel isolation part (e.g., at least one of the first inter-pixel isolation part and the second inter-pixel isolation part) between two adjacent sub-pixels may include a plurality of isolation sub-parts disposed side by side along the arrangement direction of the adjacent sub-pixels, thereby further ensuring that the charge generation layers of the adjacent sub-pixels can be effectively disconnected by the isolation structure.

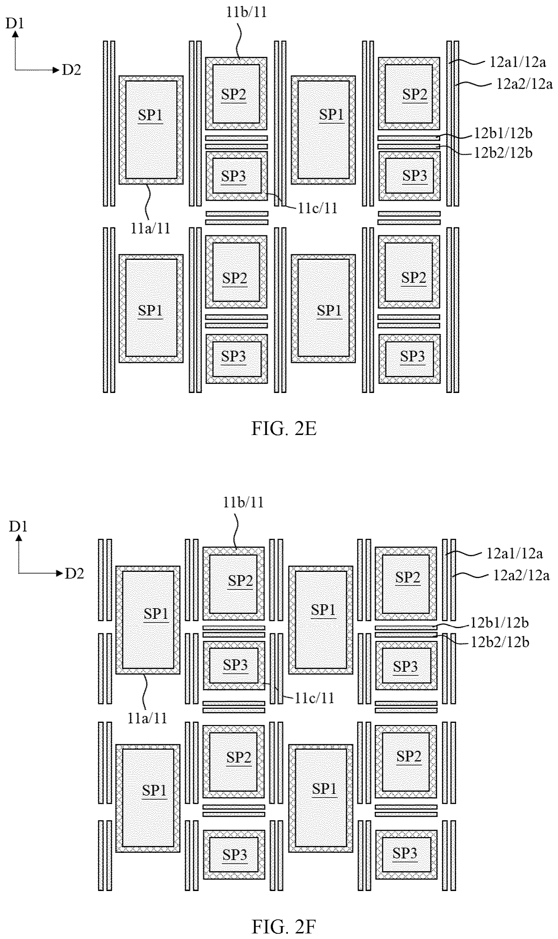

Referring to FIGs. 2E and 2F, for example, the first inter-pixel isolation part 12a may include an isolation sub-part 12a1 and an isolation sub-part 12a2 spaced apart from each other, and the isolation sub-parts 12a1 and 12a2 may extend substantially parallel to each other along the direction D1 and may be arranged between the sub-pixel SP1 and the adjacent sub-pixel SP2 and/or between the sub-pixel SP1 and the adjacent sub-pixel SP3 in the direction D2. The second inter-pixel isolation part 12b may include an isolation sub-part 12b1 and an isolation sub-part 12b2 spaced apart from each other, and the isolation sub-parts 12b1 and 12b2 may extend substantially parallel to each other in the direction D2 and may be arranged between adjacent sub-pixels SP2 and SP3 in the direction D1.

Hereinafter, the cross-sectional structure of the display panel will be described in details. It should be understood that the arrangement mode of pixels and the planar layout of the isolation structure in the display panel of various embodiments can adopt any one of those illustrated in FIGs. 2A to 2F, and the present disclosure is not limited thereto.

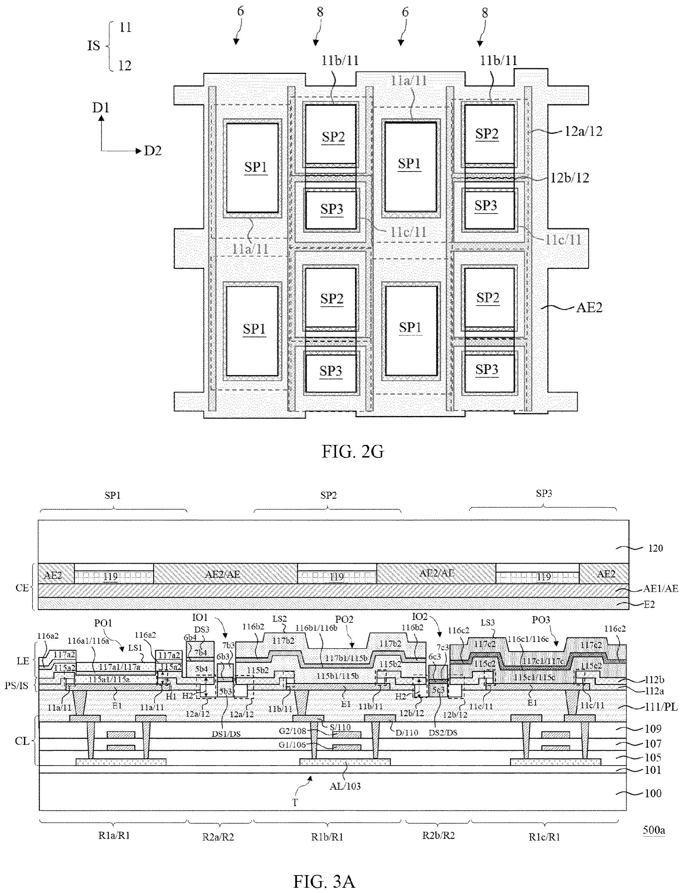

FIG. 3A illustrates a schematic cross-sectional view of a display panel according to some embodiments of the present disclosure.

Referring to FIG. 3A, in some embodiments, the display panel 500A has a pixel region R1 and a pixel spacing region R2 located between adjacent sub-pixel regions. The pixel region R1 includes a plurality of sub-pixel regions, for example, may include a first sub-pixel region R1a, a second sub-pixel region R1b and a third sub-pixel region R1c; the pixel spacing region R2 may include a first pixel spacing region R2a between the sub-pixel region R1a and adjacent sub-pixel region(s) R1b and/or R1c, and a second pixel spacing region R2b between adjacent sub-pixel regions R1b and R1c. In the present disclosure, a sub-pixel region includes a light-emitting region and a peripheral region adjacent to and surrounding the light-emitting region.

For example, the display panel 500a includes a plurality of sub-pixels, and may include a base substrate 100, a pixel circuit layer CL, a planarization structure PL, a pixel definition structure PS, an isolation structure IS, and a light-emitting stacked layer LE. The plurality of sub-pixels are disposed on the base substrate 100, and may include a first sub-pixel SP1, a second sub-pixel SP2 and a third sub-pixel SP3 for displaying different colors and respectively located in a first sub-pixel region R1a, a second sub-pixel region R1b and a third sub-pixel region R1c. In some embodiments, the display panel 500a may be an OLED display panel, such as a Tandem OLED display panel. For example, each sub-pixel includes a light-emitting device and a sub-pixel circuit for driving the light-emitting device to emit light. For example, each light-emitting device may include a first electrode E1, a light-emitting material layer, and a second electrode E2, which are sequentially stacked in a direction perpendicular to the base substrate, wherein the light-emitting material layer includes a light-emitting layer and a charge generation layer. In some embodiments, the first sub-pixel SP1, the second sub-pixel SP2 and the third sub-pixel SP3 are respectively a blue sub-pixel, a green sub-pixel and a red sub-pixel, but the present disclosure is not limited thereto.

In some embodiments, the pixel circuit layer CL is disposed on a side of the base substrate 100 and may include sub-pixel circuits of a plurality of sub-pixels. For example, each sub-pixel circuit may include one or more thin film transistors T and capacitors. In some embodiments, a buffer layer 101 may be further disposed between the base substrate 100 and the pixel circuit layer CL. The planarization structure PL is disposed on a side of the pixel circuit layer CL away from the base substrate 100, and may at least include a planarization layer 111.

In some embodiments, the first electrodes E1 of a plurality of sub-pixels are disposed on a side of the planarization structure PL away from the base substrate 100, and are electrically connected to corresponding sub-pixel circuits, such as source electrodes or drain electrodes of corresponding thin film transistors, through via holes located in the planarization structure PL.

The pixel definition structure PS is disposed on a side of the planarization structure PL away from the base substrate 100 and has a plurality of sub-pixel openings to define light-emitting regions of a plurality of sub-pixels, and at least a portion of each light-emitting device is located in the corresponding sub-pixel opening. For example, the plurality of sub-pixel openings include sub-pixel openings PO1, PO2 and PO3, which are configured to define the light-emitting regions of sub-pixels SP1, SP2 and SP3, respectively. The pixel definition structure PS may cover edge portions of first electrodes of a plurality of sub-pixels, and the plurality of sub-pixel openings respectively expose portions of surfaces of the plurality of first electrodes E1. In some embodiments, the pixel definition structure PS may further include one or more isolation openings, which are located in the pixel spacing region(s) between adjacent sub-pixels and expose a portion of the surface of the planarization structure PL. For example, the pixel definition structure PS may include an isolation opening IO1 and an isolation opening IO2 respectively located in the pixel spacing region R2a and the pixel spacing region R2b.

The light-emitting stacked layer LE is disposed on a side of the pixel definition structure PS and the planarization structure PL away from the base substrate, and in a plurality of openings such as sub-pixel openings and isolation openings of the pixel definition structure PS. The light-emitting stacked layer LE includes light-emitting material layers of light-emitting devices of a plurality of sub-pixels, and may further include a dummy light-emitting material layer.

For example, in the light-emitting stacked layer LE, the light-emitting material layer of the first sub-pixel SP1 includes a light-emitting layer 115a, a charge generation layer 116a and a light-emitting layer 117a which are stacked in sequence in a direction perpendicular to the main surface of the base substrate 100; the light-emitting material layer of the second sub-pixel SP2 includes a light-emitting layer 115b, a charge generation layer 116b and a light-emitting layer 117b which are stacked in sequence in the direction perpendicular to the main surface of the base substrate 100; the light-emitting material layer of the third sub-pixel SP3 includes a light-emitting layer 115c, a charge generation layer 116c, and a light-emitting layer 117c which are stacked in sequence in the direction perpendicular to the main surface of the base substrate 100. The light-emitting layers 115a, 115b, and 115c may also be referred to as a first light-emitting layer, a second light-emitting layer, and a third light-emitting layer, respectively.

In some embodiments, the light-emitting layers 115a, 115b, and 115c are respectively located on the side of the charge generation layers 116a, 16b, and 116c close to the base substrate 100, and the light-emitting layers 117a, 117b, and 117c are respectively located on the side of the charge generation layers 116a, 16b, and 116c away from the base substrate 100. It should be understood that, the types of materials and the number of material layers included in the light-emitting material layer located between the first electrode and the second electrode in the light-emitting device illustrated in the figure are only for illustration, and the present disclosure is not limited thereto. In some other embodiments, other materials for light emission of the light-emitting device, such as hole injection layer, hole transport layer, exciton barrier layer, electron transport layer, electron injection layer, etc., may also be included in the light-emitting material layer of each sub-pixel; in some embodiments, the light-emitting layer located at the side of the charge generation layer away from the base substrate may be omitted.

In some embodiments, the thicknesses of the light-emitting layers 115b and 115c may be larger than the thickness of the light-emitting layer 115a; the thicknesses of the light-emitting layers 115b and 115c may be the same as or different from each other; for example, the thickness of the light-emitting layer 115b may be larger or smaller than the thickness of the light-emitting layer 115c.

Still referring to FIG. 3A, in some embodiments, the isolation structure 11 includes a plurality of pixel region isolation parts 11 and inter-pixel isolation parts 12; and the plurality of pixel region isolation parts 11 are respectively located in a plurality of sub-pixel regions R1, for example, include a first pixel region isolation part 11a, a second pixel region isolation part 11b and a third pixel region isolation part 11c respectively located in the first sub-pixel region R1a, the second sub-pixel region R1b and the third sub-pixel region R1c. Among the plurality of pixel region isolation parts 11, at least the first pixel region isolation part 11a has a first isolation height H1. In some embodiments, the plurality of pixel region isolation parts 11 all have the same first isolation height H1, that is, the second pixel region isolation part 11b and the third pixel region isolation part 11c may also have the first isolation height H1.

In some embodiments, the inter-pixel isolation part 12 is located in the pixel spacing region R2 between adjacent sub-pixels, and may include, for example, a first inter-pixel isolation part 12a and a second inter-pixel isolation part 12b respectively located in the first pixel spacing region R2a and the second pixel spacing region R2b. In some embodiments, the first inter-pixel isolation part 12a and the second inter-pixel isolation part 12b have the same second isolation height H2, but the present disclosure is not limited thereto.

In some embodiments, a portion of the pixel definition structure PS that defines opening(s) (e.g., sub-pixel opening(s) or isolation opening(s)) may be used as an isolation structure. In other words, the isolation structure IS and the pixel definition structure PS may share the same one insulation structure. For example, the portion of the pixel definition structure PS that defines the opening(s) includes an extension part of the pixel definition layer which extends beyond an edge of an adjacent material layer in a direction parallel to the main surface of the base substrate, and an undercut structure is provided at a side of the extension part close to the base substrate. The isolation structure at least includes the extension part and the undercut structure. In the embodiment of the present disclosure, a portion of the pixel definition structure is used as the isolation structure, so that the pixel definition structure and the isolation structure with various isolation heights can be simultaneously formed without adding an additional mask; in this way, the process can be simplified and the cost can be saved, thereby solving the problems such as complicated process and high cost of isolation structure in the traditional process.

Referring to FIG. 3A, for example, the pixel definition structure PS may include a first pixel definition layer 112a and a second pixel definition layer 112b. The first pixel definition layer 112a is located on a side of the planarization structure PL away from the base substrate 100, and may cover portions of the first electrodes E1 in some embodiments; the second pixel definition layer 112b is located on a side of the first pixel definition layer 112a away from the base substrate 100. The second pixel definition layer 112b may include an extension part that extends beyond the edge of the first pixel definition layer 112a in a direction parallel to the main surface of the base substrate 100, and an undercut structure is provided between the extension part and a material layer located at a side of the first pixel definition layer 112a close to the base substrate. In some embodiments, the orthographic projection of the first pixel definition layer 112a on the base substrate is located within a range of the orthographic projection of the second pixel definition layer 112b on the base substrate, and the area of the orthographic projection of the second pixel definition layer 112b is larger than the area of the orthographic projection of the first pixel definition layer 112a.

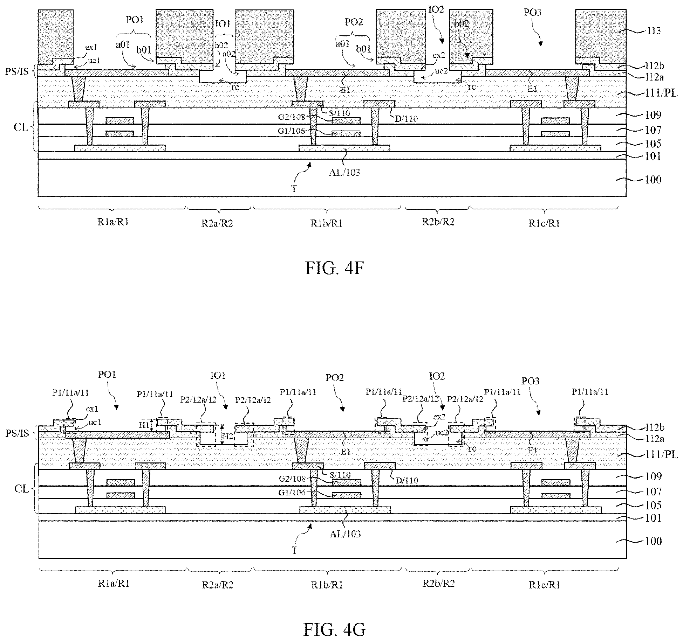

FIG. 4G illustrates the structure after forming the pixel definition structure on the base substrate and before forming the light-emitting stacked layer.

Referring to FIGs. 3A and 4G, for example, the pixel definition structure PS may include a sub-pixel opening definition part P1 for defining a sub-pixel opening and an isolation opening definition part P2 for defining an isolation opening; a plurality of sub-pixel opening definition parts P1 may be respectively used as the pixel region isolation part 11 of the isolation structure, and a plurality of isolation opening definition parts P2 may be respectively used as at least a portion of inter-pixel isolation part 12 of the isolation structure IS. For example, the sub-pixel opening definition part P1 may include a first extension part ex1 of the second pixel definition layer 112b, and has a first undercut structure uc1 between the first extension part ex1 and the first electrode E1 in the direction perpendicular to the main surface of the base substrate; the isolation opening definition part P2 may include a second extension part ex2 of the second pixel definition layer 112b, and has a second undercut structure uc2 between the second extension part ex2 and the planarization structure PL in the direction perpendicular to the main surface of the base substrate.

In some embodiments, each opening among a plurality of sub-pixel openings and isolation openings in the pixel definition structure PS includes a first sub-opening in the first pixel definition layer 112a and a second sub-opening in the second pixel definition layer 112b, and the width of the first sub-opening is larger than the width of the second sub-opening; the first sub-opening of the first pixel definition layer includes at least a portion of the undercut structure located underlying the extension part of the second pixel definition layer. For example, the orthographic projection of the second sub-opening on the main surface of the base substrate is located within the range of the orthographic projection of the first sub-opening on the main surface of the base substrate, and the area of the orthographic projection of the second sub-opening is smaller than the area of the orthographic projection of the first sub-opening.

In some embodiments, the planarization structure PL has one or more recesses rc, the recess rc may be in spatial communication with the isolation opening IO1 or IO2 in the pixel definition structure PS. In some embodiments, the second undercut structure uc2 may further extend into the planarization structure PL; for example, the width of the recess rc may be substantially equal to the width of the first sub-opening in the corresponding isolation opening; the recess rc and a portion of the first sub-opening are located between the extension part ex2 of the second pixel definition layer 112b and the planarization structure PL in the direction perpendicular to the main surface of the base substrate, and together constitute the second undercut structure uc2. However, the present disclosure is not limited thereto. In some other embodiments, the width of the recess rc may also be smaller than the width of the first sub-opening in the corresponding isolation opening, or may be substantially equal to the width of the second sub-opening. In the present disclosure, the width of an opening, a recess, an undercut structure or the like refers to a width thereof in a direction parallel to the main surface of the base substrate.

In this embodiment, the pixel region isolation part 11 includes an extension part ex1 and an undercut structure uc1, and the first isolation height H1 is defined by the sum of the thickness of the extension part ex1 of the second pixel definition layer 112b and the depth of the undercut structure uc1; the depth of the undercut structure uc1 may be substantially equal to the thickness of the first pixel definition layer 112a; therefore, the first isolation height H1 is substantially equal to the sum of the thicknesses of the pixel definition layers 112a and 112b. The inter-pixel isolation part 12 includes an extension part ex2 and an undercut structure uc2, and the second isolation height H2 may be defined by the sum of the thickness of the extension part ex2 and the depth of the undercut structure uc1 (i.e., the sum of the depth of the isolation opening and the depth of the recess rc). The depth of the isolation opening may be substantially equal to the sum of the thicknesses of the pixel definition layers 112a and 112b in the direction perpendicular to the main surface of the base substrate. That is, the second isolation height H2 may be substantially equal to the sum of the thicknesses of the pixel definition layers 112a and 112b and the depth of the recess rc in the planarization structure.

In some embodiments, as illustrated in FIGs. 3A and 4G, the pixel definition structure PS includes a plurality of pixel definition stack parts, the pixel definition stack part is located between adjacent sub-pixels or located laterally aside the sub-pixel, and includes two opposite sides (e.g., a first side and a second side) in the direction parallel to the main surface of the base substrate; the pixel definition stack part may have an extension part and an undercut structure serving as the isolation structure, at the position of at least one of the two opposite sides. For example, the two opposite sides of the pixel stack part located between adjacent sub-pixels may respectively include a sub-pixel opening definition part and an isolation opening definition part, which respectively serve as at least portions of the pixel region isolation part and the inter-pixel isolation part of the isolation structure.

Referring to FIG. 3A, in some embodiments, the light-emitting stacked layer includes a first light-emitting stack part, a second light-emitting stack part, a third light-emitting stack part and a dummy stack part; the first light-emitting stack part, the second light-emitting stack part and the third light-emitting stack part respectively include at least light-emitting material layers including charge generation layers of the first sub-pixel, the second sub-pixel and the third sub-pixel. The dummy stack part is located between adjacent light-emitting stack parts among the first light-emitting stack part to the third light-emitting stack part. The first, second and third light-emitting stack parts each include a first stack sub-part and a second stack sub-part; in each light-emitting stack part, the first stack sub-part is located in the light-emitting region defined by the sub-pixel opening of the pixel definition structure, and the second stack sub-part is located on a side, away from the base substrate, of a portion of the pixel definition structure that defines the sub-pixel opening.

For example, the light-emitting stacked layer LE includes light-emitting stack parts LS1, LS2, LS3 and dummy stack parts DS1, DS2. The light-emitting stack parts LS1, LS2, LS3 may be referred to as a first light-emitting stack, a second light-emitting stack, and a third light-emitting stack, respectively. The dummy stack parts DS1 and DS2 may be referred to as a first dummy stack part and a second dummy stack part, respectively. The light-emitting stack part LS1 may include a light-emitting layer 115a, a charge generation layer 116a, and a light-emitting layer 117a stacked in sequence in a direction perpendicular to the main surface of the base substrate. The light-emitting stack part LS2 may include a light-emitting layer 115b, a charge generation layer 116b, and a light-emitting layer 117b stacked in sequence in a direction perpendicular to the main surface of the base substrate. The light-emitting stack part LS3 may include a light-emitting layer 115c, a charge generation layer 116c, and a light-emitting layer 117c stacked in sequence in a direction perpendicular to the main surface of the base substrate.

In some embodiments, the light-emitting stack part LS1 includes a first stack sub-part located in the sub-pixel opening PO1 and a second stack sub-part located on a side, away from the base substrate, of a portion of the pixel definition structure PS that defines the sub-pixel opening PO1. For example, the first stack sub-part may include a light-emitting layer 115a1, a charge generation layer 116a1, and a light-emitting layer 117a1; the second stack sub-part may include a light-emitting layer 115a2, a charge generation layer 116a2, and a light-emitting layer 117a2. It should be understood that the corresponding material layers in the respective stack sub-parts of the same light-emitting stack part are formed from the same forming process, and the portions of each material layer located in different stack sub-parts include the same material. For example, in the light-emitting stack part LS1, the light-emitting layer 115a1 and the light-emitting layer 115a2 are formed from the same process and include the same material, the charge generation layer 116al and the charge generation layer 116a2 are formed from the same process and include the same material, the light-emitting layer 117al and the light-emitting layer 117a2 are formed from the same process and include the same material.

In some embodiments, in the light-emitting stack part LS1, the charge generation layer 116a1 of the first stack sub-part and the charge generation layer 116a2 of the second stack sub-part may be disconnected from each other by the first pixel region isolation part 11a of the isolation structure IS. For example, there is a height difference between the charge generation layer 116a1 and the charge generation layer 116a2 in the direction perpendicular to the main surface of the base substrate, and the height difference can be defined by the first isolation height H1 of the first pixel region isolation part 11a. For example, the height difference may be substantially equal to the first isolation height H1, but the present disclosure is not limited thereto. In some embodiments, the light-emitting layer 115a1 and the light-emitting layer 115a2 may be connected to each other or disconnected from each other, and the light-emitting layer 117a1 and the light-emitting layer 117a2 may be connected to each other or disconnected from each other. In some examples, the light-emitting layer 117a1 may be connected to the light-emitting layer 115a1, but the present disclosure is not limited thereto.

In some embodiments, the light-emitting stack part LS2 includes a first stack sub-part located in the sub-pixel opening PO2 and a second stack sub-part located on a side, away from the base substrate, of a portion of the pixel definition structure PS that defines the sub-pixel opening PO2. For example, in the light-emitting stack part LS2, the first stack sub-part may include a light-emitting layer 115b1, a charge generation layer 116b1 and a light-emitting layer 117b1; the second stack sub-part may include a light-emitting layer 115b2, a charge generation layer 116b2, and a light-emitting layer 117b2.

In some embodiments, in the light-emitting stack part LS2, the respective layers in the first stack sub-part and the second stack sub-part may be connected to each other, that is, the respective layers of the light-emitting stack part LS2 may be continuous layers; for example, the light-emitting layer 15b1, the charge generation layer 116b1 and the light-emitting layer 117b1 of the first stack sub-part may be connected to the light-emitting layer 115b2, the charge generation layer 116b2 and the light-emitting layer 117b2 of the second stack sub-part, respectively. That is, the charge generation layers of the first stack sub-part and the second stack sub-part in the light-emitting stack part LS2 are not disconnected by the second pixel region isolation part 12b. However, the present disclosure is not limited thereto. In some other embodiments, the charge generation layers of the first stack sub-part and the second stack sub-part of the light-emitting stack part LS2 may also be disconnected from each other.

In some embodiments, the light-emitting stack part LS3 includes a first stack sub-part located in the sub-pixel opening PO3 and a second stack sub-part located on a side, away from the base substrate, of a portion of the pixel definition structure PS that defines the sub-pixel opening PO3. For example, in the light-emitting stack part LS3, the first stack sub-part may include a light-emitting layer 115c1, a charge generation layer 116c1 and a light-emitting layer 117cl; the second stack sub-part may include a light-emitting layer 115c2, a charge generation layer 116c2, and a light-emitting layer 117c2.

In some embodiments, in the light-emitting stack part LS3, the respective layers of the first stack sub-part and the second stack sub-part may be connected to each other, that is, the respective layers of the light-emitting stack part LS3 may be continuous layers; for example, the light-emitting layer 115c1, the charge generation layer 116c1, and the light-emitting layer 117c1 of the first stack sub-part may be connected to the light-emitting layer 115c2, the charge generation layer 116c2, and the light-emitting layer 117c2 of the second stack sub-part, respectively. That is, the charge generation layers of the first stack sub-part and the second stack sub-part in the light-emitting stack part LS3 are not disconnected by the third pixel region isolation part 12c. However, the present disclosure is not limited thereto. In some other embodiments, the charge generation layers of the first stack sub-part and the second stack sub-part of the light-emitting stack part LS3 may also be disconnected from each other.

In some embodiments, the first dummy stack part is located in the pixel spacing region between the first sub-pixel and an adjacent second or third sub-pixel, and includes a first dummy charge generation layer, which is disconnected from the charge generation layers in light-emitting stack parts (e.g., the first light-emitting stack, the second light-emitting stack) of the first sub-pixel and the adjacent sub-pixel by the first inter-pixel isolation part of the isolation structure.

For example, the dummy stack part DS1 may include a dummy light-emitting layer 5b3, a dummy charge generation layer 6b3, and a dummy light-emitting layer 7b3 stacked in sequence in a direction perpendicular to the main surface of the base substrate. The dummy stack part DS1 may be located in the isolation opening IO1 of the pixel definition structure PS and in the recess of the planarization structure PL, and may be in contact with a portion of the surface of the planarization structure PL. The dummy charge generation layer 6b3 may be disconnected from the charge generation layers in the light-emitting stack parts LS1 and LS2 through the first inter-pixel isolation part 12a of the isolation structure IS. For example, a height difference may be provided between the dummy charge generation layer 6b3 and the charge generation layer of the light-emitting stack part LS1 or the light-emitting stack part LS2 in the direction perpendicular to the main surface of the base substrate, and the height difference may be defined by the isolation height (e.g., the second isolation height H2) of the first inter-pixel isolation part 12a. For instance, in this example, the height difference between the dummy charge generation layer 6b3 and the charge generation layer 116b2 in the light-emitting stack part LS2 may be substantially equal to the second isolation height H2, but the present disclosure is not limited thereto.

In some embodiments, the dummy light-emitting layer 5b3, the dummy charge generation layer 6b3 and the dummy light-emitting layer 7b3 of the dummy stack part DS1 may respectively have the same materials as the light-emitting layer 115b, the charge generation layer 116b and the light-emitting layer 117b of the light-emitting stack part LS2, but the present disclosure is not limited thereto.

Still referring to FIG. 3A, in some embodiments, a second dummy stack part is located in the pixel spacing region between the second sub-pixel and the third sub-pixel that are adjacent to each other, and includes a second dummy charge generation layer, which is disconnected from the charge generation layers in the second light-emitting stack part and the third light-emitting stack part through a second inter-pixel isolation part of the isolation structure.

For example, the dummy stack part DS2 may include a dummy light-emitting layer 5c3, a dummy charge generation layer 6c3, and a dummy light-emitting layer 7c3 stacked in sequence in a direction perpendicular to the main surface of the base substrate. The dummy stack part DS2 may be located in the isolation opening IO2 of the pixel definition structure PS and the recess of the planarization structure PL, and may be in contact with a portion of a surface of the planarization structure PL. The dummy charge generation layer 6c3 may be disconnected from the charge generation layers in the light-emitting stack parts LS2 and LS3 through the second inter-pixel isolation part 12b of the isolation structure IS. For example, a height difference may be provided between the dummy charge generation layer 6b3 and the charge generation layer in the second stack sub-part of the light-emitting stack part LS2 or the light-emitting stack part LS3 in the direction perpendicular to the main surface of the base substrate, and the height difference may be defined by the isolation height (e.g., the second isolation height H2) of the second inter-pixel isolation part 12b. For instance, in this example, the height difference between the dummy charge generation layer 6c3 and the charge generation layer 116c2 in the light-emitting stack part LS3 may be substantially equal to the second isolation height H2, but the present disclosure is not limited thereto.

In some embodiments, the dummy light-emitting layer 5c3, the dummy charge generation layer 6c3 and the dummy light-emitting layer 7c3 of the dummy stack part DS2 may have the same materials as the light-emitting layer 115c, the charge generation layer 116c and the light-emitting layer 117c of the light-emitting stack part LS3, respectively, but the present disclosure is not limited thereto. In some other embodiments, the dummy light-emitting layer and the dummy charge generation layer of the dummy stack part DS2 may also have the same materials as the corresponding light-emitting layer and charge generation layer of the light-emitting stack part LS2, respectively, and the height difference between the dummy charge generation layer and the charge generation layer 116b2 in the light-emitting stack part LS2 may be substantially equal to the second isolation height.

Still referring to FIG. 3A, in some embodiments, the light-emitting stacked layer LE may further include a dummy stack part DS3 located on a side, away from the base substrate, of a portion of the pixel definition structure PS that defines the isolation opening IO1; and the dummy stack part DS3 may include a dummy light-emitting layer 5b4, a dummy charge generation layer 6b4, and a dummy light-emitting layer 7b4 stacked in sequence in a direction perpendicular to the main surface of the base substrate. The dummy charge generation layer 6b4 and the dummy charge generation layer 6b3 may be disconnected from each other. In some embodiments, the dummy light-emitting layer 5b4, the dummy light-emitting layer 5b3 and the light-emitting layer 115b may have the same material; the dummy charge generation layer 6b4, the dummy charge generation layer 6b3 and the charge generation layer 116b may have the same material; the dummy light-emitting layer 7b4, the dummy light-emitting layer 7b3 and the light-emitting layer 117b may have the same material, but the present disclosure is not limited thereto. In some embodiments, the height difference between the dummy charge generation layer 6b4 and the dummy charge generation layer 6b3 in the direction perpendicular to the main surface of the base substrate may be defined by the second isolation height of the first inter-pixel isolation part 12a, for example, substantially equal to the second isolation height H2 of the first inter-pixel isolation part 12a.

In some embodiments, the dummy stack part DS3 may be adjacent to a portion of the second stack sub-part of the light-emitting stack part LS1, and the charge generation layers of the dummy stack part DS3 and the second stack sub-part of the light-emitting stack part LS1 may be connected to each other or disconnected from each other. In this example, the charge generation layers of the first stack sub-part and the second stack sub-part of the light-emitting stack part LS1 are disconnected from each other; therefore, even if the dummy charge generation layer 6b4 of the dummy stack part DS3 is connected to the charge generation layer 116a2 of the second stack sub-part, the dummy charge generation layer 6b4 still can be disconnected from the charge generation layer 116a1 of the first stack sub-part. Moreover, since the dummy charge generation layers 6b4 and 6b3 and the charge generation layer 116b2 of the light-emitting stack part LS2 are disconnected from each other by the inter-pixel isolation part 12a having the second isolation height, it is ensured that the charge generation layer 116a1 in the light-emitting device of the first sub-pixel SP1 and the charge generation layer 116b in the light-emitting device of the second sub-pixel SP2 can be effectively disconnected.

In some embodiments, the display panel 500a further includes a common electrode structure CE, and second electrodes of a plurality of sub-pixels share the common electrode structure CE. For example, the common electrode structure CE may include a second electrode layer E2 and an auxiliary electrode layer AE. The second electrode layer E2 is disposed on a side of the light-emitting stacked layer LE away from the base substrate 100; the auxiliary electrode layer AE is disposed on a side of the second electrode layer E2 away from the base substrate 100, and is electrically connected to the second electrode layer E2. In some embodiments, the orthographic projection of the auxiliary electrode layer AE on the base substrate overlaps with the orthographic projection of the isolation structure IS on the base substrate 100. The orthographic projection of the isolation structure IS on the base substrate 100 may be located within the range of the orthographic projection of the auxiliary electrode layer AE on the base substrate 100. It should be understood that, FIG. 3A schematically illustrates a common electrode structure CE disposed above the light-emitting stacked layer LE, without specifically illustrating the morphology of the common electrode structure. In some embodiments, the respective layers in the common electrode structure CE may have a morphology similar to that of the underlying structure.

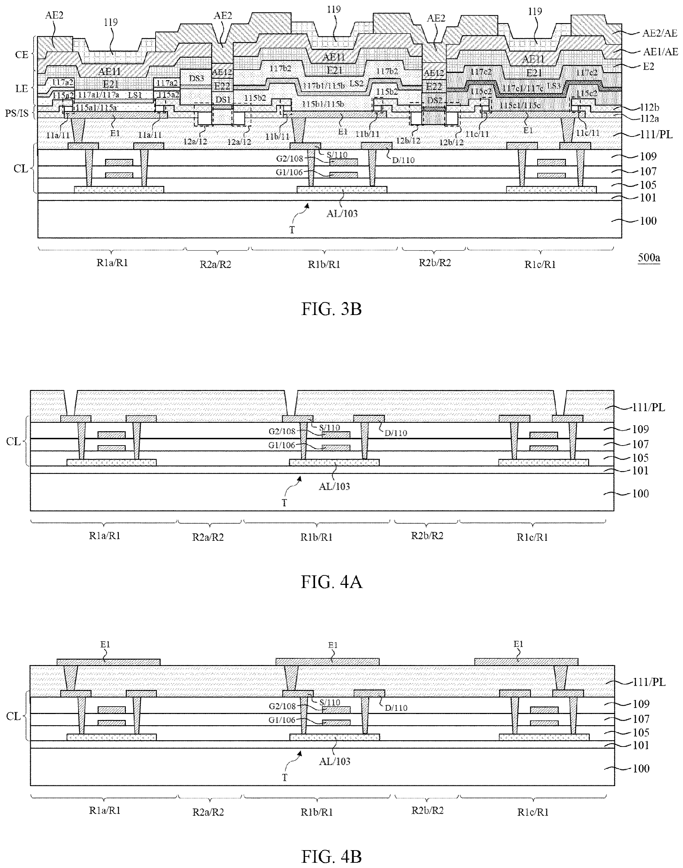

FIG. 3B is a schematic cross-sectional view of a display panel 500a according to some embodiments of the present disclosure, in which the morphology of a common electrode structure CE is schematically illustrated.

Referring to FIGs. 3A and 3B, in some embodiments, the second electrode layer E2 may include portions that are disconnected at the isolation structure IS (e.g., the inter-pixel isolation part 12), and the disconnected portions of the second electrode layer E2 may be electrically connected through the auxiliary electrode layer AE. For example, the second electrode layer E2 may be conformal with the underlying structure (i.e., the light-emitting stacked layer LE) and may include a plurality of first electrode portions E21 and one or more second electrode portions E22; the plurality of first electrode portions E21 are respectively located on the light-emitting stack parts of a plurality of sub-pixels, and the second electrode portion E22 is located on the dummy stack part in the sub-pixel spacing region. In some embodiments, the first electrode portion E21 and the second electrode portion E22 may be disconnected by the inter-pixel isolation part 12.

It should be noted that in FIG. 3A, in order to clearly illustrate the disconnection of the charge generation layers, a gap is illustrated between the light-emitting stack parts/dummy stack parts whose charge generation layers are disconnected, but it should be understood that the respective adjacent stack parts in the light-emitting stacked layer would be connected with and in contact with each other, or would overlap with each other in the direction perpendicular to the main surface of the base substrate, and the charge generation layers of these stack parts are disconnected from each other. FIG. 3B illustrates a case where adjacent stack parts are connected to each other. As illustrated in FIG. 3B, in some embodiments, the dummy stack part may be connected to adjacent light-emitting stack parts; at each isolation part, the sidewall of the extension part of the second pixel definition layer and the surface thereof at a side away from the base substrate may be covered by the light-emitting stacked layer; the undercut structure may be surrounded by the pixel definition layer, the light-emitting stacked layer and a material layer (e.g., the first electrode or the planarization structure) located underlying the pixel definition layer, and an air gap may be formed. That is, at least a portion of the undercut structure is not filled by the light-emitting stacked layer. It should be understood that the air gap may include air or any other type of gas therein, and the present disclosure is not limited thereto.

As illustrated in FIG. 3B, in some examples, the second electrode layer E2 may be continuous at the pixel region isolation part 11 and may be disconnected at the inter-pixel isolation part 12; for example, a plurality of first electrode portions E21 corresponding to a plurality of sub-pixels SP1, SP2, and SP3 are respectively disconnected from adjacent second electrode portions E22, so that the adjacent first electrode portions E21 are disconnected from each other.

In some embodiments, portions of the second electrode layer E2 that are disconnected from each other may be electrically connected through the auxiliary electrode layer AE. For example, the auxiliary electrode layer AE may include at least one of a first auxiliary electrode layer AE1 and a second auxiliary electrode layer AE2; the first auxiliary electrode layer AE1 may extend in the pixel region and the pixel spacing region, for example, may extend continuously, or may be disconnected at the isolation structure; the first auxiliary electrode layer AE1 is in contact with and electrically connected to the second electrode layer E2; the orthographic projection of the first auxiliary electrode layer AE1 on the base substrate overlaps or coincides with the orthographic projection of the second electrode layer E2 on the base substrate. In some embodiments, the orthographic projection of the second electrode layer E2 on the base substrate may be located within the orthographic projection of the first auxiliary electrode layer AE1 on the base substrate, but the present disclosure is not limited thereto.

In some embodiments, the first auxiliary electrode layer AE1 may also be disconnected at the isolation structure; for example, the first auxiliary electrode layer AE1 may include a first auxiliary electrode part AE11 and a second auxiliary electrode part AE12; the first auxiliary electrode part AE11 is located on (e.g., directly on) the light-emitting stack parts of a plurality of sub-pixels, and the second auxiliary electrode part AE12 is located on the dummy stack part in the isolation opening. In some embodiments, the first auxiliary electrode part AE11 and the second auxiliary electrode part AE12 may be disconnected by the inter-pixel isolation part 12 of the isolation structure IS, but the present disclosure is not limited thereto. In some other embodiments, the first auxiliary electrode part AE11 and the second auxiliary electrode part AE12 may be continuous with each other without being disconnected by the isolation structure.

As illustrated in FIG. 3B, in some embodiments, the second auxiliary electrode part AE12 covers the second electrode portion E22 and is in contact with and electrically connected to the adjacent first electrode portion E21, while the first electrode portion E21 is in contact with and electrically connected to the first auxiliary electrode part AE11; therefore, a plurality of first electrode portions E21 and second electrode portions E22 of the second electrode layer E2 that are disconnected by the isolation structure can be electrically connected through the second auxiliary electrode part AE12; the first auxiliary electrode part AE11 and the second auxiliary electrode part AE12 that are disconnected by the isolation structure may be electrically connected through the first electrode portions E21 of the second electrode layer E2.

Still referring to FIG. 3B, in the case that the auxiliary electrode layer AE includes both the first auxiliary electrode layer AE1 and the second auxiliary electrode layer AE2, the second auxiliary electrode layer AE2 may be disposed on a side of the first auxiliary electrode layer AE1 away from the base substrate 100. In some embodiments, the orthographic projection of the second auxiliary electrode layer AE2 on the base substrate may overlap with the orthographic projection of at least a portion of or the whole of the isolation structure IS on the base substrate 100, and may be offset from the orthographic projection of at least a portion of the light-emitting regions (i.e., sub-pixel openings) of a plurality of sub-pixels on the base substrate. FIG. 2G illustrates a schematic plan view of the second auxiliary electrode layer AE2, a plurality of sub-pixels and the isolation structure. Referring to FIG. 3B and FIG. 2G, in some embodiments, the orthographic projection of at least a portion of or the whole of the isolation structure IS on the base substrate is located within a range of the orthographic projection of the second auxiliary electrode layer AE2 on the base substrate.

For example, an electrode patterning layer 119 is disposed on a portion of the second electrode layer E21 and the first auxiliary electrode part AE11 which is located in the light-emitting region, and the electrode patterning layer 119 is a material used for selective deposition of electrode materials in the electrode forming process, so that the auxiliary electrode material is difficult to be formed in a region having the electrode patterning layer 119. The common electrode structure may be the cathode of the light-emitting device, and the electrode patterning layer 119 may be a cathode patterning material (CPM), that is, it is difficult to form a cathode material in the region where the cathode patterning material is located.

For example, the electrode patterning layer 119 is disposed at positions corresponding to the light-emitting regions of a plurality of sub-pixels; the orthographic projection of the electrode patterning layer 119 on the base substrate may overlap with the orthographic projection of a plurality of sub-pixel openings on the base substrate. For example, the orthographic projection of a plurality of sub-pixel openings on the base substrate may be located within the orthographic projection of the electrode patterning layer 119 on the base substrate. The second auxiliary electrode layer AE2 is formed in a region other than the electrode patterning layer 119, and may cover the second auxiliary electrode part AE12 and a portion of the first auxiliary electrode part AE11 adjacent thereto. In a case where the first auxiliary electrode part AE11 and the second auxiliary electrode part AE12 of the first auxiliary electrode layer AE1 are disconnected by the isolation structure, the first auxiliary electrode part AE11 and the second auxiliary electrode part AE12 can be electrically connected to each other through the second auxiliary electrode layer AE12; and the first electrode portion E21 and the second electrode portion E22 of the second electrode layer E2 that are disconnected from each other can also be electrically connected through the first auxiliary electrode layer AE1 and the second auxiliary electrode layer AE2.

In some embodiments, disposing the second auxiliary electrode layer AE2 can further ensure that the disconnected portions of the second electrode layer E2 are electrically connected to each other through the auxiliary electrode layer; meanwhile, the second auxiliary electrode layer AE2 is disposed in the region other than the cathode patterning material 119 corresponding to the light-emitting region, which can avoid lowering the light transmittance. In some embodiments, only the second auxiliary electrode layer AE2 may be provided and the first auxiliary electrode layer AE1 may be omitted. That is to say, the auxiliary electrode layer AE may be at least disposed in the region corresponding to the isolation structure, and the orthographic projection of at least the portions of the second electrode layer E2 disconnected by the isolation structure IS on the base substrate 100 is located within the range of the orthographic projection of the auxiliary electrode layer AE on the base substrate 100. In some embodiments, since the second electrode layer E2 is easily disconnected at the isolation part with a larger second isolation height, the second auxiliary electrode layer AE2 may be disposed at the position corresponding to the isolation part with the second isolation height, so that the disconnected portions of the second electrode layer E2 may be electrically connected through the auxiliary electrode layer.

It should be understood that, the morphology of the second electrode layer E2 and the disconnection thereof at the isolation parts, as well as the morphology of the respective layers in the common electrode structure and the arrangement of the auxiliary electrode layer AE illustrated in FIG. 3B can be set according to the disconnection of the second electrode layer E2 in practical application, so as to ensure that the disconnected portions of the second electrode layer E2 can be connected through the auxiliary electrode layer AE.

In the embodiment of the present disclosure, by disposing the auxiliary electrode layer, the disconnection of the second electrodes (e.g., cathodes) of the light-emitting devices of a plurality of sub-pixels can be further avoided, thereby avoiding the increase in resistance caused by the disconnection of the second electrodes, and thus avoiding the disadvantages such as poor brightness uniformity and high device power consumption. That is to say, the embodiment of the present disclosure can ensure that the second electrodes of the light-emitting devices of a plurality of sub-pixels are connected to each other and can be in a continuous structure through the related set of the isolation structure and/or the auxiliary electrode layer, thereby improving the brightness uniformity of the display panel and reducing the device power consumption.

Referring to FIG. 3A, in some embodiments, the display panel 500a may further include an encapsulation layer 120, and the encapsulation layer 120 is disposed on a side of the common electrode structure CE away from the base substrate to protect the light-emitting devices of a plurality of sub-pixels. For example, the encapsulation layer 120 can prevent external water and oxygen molecules from corroding the light-emitting devices of the display panel, thereby improving the service life of the light-emitting devices and the display panel.

FIGs. 4A to 4G illustrate schematic cross-sectional views of intermediate structures of various steps in a manufacturing method of a display panel according to some embodiments of the present disclosure.

Referring to FIG. 4A, in some embodiments, a base substrate 100 is provided, and a buffer layer 101 is formed on the base substrate 100; a pixel circuit layer CL is formed on a side of the buffer layer 101 away from the base substrate 100. The pixel circuit layer CL may include sub-pixel circuits of a plurality of sub-pixels and may include a plurality of thin film transistors and capacitors. For example, the pixel circuit layer CL may include an active material layer 103, a dielectric layer 105, a conductive layer 106, a dielectric layer 107, a conductive layer 108, a dielectric layer 109, and a conductive layer 110 that are sequentially stacked. A plurality of thin film transistors in a plurality of sub-pixel circuits may each include an active layer AL, a first gate G1, a second gate G2, a source electrode S, and a drain electrode D; the active layers AL, the first gates G1 and the second gates G2 of a plurality of thin film transistors may be respectively disposed in the active material layer 103, the conductive layer 106 and the conductive layer 108; the source electrodes S and drain electrodes D of a plurality of thin film transistors may be disposed in the conductive layer 110. The dielectric layer 105 is disposed between the conductive layer 106 and the active material layer 103, and may be used as a gate dielectric layer of a plurality of thin film transistors; the dielectric layer 107 is located between the conductive layer 106 and the conductive layer 108, and may be used as an inter-gate dielectric layer of a plurality of thin film transistors. The dielectric layer 109 may be disposed between the conductive layer 108 and the conductive layer 110, and the source electrodes S and the drain electrodes D extend through the dielectric layers 109, 107 and 105 and are connected to the corresponding active layers AL, respectively. For example, the dielectric layers 109, 107, and 105 are provided with via holes, and the source electrodes S and the drain electrodes D may be connected to the active layers AL through the via holes. In some embodiments, electrode plates of capacitors of a plurality of sub-pixel circuits may be disposed in two or more of the active material layer AL, the conductive layer 106, the conductive layer 108, and the conductive layer 110.

It should be noted that only one thin film transistor in each sub-pixel circuit is schematically illustrated in the figures, but it should be understood that, each sub-pixel circuit can adopt any suitable circuit structure according to product designs and requirements, for example, may be a pixel circuit such as 2T1C, 3T1C, 6T1C, 7T1C, 8T1C, 10T1C, 6T2C, 7T2C, 8T2C and 10T2C. In addition, each thin film transistor in the sub-pixel circuit may be an amorphous silicon thin film transistor, a low temperature polysilicon (LTPS) thin film transistor or an oxide thin film transistor; and the pixel circuit structure of each sub-pixel and the type of each thin film transistor can be set and adjusted according to product designs and requirements, which are not limited in the present disclosure.

Still referring to FIG. 4A, after the pixel circuit layer CL is formed, a planarization structure PL may be formed on a side of the pixel circuit layer CL away from the base substrate 100. For example, forming the planarization structure PL includes forming a planarization layer 111 on a side of the dielectric layer 109 away from the base substrate 100; the planarization layer 111 covers a sidewall of the conductive layer 110 and the surface thereof at a side away from the base substrate. The planarization structure PL may have a flat surface at the side away from the base substrate 100, so that light-emitting devices are formed subsequently on the flat surface, thereby improving the light emission uniformity of the light-emitting devices.

In some embodiments, a patterning process is performed on the planarization structure PL to form a plurality of via holes in the planarization structure PL, and each via hole extends through the planarization structure PL and exposes a corresponding component of the sub-pixel circuit, such as the source electrode S or the drain electrode D of the thin film transistor. The patterning process may include photolithography and etching processes.

Referring to FIG. 4B, a first electrode layer is formed on the planarization structure PL, and the first electrode layer may include first electrodes E1 of a plurality of sub-pixels, and each first electrode E1 is formed on a side of the planarization structure PL away from the base substrate 100 and connected to the source electrode S or the drain electrode D of the corresponding thin film transistor through a via hole. The plurality of first electrodes E1 may be formed by a deposition process such as sputtering and a patterning process. For example, after a plurality of via holes are formed in the planarization structure PL, a first electrode material layer may be formed on the planarization structure PL by a deposition process such as sputtering, and the first electrode material layer continuously extends at the side of the planarization structure PL away from the base substrate and is filled in the plurality of via holes to be electrically connected to the corresponding components of the sub-pixel circuits; the first electrode material layer may be a single-layer structure or a multilayer structure, for example, it may be a multilayer structure including stacked layers of ITO/Ag/ITO. In some examples, the thicknesses of ITO/Ag/ITO may be 80 angstroms, 1000 angstroms and 120 angstroms, respectively, but the present disclosure is not limited thereto. Thereafter, a patterning process may be performed on the first electrode material layer to form a plurality of first electrodes E1. The patterning process may include photolithography and etching processes.

Thereafter, a pixel definition structure PS and an isolation structure IS are formed on a side of the planarization structure PL and the first electrodes E1 away from the base substrate 100. For example, forming the pixel definition structure PS and the isolation structure IS may include: sequentially forming a first pixel definition layer and a second pixel definition layer on a side of the planarization structure; performing a first removal process to remove a portion of the second pixel definition layer, and forming an opening in the second pixel definition layer, wherein the opening is defined by an extension part of the second pixel definition layer and exposes a portion of a surface of the first pixel definition layer; and performing a second removal process to remove the portion of the first pixel definition layer exposed by the opening and a portion of the first pixel definition layer covered by the extension part of the second pixel definition layer, and forming an undercut structure at a side of the extension part close to the base substrate, wherein the isolation structure includes the extension part and the undercut structure. In some embodiments, after the second removal process, the pixel definition layer is formed with an isolation opening exposing a portion of a surface of the planarization structure; the manufacturing method may further include performing a third removal process to remove a portion of the planarization structure exposed by the isolation opening, and forming a recess in the planarization structure.

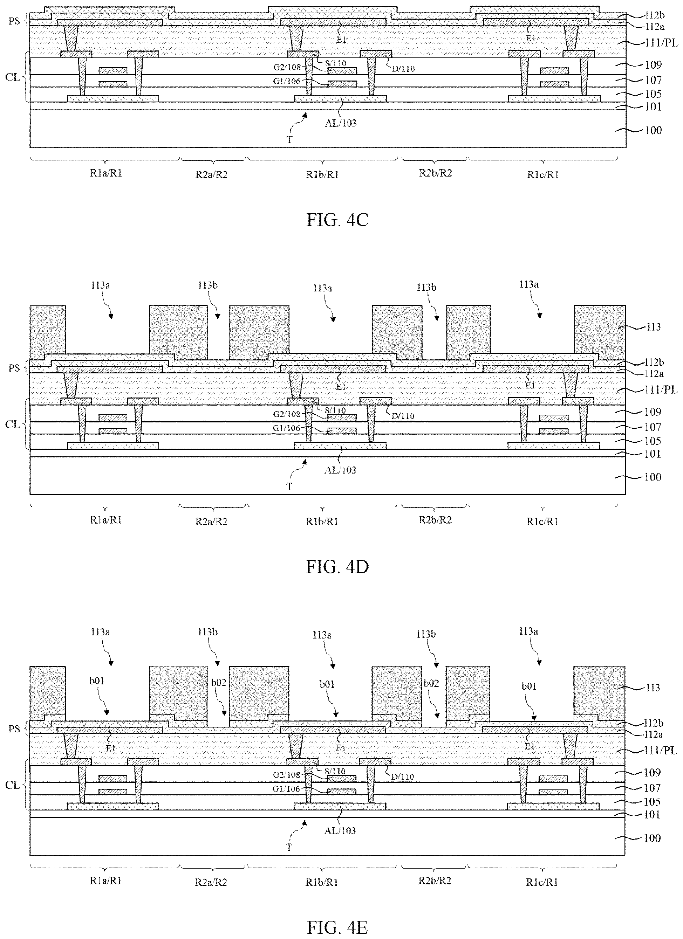

Referring to FIG. 4C, for example, a first pixel definition layer 112a is formed on a side of the planarization structure PL and the first electrodes E1 away from the base substrate 100, and a second pixel definition layer 112b is formed on a side of the first pixel definition layer 112a away from the base substrate 100. The first pixel definition layer 112a and the second pixel definition layer 112b may include different materials and have high etching selectivity ratio in the subsequent etching process; for example, at least one of the first pixel definition layer 112a and the second pixel definition layer 112b may include an inorganic material, such as an inorganic insulating material. In some embodiments, each pixel definition layer may include a material selected from inorganic materials such as SiO, SiN, SiON, SiCN, metal oxides such as Al₂O₃, NbO, Nb₂O₅, IGZO, TiO, and organic glues.

For example, one of the first pixel definition layer 112a and the second pixel definition layer 112b includes a first inorganic insulating material, and the other one of the first pixel definition layer 112a and the second pixel definition layer 112b includes a second inorganic insulating material or an organic insulating material. For example, in some examples, one of the first pixel definition layer 112a and the second pixel definition layer 112b includes aluminum oxide (Al₂O₃), and the other one of the first pixel definition layer 112a and the second pixel definition layer 112b includes silicon nitride (SiN) or silicon oxide (SiO); alternatively, one of the first pixel definition layer 112a and the second pixel definition layer 112b includes silicon oxide, and the other one of the first pixel definition layer 112a and the second pixel definition layer 112b includes silicon carbonitride (SiCN); alternatively, one of the first pixel definition layer 112a and the second pixel definition layer 112b includes titanium oxide (TiO), and the other one of the first pixel definition layer 112a and the second pixel definition layer 112b includes niobium oxide (Nb₂O₅).

Referring to FIG. 4D, a mask layer 113 is formed on a side of the first pixel definition layer 112a and the second pixel definition layer 112b away from the base substrate 100 to cover a portion of the pixel definition layer. The mask layer 113 may include a patterned photoresist layer, and has a first mask opening 113a and a second mask opening 113b. The first mask opening 113a and the second mask opening 113b may be respectively used to form a sub-pixel opening and an isolation opening in the pixel definition layer. For example, a plurality of first mask openings 113a respectively expose portions of the pixel definition layer directly above the plurality of first electrodes E1; the second mask opening 113b may expose a portion of the pixel definition layer that is located between adjacent first electrodes.

Referring to FIG. 4D and FIG. 4E, a first removal process is performed to remove a portion of the second pixel definition layer 112b and form an opening in the second pixel definition layer 112b. The first removal process may include performing an etching process on the second pixel definition layer 112b by using the mask layer 113 as an etching mask, so as to remove a portion of the second pixel definition layer 112b exposed by a plurality of mask openings of the mask layer 113, and forming a plurality of openings b01 and b02 in the second pixel definition layer 112b. The positions of the openings b01 and b02 correspond to the positions of the first mask openings 113a and the second mask openings 113b, respectively, and the openings b01 and b02 each expose a portion of a surface of the first pixel definition layer 112a at a side away from the base substrate. portions of the second pixel definition layer 112b that define the openings b01 and b02 are extension parts of the second pixel definition layer 112b.

Referring to FIG. 4F, in some embodiments, a second removal process is performed to remove a portion of the first pixel definition layer 112a. For example, the second removal process may include performing an etching process on the first pixel definition layer 112a by using the mask layer 113 and the patterned second pixel definition layer 112b as an etching mask, the etching process removes portions of the first pixel definition layer 112a exposed by a plurality of mask openings and a plurality of openings b01 and b02 of the second pixel definition layer, and removes portions of the first pixel definition layer 112a covered by the extension parts of the second pixel definition layer 112b; in this way, a plurality of openings a01 and a02 are formed in the first pixel definition layer 112a, and each opening includes an undercut structure located underlying the extension part of the second pixel definition layer. Each opening a01 and a corresponding opening b01 are in spatial communication with each other, and collectively constitute a sub-pixel opening of the pixel definition structure, and may be referred to as a first sub-opening and a second sub-opening of the sub-pixel opening respectively; each opening a02 and a corresponding opening b02 are in spatial communication with each other, and collectively constitute an isolation opening of the pixel definition structure, and may be referred to as a first sub-opening and a second sub-opening of the isolation opening, respectively.

In some embodiments, after removing these portions of the second pixel definition layer 112a, each sub-pixel opening exposes a portion of a surface of the first electrode E1, and each isolation opening exposes a portion of a surface of the planarization structure PL. In some embodiments, a third removal process may be further performed to remove a portion of the planarization structure PL exposed by the isolation opening, so as to form a recess rc in the planarization structure PL; the recess rc is in spatial communication with the corresponding isolation opening, and each recess rc may have substantially the same width as the corresponding opening a02 in the first pixel definition layer 112a, or may also have substantially the same width as the opening b02.

In some embodiments, the first removal process, the second removal process and the third removal process described above may be etching processes using one or more etching gases or etchants, and the etching process has a high etching selectivity ratio for the first pixel definition layer/planarization structure as compared to the second pixel definition layer. That is, the etching rate of the first pixel definition layer and the planarization structure may be larger than the etching rate of the second pixel definition layer, so that in the etching process, the first pixel definition layer and the planarization structure can be laterally recessed relative to the edge of the second pixel definition layer to form an undercut structure. However, the present disclosure is not limited thereto.

Referring to FIG. 4F and FIG. 4G, the mask layer 113 is removed, thereby completing the fabrication of the pixel definition structure PS, in which the portion of the pixel definition structure PS that defines the respective openings is used as the isolation structure IS.

Referring to FIG. 4G, FIG. 3A, and FIG. 3B, after the pixel definition structure PS and the isolation structure IS are formed, a light-emitting stacked layer may be formed on a side of the pixel definition structure PS away from the base substrate by multiple times of deposition processes such as evaporation processes. For example, the light-emitting stack part LS1, the light-emitting stack part LS2, and the light-emitting stack part LS3 are formed by a first evaporation process, a second evaporation process, and a third evaporation process, respectively. The evaporation region of each evaporation process covers at least the corresponding sub-pixel region and may further cover an adjacent sub-pixel spacing region; and the dummy stack part may be formed in the same evaporation process as one of adjacent light-emitting stack parts. For example, a dummy stack part DS1 and a dummy stack part DS3 may be further formed by the second evaporation process, and a dummy stack part DS2 may be further formed by the third evaporation process. That is, the respective layers in the dummy stack parts DS1, DS3 and the light-emitting stack part LS2 may be formed from the same materials; and the respective layers of the dummy stack part DS2 and the light-emitting stack part LS3 may be formed from the same materials.

Referring to FIG. 3A and FIG. 3B, a common electrode structure CE is formed on a side of the light-emitting stacked layer LE. For example, forming the common electrode structure CE may include: forming a second electrode layer E2 on a side of the light-emitting stacked layer LE away from the base substrate 100; forming a first auxiliary electrode layer AE1 on a side of the second electrode layer E2 away from the base substrate 100; forming an electrode patterning layer 119 on a side of the first auxiliary electrode layer AE1 away from the base substrate 100, wherein the electrode patterning layer 119 may be formed in regions corresponding to the light-emitting regions of the respective sub-pixels; then forming a second auxiliary electrode layer AE2 on a side of the first auxiliary electrode layer AE1 away from the base substrate 100. Since the electrode patterning layer 119 is provided in the regions corresponding to the light-emitting regions of the respective sub-pixels, electrode material of the second auxiliary electrode layer would not be formed in these regions, but is formed in regions on the first auxiliary electrode layer AE1 where the electrode patterning layer 119 is not disposed. Thereafter, an encapsulation process may be performed to form an encapsulation layer 120 at a side of the common electrode structure CE away from the base substrate, thereby protecting the light-emitting devices of a plurality of sub-pixels.

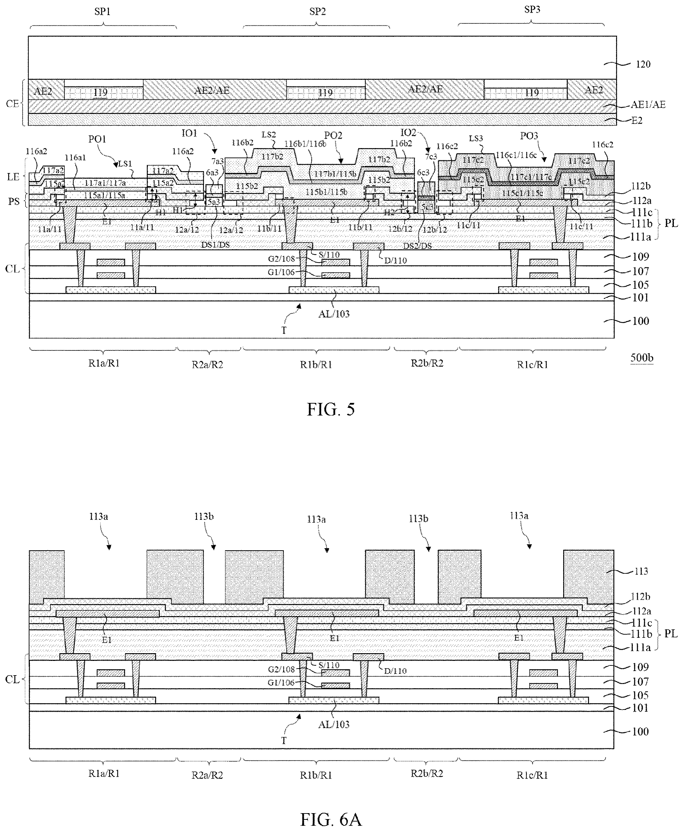

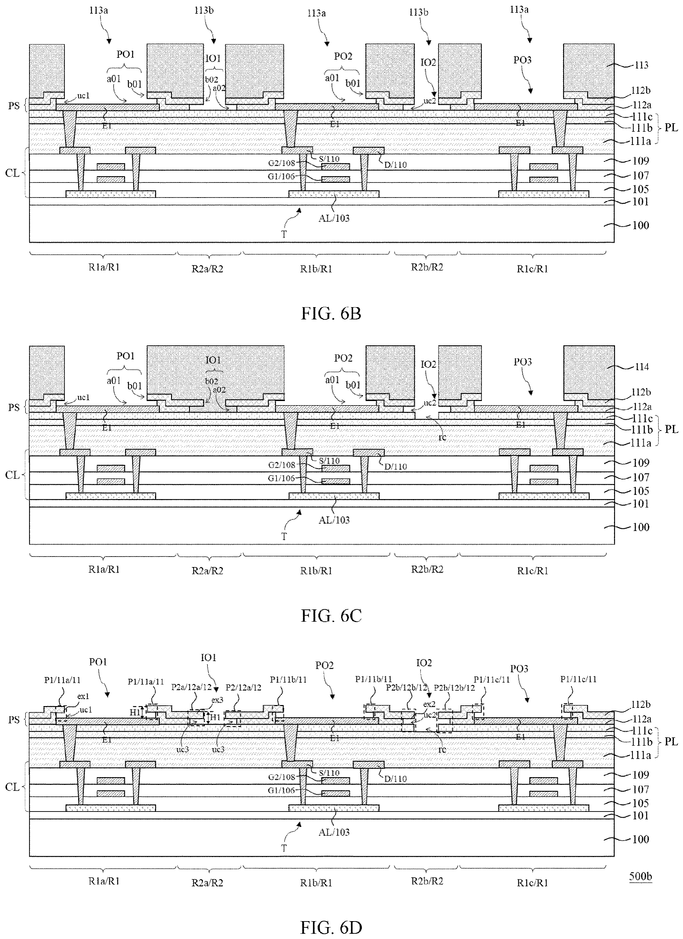

FIG. 5 illustrates a schematic cross-sectional view of a display panel 500b according to some other embodiments of the present disclosure. FIG. 6D illustrates a schematic cross-sectional view of a part of the structure of the display panel 500b, including a pixel definition structure. The display panel 500b is similar to the display panel 500a, with the difference that in the display panel 500b, the inter-pixel isolation parts of the isolation structure located in different pixel spacing regions may have different isolation heights, and the planarization structure PL may be a multilayer structure. Hereinafter, the features of the display panel 500b that are different from the display panel 500a will be described in details. The features of the display panel 500b that are similar to those of the previous embodiment can refer to the contents described above with respect to the display panel 500a, which will not be repeated below.

Referring to FIG. 5, in some embodiments, the planarization structure PL may be a multilayer structure and may include, for example, a planarization layer 111a, a buffer layer 111b and a passivation layer 111c; materials of the planarization layer 111a, the buffer layer 111b and the passivation layer 111c may be different from each other; the buffer layer 111b and the passivation layer 111c may include materials having a high etching selectivity ratio in the etching process. For example, the passivation layer 111c may include one selected from SiO, SiN, SiON and AL₂O₃. In an example, the passivation layer 111c includes AL₂O₃ and the buffer layer 111b includes SiO, but the present disclosure is not limited thereto.

The pixel definition structure PS may include a first pixel definition layer 112a and a second pixel definition layer 112b, and may have a plurality of sub-pixel openings PO1, PO2, PO3 and isolation openings IO1, IO2. The structures of the respective openings of the pixel definition structure PS are similar to those of the previous embodiment, which are not described again here.

In some embodiments, the pixel definition structure PS has a sub-pixel opening definition part P1 for defining a sub-pixel opening and an isolation opening definition part P2 for defining an isolation opening; each sub-pixel opening definition part includes a first extension part ex1 of the second pixel definition layer 112b, and a first undercut structure uc1 is provided between the first extension part ex1 and the first electrode E1, and the first undercut structure uc1 is defined by surfaces of the first extension part ex1 and the first electrode E1 facing each other and a sidewall of the first pixel definition layer 112a.

In some embodiments, a plurality of isolation opening definition parts P2 include isolation opening definition parts P2a and P2b. The isolation opening definition parts P2a and P2b respectively define an isolation opening IO1 between adjacent sub-pixels P1, P2 and an isolation opening IO2 between adjacent sub-pixels P2, P3. The isolation opening definition part P2a has an extension part ex3, and an undercut structure uc3 is provided between the extension part ex3 and the passivation layer 111c of the planarization structure PL. The isolation opening definition part P2b has an extension part ex2, and an undercut structure uc3 is provided between the extension part ex2 and the passivation layer 111c of the planarization structure PL.

In some embodiments, the planarization structure PL has a recess at a position corresponding to part of the isolation openings, and may not have a recess at a position corresponding to another part of the isolation openings. The recess may be formed in the passivation layer. For example, the planarization structure PL may have a recess rc, the recess rc may be located in the passivation layer 111c and in spatial communication with the isolation opening IO2. In some embodiments, the width of the recess rc may be smaller than the width of the first sub-opening in the isolation opening IO2 (i.e., the width of a corresponding opening in the first pixel definition layer 112a) and may be substantially equal to the width of the second sub-opening in the isolation opening IO2 (i.e., the width of a corresponding opening in the second pixel definition layer 112b). For example, the orthographic projection of the recess rc on the base substrate overlaps with the orthographic projection of the isolation opening IO2 on the base substrate, and may be located within the orthographic projection of the isolation opening IO2 on the base substrate. For example, the orthographic projection of the recess rc on the base substrate may substantially coincide with the orthographic projection of the second sub-opening of the isolation opening IO2 on the base substrate, and the orthographic projections of the recess rc and the second sub-opening on the base substrate may be located within the orthographic projection of the first sub-opening on the base substrate.

In some embodiments, the recess rc may be referred to as a passivation opening of the passivation layer 111c, and a portion of the passivation layer 111c that defines the passivation opening protrudes from a portion of the first pixel definition layer 112a that defines the isolation opening in a direction parallel to the main surface of the base substrate, and may also be referred to as a passivation extension part. That is, the undercut structure uc2 may be located between the extension part ex2 of the second pixel definition layer 112b and the passivation extension part of the passivation layer 111c in a direction perpendicular to the main surface of the base substrate, and may be defined by surfaces of the extension part ex2 and the passivation extension part that are facing each other and a sidewall of the first pixel definition layer 112a. In some embodiments, the isolation opening IO2 and the recess rc (i.e., the passivation opening) expose a portion of a surface of the buffer layer 111b at a side away from the base substrate.

In some embodiments, the planarization structure PL may not be provided with a recess at the position corresponding to the isolation opening IO1, that is, the isolation opening IO1 may expose a portion of a surface of the passivation layer 111c at a side away from the base substrate, and the buffer layer 111b is covered by the passivation layer 111c without being exposed by the isolation opening IO1.

Still referring to FIG. 5 and FIG. 6D, in some embodiments, the isolation structure IS may include a portion of the pixel definition structure PS and a portion of the planarization structure PL; for example, the isolation structure IS may include a plurality of pixel region isolation parts 11 and a plurality of inter-pixel isolation parts 12. The plurality of pixel region isolation parts 11 may each include an extension part ex1 of the second pixel definition layer 112b and an undercut structure uc1 located between the extension part ex1 and the first electrode E1. In some embodiments, the plurality of pixel region isolation parts 11 may have the same first isolation height H1, and the first isolation height H1 may be defined by the sum of the thickness of the extension part of the second pixel definition layer 112b and the height of the undercut structure uc1; the height of the undercut structure uc1 is substantially equal to the thickness of the first pixel definition layer 112a. That is, the first isolation height H1 may be substantially equal to the sum of the thicknesses of the second pixel definition layer 112b and the first pixel definition layer 112a.

In some embodiments, the plurality of inter-pixel isolation parts 12 may include a first inter-pixel isolation part 12a and a second inter-pixel isolation part 12b; for example, the first inter-pixel isolation part 12a may include an extension part ex3 of the second pixel definition layer 112b and an undercut structure uc3 located between the extension part ex3 and the passivation layer 111c; the second inter-pixel isolation part 12b may include an extension part ex2 of the second pixel definition layer 112b, an undercut structure uc2 located between the extension part ex2 and the planarization structure, and a portion of the planarization structure PL that has a recess (e.g., a passivation extension part of the passivation layer 111c). In some embodiments, the first inter-pixel isolation part 12a may be located between adjacent first and second sub-pixels or may be located between adjacent first and third sub-pixels; the second inter-pixel isolation part 12b may be located between adjacent second and third sub-pixels.

The first inter-pixel isolation part 12a and the second inter-pixel isolation part 12b may have different isolation heights. In this embodiment, the first inter-pixel isolation part 12a may have a first isolation height H1, and the first isolation height H1 may be defined by the depth of the isolation opening IO1, that is, defined by the sum of the thickness of the extension part of the second pixel definition layer 112b and the height of the undercut structure uc3, and the height of the undercut structure uc3 may be substantially equal to the thickness of the first pixel definition layer 112a; for example, the first isolation height H1 may be substantially equal to the sum of the thicknesses of the first pixel definition layer 112a and the second pixel definition layer 112b. The second inter-pixel isolation part 12b may have a second isolation height H2, and the second isolation height H2 may be defined by the sum of the depth of the isolation opening IO2 and the depth of the recess rc. The depth of the isolation opening IO2 is substantially equal to the sum of the thickness of the second pixel definition layer 112b and the thickness of the first pixel definition layer 112a; the depth of the recess rc may be substantially equal to the thickness of the passivation layer 111c. For example, the second isolation height H2 may be substantially equal to the sum of the thicknesses of the first pixel definition layer 112a, the second pixel definition layer 112b and the passivation layer 111c. However, the present disclosure is not limited thereto. In some other embodiments, the depth of the recess in the planarization structure may also be larger than the thickness of the passivation layer, and the multilayer structure of the planarization structure is advantaged for controlling the depth of the recess.

Referring to FIG. 5, in some embodiments, the light-emitting stacked layer LE includes light-emitting stack parts LS1, LS2, LS3 and dummy stack parts DS1, DS2. In this embodiment, the positions of the respective stack parts among the light-emitting stack parts LS2, LS3 and the dummy stack part DS2, and the related features such as the material layers included therein are similar to those of the display panel 500a, which are not described again here. The charge generation layers in the light-emitting stack parts LS2, LS3 and the dummy charge generation layer 6c3 in the dummy stack part DS2 are disconnected from each other by the inter-pixel isolation part 12b.

Similar to the foregoing embodiment, in the light-emitting stack part LS1, the charge generation layer 116a1 of the first stack sub-part in the sub-pixel opening PO1 and the charge generation layer 116a2 of the second stack sub-part located are disconnected from each other by the pixel region isolation part 11a. In some embodiments, the dummy stack part DS1 is located in the isolation opening IO1 of the pixel definition structure PS, and includes a dummy light-emitting layer 5a3, a dummy charge generation layer 6a3, and a dummy light-emitting layer 7a3 which are stacked in sequence in a direction perpendicular to the main surface of the base substrate.

The dummy charge generation layer 6a3 in the dummy stack part DS1 and the charge generation layers 116a2, 116b2 in the light-emitting stack parts LS1, LS2 may be disconnected from each other by the inter-pixel isolation part 12a having the first isolation height H1. In some embodiments, the dummy light-emitting layer 5a3, the dummy charge generation layer 6a3 and the dummy light-emitting layer 7a3 in the dummy stack part DS1 have the same materials as the light-emitting layer 15a, the charge generation layer 116a and the light-emitting layer 117a of the light-emitting stack part LS1, respectively, and the respective material layers in the dummy stack part DS1 and the corresponding respective material layers in the light-emitting stack part LS1 can be formed by the same forming processes (e.g., evaporation process), respectively.

In this example, the second stack sub-part of the light-emitting stack part LS1 may continuously extend from a location on the sub-pixel opening definition part of the pixel definition structure LS for defining the sub-pixel opening PO1 to a location on the isolation opening definition part for defining the isolation opening IO1, and there may be free of other dummy stack parts, adjacent to the second stack sub-part and including different materials, disposed on the side of the pixel definition structure away from the base substrate, for example, there may be free of dummy stack part, similar to the third dummy stack part DS3 in the display panel 500a, disposed on the side of the pixel definition structure away from the base substrate.

Still referring to FIG. 5, in some embodiments, the height difference between the dummy charge generation layer 6a3 of the dummy stack part DS1 and the charge generation layer 116a2 in the second stack sub-part of the light-emitting stack part LS1 in the direction perpendicular to the main surface of the base substrate may be defined by the isolation height (e.g., the first isolation height H1) of the inter-pixel isolation part 12a; for example, the height difference between the dummy charge generation layer 6a3 and the charge generation layer 116a2 may be substantially equal to the first isolation height H1, but the present disclosure is not limited thereto.

In this embodiment, the respective material layers of the dummy stack part DS1 and the respective material layers of the light-emitting stack part LS1 are formed of the same materials, that is, the thickness of the dummy light-emitting layer and the thickness of the light-emitting layer in the light-emitting stack part are both relatively small; therefore, the inter-pixel isolation part 12a can disconnect the charge generation layers of the first sub-pixel and an adjacent sub-pixel using a relatively small first isolation height H1. Moreover, the relatively small isolation height can reduce the possibility that the second electrodes located on the light-emitting stack part LS1 and the dummy stack part DS1 are disconnected, thereby avoiding or reducing the defects such as poor brightness uniformity and high power consumption of the light-emitting device module caused by the voltage drop due to the disconnection of the second electrodes.

The common electrode structure CE and the encapsulation layer 120 are disposed on a side of the light-emitting stacked layer LE away from the base substrate; similar to the display panel 500a, the common electrode structure CE includes a second electrode layer E2 and an auxiliary electrode layer CE; in some examples, the second electrode layer E2 may be disconnected at one or more isolation parts of the isolation structure (e.g., the second inter-pixel isolation part 12b), and the disconnected portions of the second electrode layer E2 may be electrically connected through the auxiliary electrode layer. Related features and specific morphology of the common electrode structure CE are similar to those described with respect to the display panel 500a in the above embodiment, and will not be repeated here.

FIGs. 6A to 6D illustrate schematic cross-sectional views of intermediate structures of various steps in a manufacturing method of the display panel 500b according to some embodiments of the present disclosure. The differences between the manufacturing method and the previous embodiment are described in detail below, and the steps and/or processes similar to those of the previous embodiment can refer to the above description, which will not be described again below.

Referring to FIG. 6A, in some embodiments, after the pixel circuit layer CL is formed on the base substrate 100, a planarization structure PL is formed on a side of the pixel circuit layer CL away from the base substrate. In some embodiments, forming the planarization structure PL may include: sequentially forming a planarization layer 111a, a buffer layer 111b and a passivation layer 111c on the pixel circuit layer CL by a deposition process; then forming a plurality of via holes in the planarization structure PL, each via hole extending through the passivation layer 111c, the buffer layer 111b and the planarization layer 111a to expose a corresponding component in the sub-pixel circuit, such as the source electrode or the drain electrode of the thin film transistor.

A plurality of first electrodes E1 is formed on the planarization structure PL; each first electrode E1 is formed on a side of the passivation layer 111c in the planarization structure PL away from the base substrate, and is connected to a corresponding sub-pixel circuit through a via hole.

Referring to FIGs. 6A to 6D, a pixel definition structure PS is formed on a side of the planarization structure PL and the first electrodes E1 away from the base substrate. For example, forming the pixel definition structure may include the following processes: forming a first pixel definition layer 112a on the passivation layer 111c to cover the sidewalls of the plurality of first electrodes E1 and the surfaces thereof at a side away from the base substrate; forming a second pixel definition layer 112b on a side of the first pixel definition layer 112a away from the base substrate; and performing a patterning process on the second pixel definition layer 112b and the first pixel definition layer 112a to form a plurality of sub-pixel openings and isolation openings in the pixel definition structure. For example, the patterning process includes: forming a mask layer 113 including a plurality of first mask openings 113a and second mask openings 113b on a side of the second pixel definition layer 112b away from the base substrate; and then etching the pixel definition structure using the mask layer 113 as an etching mask, so as to remove a portion of the second pixel definition layer 112b and a portion of the first pixel definition layer 112a.

Referring to FIG. 6A and FIG. 6B, in some embodiments, a first removal process is performed to remove the portion of the second pixel definition layer 112b exposed by the mask layer 113, and form a plurality of openings b01 and b02 in the second pixel definition layer 112b which respectively expose portions of a surface of the first pixel definition layer 112b; and a second removal process is performed to remove the portions of the first pixel definition layer 112a exposed by the plurality of openings b01 and b02 and portions of the first pixel definition layer 112a covered by the extension parts of the second pixel definition layer 112b, and form a plurality of openings a01 and a02 in the first pixel definition layer 112a, each of which includes an undercut structure located below the corresponding extension part of the second pixel definition layer 112b.

Referring to FIG. 6B and FIG. 6C, in some embodiments, after a plurality of sub-pixel openings and isolation openings are formed in the pixel definition structure PS, a third removal process may be further performed to remove a portion of the planarization structure PL exposed by a part of the isolation openings, and to form a recess rc in the planarization structure PL. For example, the third removal process may include: removing a portion of the passivation layer 111c exposed by a part of the isolation openings through an etching process, and forming a passivation opening in the passivation layer 111c, wherein the passivation opening constitutes a recess rc in the planarization structure PL. In some embodiments, in the third removal process, a portion of the passivation layer 111c exposed by another part of the isolation openings is covered by the mask layer and will not be removed. For example, the third removal process may remove a portion of the passivation layer 111c exposed by the isolation opening IO2, while the isolation opening IO1 may be covered by a mask layer, so that the portion of the passivation layer 111c exposed by the isolation opening IO1 is covered by the mask layer in the third removal process without being removed.

For example, before the third removal process, a mask layer 114 may be formed on a side of the pixel definition structure PS away from the base substrate, and the mask layer 114 covers the pixel definition structure PS and fills in the isolation opening IO1 to cover the passivation layer 111c exposed by the isolation opening IO1. Forming the mask layer 114 may include: filling a mask material into the mask opening 113b of the mask layer 113 corresponding to the isolation opening IO1. In this example, the mask layer 114 still has mask openings exposing the light-emitting regions of the respective sub-pixels. Alternatively, the mask layer 113 may be removed before the mask layer 114 is formed. In such examples, the mask layer 114 may only have a mask opening corresponding to the isolation opening IO2, and may not have mask openings at positions corresponding to the respective pixel openings and other isolation openings.

In some embodiments, the second removal process may include an isotropic etching process, and the etching process has a high etching selectivity ratio of the first pixel definition layer 112b to the second pixel definition layer 112a, and may also have a high etching selectivity ratio of the first pixel definition layer 112b to the passivation layer 111c; the third removal process may include an anisotropic etching process, and the buffer layer 111b and/or the first electrode E1 may serve as an etching stop layer of the etching process.

Referring to FIG. 6C, FIG. 6D and FIG. 5, the mask layer 114 is removed, and then components such as a light-emitting stacked layer, a common electrode structure and an encapsulation layer may be formed on a side of the pixel definition structure PS away from the base substrate, thereby forming the display panel 500b. The subsequent processes are similar to those described in the previous embodiments, with the differences that, when forming the light-emitting stacked layer, the evaporation region of the first evaporation process for forming the light-emitting stack part LS1 may further cover a portion of the first pixel spacing region R2a, so that the light-emitting stack part LS1 and the dummy stack part DS1 are simultaneously formed by the first evaporation process. That is to say, the respective material layers in the light-emitting stack part LS1 and the dummy stack part DS1 may be formed by using the same materials through the same evaporation process.

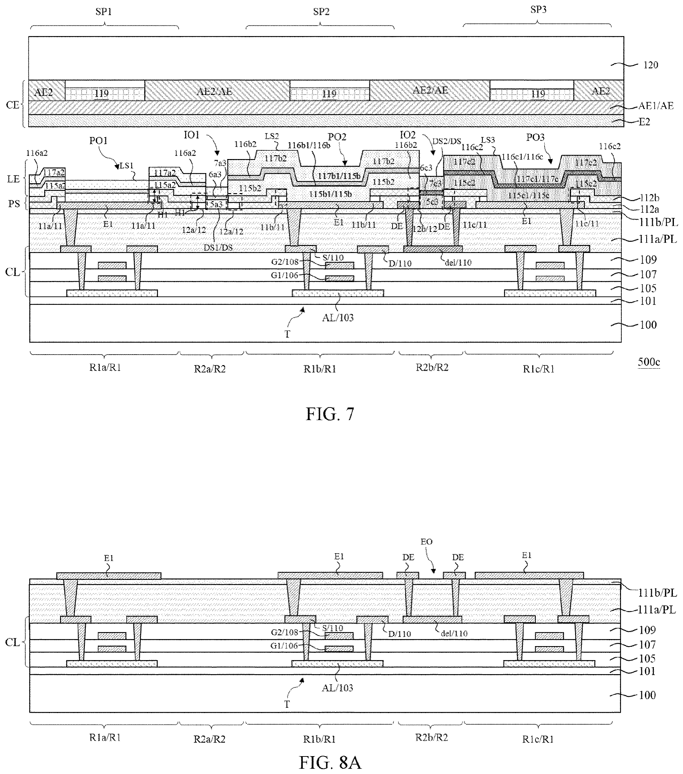

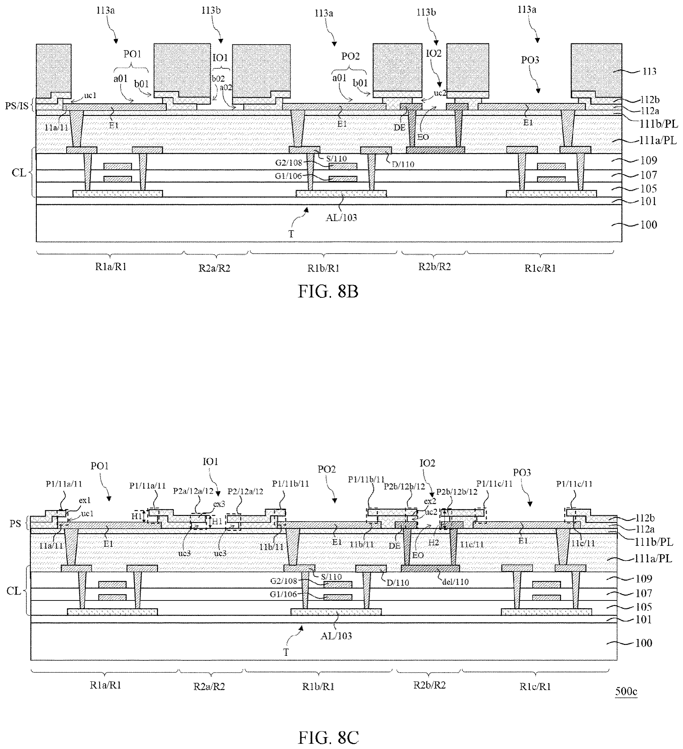

FIG. 7 illustrates a schematic cross-sectional view of a display panel 500c according to still other embodiments of the present disclosure. FIG. 8C illustrates a schematic cross-sectional view of a part (e.g., a pixel definition structure, etc.) of the structure of the display panel 500c. The display panel 500c is similar to the display panel 500b of the previous embodiment, with the difference that the display panel 500c further includes a dummy electrode. The difference between the display panel 500c and the aforementioned embodiment will be described in details below. Other features of the display panel 500c similar to those of the aforementioned embodiment can refer to the above description, and will not be repeated below.

In some embodiments, the dummy electrode and the first electrode may be disposed in the same electrode layer and electrically isolated from each other; at least one of the dummy stack parts may be connected to the dummy electrode. For example, the dummy electrode may be located between the planarization structure and the isolation opening definition part of the pixel definition structure in the direction perpendicular to the main surface of the base substrate, and the dummy electrode may have an electrode opening which is in spatial communication with the corresponding isolation opening of the pixel definition structure. For example, a portion of the inter-pixel isolation parts of the isolation structure may include an extension part of the isolation opening definition part, a dummy electrode, and an undercut structure located between the extension part and the dummy electrode, and the inter-pixel isolation part has a second isolation height defined by the sum of the depth of the isolation opening and the depth of the electrode opening.

For example, referring to FIG. 7, in some embodiments, the display panel 500b further includes a dummy electrode DE, the dummy electrode DE may be disposed on a side of the planarization structure PL away from the base substrate and may be disposed in the same layer as the first electrodes E1 of a plurality of sub-pixels. In the present disclosure, multiple components being disposed in the same layer may include the case where these components are formed from the same material layer by the same patterning process. That is, the dummy electrode DE and a plurality of first electrodes E1 may be formed from the same material layer through the same patterning process.

Referring to FIG. 7 and FIG. 8C, in some embodiments, at least a portion of the dummy electrode DE is located between the planarization structure PL and the isolation opening definition part P2b of the pixel definition structure PS. For example, the isolation opening definition part P2b has an extension part ex2, and an undercut structure uc2 is provided between the extension part ex2 and the dummy electrode DE. The orthographic projection of the dummy electrode DE on the main surface of the base substrate may overlap with the orthographic projection of the extension part ex2 of the second pixel definition layer on the base substrate. The dummy electrode DE has an electrode opening EO, and the electrode opening EO is in spatial communication with the isolation opening IO2. The width of the electrode opening EO may be the same as or different from the width of the isolation opening IO2. For example, the width of the electrode opening EO may be substantially equal to the width of the second sub-opening of the isolation opening IO2 and smaller than the width of the first sub-opening, but the present disclosure is not limited thereto. In some other embodiments, the width of the electrode opening EO may also be smaller than or larger than the width of the second sub-opening, and may be smaller than or substantially equal to the width of the first sub-opening. In some embodiments, a portion of the dummy electrode DE extends beyond the edge of the first pixel definition layer in a direction parallel to the main surface of the base substrate, and this portion may be referred to as an electrode extension part.

In some embodiments, the inter-pixel isolation part 12b of the isolation structure IS may include an extension part ex2 of the second pixel definition layer, an undercut structure uc2 and an electrode extension part of the dummy electrode DE, and the second isolation height H2 of the inter-pixel isolation part 12b may be defined by the sum of the depth of the isolation opening IO2 and the depth of the electrode opening EO. For example, the depth of the isolation opening IO2 is substantially equal to the sum of the thicknesses of the first pixel definition layer 112a and the second pixel definition layer 112b, and the depth of the electrode opening EO may be substantially equal to the thickness of the dummy electrode DE. In some examples, the second isolation height H2 may be substantially equal to the sum of the thicknesses of the first pixel definition layer 112a, the second pixel definition layer 112b and the dummy electrode DE.

In some embodiments, the electrode opening EO exposes a portion of a surface of the planarization structure PL, and there may be free of recess provided in the planarization structure PL, but the present disclosure is not limited thereto. In an alternative embodiment, the planarization structure PL may also have a recess, and the recess may be in spatial communication with the electrode opening and the isolation opening, so that the isolation height of the inter-pixel isolation part may be defined by the sum of the depths of the isolation opening, the electrode opening and the recess. It should be understood that the isolation height can be set and adjusted according to product designs and requirements.

In some embodiments, the planarization structure PL may include a single-layer structure or a multilayer structure. For example, the planarization structure PL may include a planarization layer 111a and a buffer layer 111b, but the present disclosure is not limited thereto. The planarization structure PL may further include other material layers, such as the passivation layer illustrated in FIG. 5, or may also include fewer material layers, for example, the buffer layer 111b may be omitted and only the planarization layer 111a may be included in the planarization structure PL.

In some embodiments, the dummy electrode DE may be connected to a low-voltage signal, such as a low-voltage terminal such as ground, zero potential, power supply voltage VSS, etc. The dummy electrode DE may be connected to a dummy electrode signal line, and the dummy electrode signal line may be disposed in at least one of the conductive layer 110, the conductive layer 108, the conductive layer 106, and the active material layer 103. For example, the dummy electrode DE may be electrically connected to a dummy electrode signal line del located in the conductive layer 110 through a via hole in the planarization structure PL, and the dummy electrode signal line is configured to apply a low-voltage signal to the dummy electrode DE. However, the present disclosure is not limited thereto. In alternative embodiments, the dummy electrode DE may also be electrically floating, that is, not connected to any other conductive component and/or voltage source.

Still referring to FIG. 7 and FIG. 8C, in some embodiments, the structures and isolation heights of a plurality of pixel region isolation parts 11 and inter-pixel isolation parts 12a in the isolation structure IS are similar to those of the display panel 500b, which will not be repeated here.

In some embodiments, in the light-emitting stacked layer LE, the dummy stack part DS2 is located in the isolation opening IO2 and the electrode opening DE, and the dummy charge generation layer 6c3 in the dummy stack part DS2 can be disconnected from the charge generation layers 116b2 and 116c2 in the light-emitting stack parts LS2 and LS3 through the inter-pixel isolation part 12b. In some embodiments, the dummy stack part DS2 may be connected to the dummy electrode DE, and the dummy electrode DE is kept in a low voltage state, so that it can be beneficial to leading out excess charges generated in the dummy stack part and/or the light-emitting device (e.g., the charge generation layer, the hole injection layer, etc.) and prevent the device from being damaged by charge accumulation.

FIGs. 8A to 8C illustrate schematic cross-sectional views of intermediate structures of various steps in a manufacturing method of a display panel 500c according to some embodiments of the present disclosure.

Referring to FIG. 8A, in some embodiments, a pixel circuit layer CL is formed on a side of the base substrate 100. Forming the pixel circuit layer CL may further include forming a dummy electrode signal line in one or more of the active layer AL, the conductive layer 106, the conductive layer 108 and the conductive layer 110; that is, the dummy electrode signal line may be provided in the same layer as at least one of the active layer AL, the first gate electrode G1, the second gate electrode G2, and the source electrode S/drain electrode D. For example, forming the conductive layer 110 further includes forming a dummy electrode signal line del; for example, the source electrode S, the drain electrode D and the dummy electrode signal line del may be formed from the same material through the same patterning process.

A planarization structure PL is formed on a side of the pixel circuit layer CL away from the base substrate 100, and the planarization structure PL may include, for example, a planarization layer 111a and a buffer layer 111b, but the present disclosure is not limited thereto. Thereafter, a patterning process is performed on the planarization structure PL to form a plurality of via holes in the planarization structure PL, which may include one or more via holes (or referred to as first via holes) exposing relevant component(s) of the sub-pixel circuit (e.g., a source electrode or a drain electrode of a thin film transistor) and one or more via holes (or referred to as second via holes) exposing the dummy electrode signal line del. It should be understood that, in the case where the dummy electrode signal line is disposed in the active layer AL, the conductive layer 106 or the conductive layer 108, the second via hole is further formed in corresponding dielectric layer(s) at a side of the planarization structure PL close to the base substrate, so as to expose the dummy electrode signal line.

Thereafter, a plurality of first electrodes E1 and a dummy electrode DE are formed on the planarization structure PL, the plurality of first electrodes E1 are formed on a side of the planarization structure PL away from the base substrate and filled in a plurality of first via holes so as to be electrically connected to corresponding sub-pixel circuits respectively; the dummy electrode DE is formed on a side of the planarization structure PL away from the base substrate, and filled in a plurality of second via holes so as to be electrically connected to the dummy electrode signal line del. In some embodiments, the plurality of first electrodes E1 and the dummy electrode DE may be formed by forming a first electrode material layer on the planarization structure PL and then performing a patterning process on the first electrode material layer. In some embodiments, an electrode opening EO may also be formed in the dummy electrode DE by the patterning process. For example, the dummy electrode DE may be a continuous ring-shaped electrode, and the electrode opening is located in the ring-shaped electrode; alternatively, the dummy electrode DE may include a plurality of dummy sub-electrodes separated from each other, and the electrode opening EO is located between adjacent dummy sub-electrodes.

Referring to FIG. 8A and FIG. 8B, a pixel definition structure PS is formed on a side of the planarization structure PL away from the base substrate, and a portion of the pixel definition structure PS and the dummy electrode DE together constitute an isolation structure IS. The forming method of the pixel definition structure PS is similar to that of the previous embodiment, and includes the following processes, for example: forming a first pixel definition layer 112a on a side of the planarization structure PL away from the base substrate to cover sidewalls of the first electrode E1 and the dummy electrode DE and the surfaces thereof at a side away from the base substrate; forming a second pixel definition layer 112b on a side of the first pixel definition layer 112a away from the base substrate; forming a mask layer 113 on a side of the second pixel definition layer 112b away from the base substrate, wherein the mask layer 113 may include, for example, a first mask opening 113a and a second mask opening 113b, wherein a portion of the second mask opening 113b may be located at a position corresponding to the electrode opening EO of the dummy electrode DE; then performing an etching process on the second pixel definition layer 112b and the first pixel definition layer 112a by using the mask layer 113 as an etching mask and by using the first electrode E1, the dummy electrode DE and the planarization structure PL as an etching stop layer in the etching process. A plurality of sub-pixel openings PO1, PO2, PO3 and isolation openings IO1, IO2 are formed in the pixel definition structure PS by the etching process, and the pixel definition material located in the electrode opening EO is removed by the etching process, so that the formed isolation opening IO2 and the electrode opening EO are in spatial communication with each other, and a portion of a surface of the planarization structure is exposed.

Referring to FIG. 8B, FIG. 8C and FIG. 7, thereafter, the mask layer 113 is removed, and components such as a light-emitting stacked layer LE, a common electrode structure CE and an encapsulation layer 112 are formed on the pixel definition structure PS, thereby forming a display panel 500c.

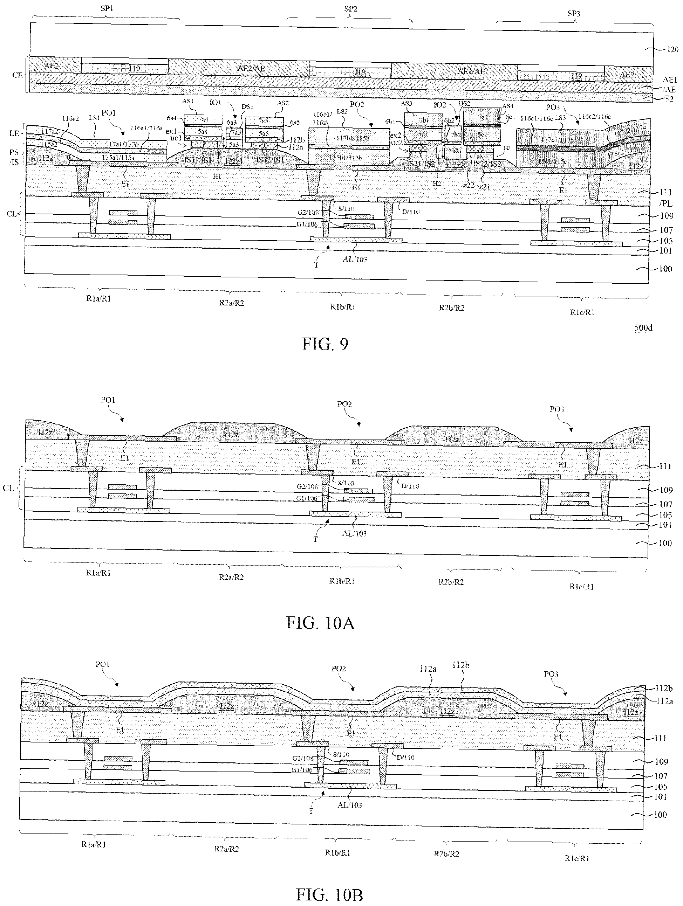

FIG. 9 illustrates a schematic cross-sectional view of a display panel 500d according to some other embodiments of the present disclosure.

In some embodiments, the pixel definition structure may include a pixel definition body layer, a first pixel definition layer and a second pixel definition layer; the pixel definition body layer may be disposed at a side of the first pixel definition layer close to the base substrate and define a plurality of sub-pixel openings. For example, the pixel definition body layer includes a first body part located between a first sub-pixel and an adjacent second sub-pixel or third sub-pixel, and a second body part located between a second sub-pixel and a third sub-pixel, wherein the first pixel definition layer and the second pixel definition layer include a first isolation part and a second isolation part respectively located on the first body part and the second body part, and each isolation part includes an extension part of the first pixel definition layer and an undercut structure located between the extension part and the pixel definition body layer.

For example, referring to FIG. 9, in the display panel 500d, the pixel definition structure PS may include a pixel definition body layer 112z, a first pixel definition layer 112a and a second pixel definition layer 112b. The pixel definition structure PS defines a plurality of sub-pixel openings, and a portion of the pixel definition structure PS serves as an isolation structure IS. In some embodiments, a plurality of sub-pixel openings PO1, PO2, PO3 may be mainly defined by the pixel definition body layer 112z; and the first pixel definition layer 112a and the second pixel definition layer 112b may also be used for defining portions of the sub-pixel openings. In some embodiments, the pixel definition body layer may include a plurality of body parts, each body part is located between adjacent sub-pixels, and the first and second pixel definition layers may be formed on the body parts of the pixel definition layer and include a plurality of isolation parts. In each isolation part, the second pixel definition layer has an extension part extending beyond the edge of the first pixel definition layer in a direction parallel to the main surface of the base substrate, and an undercut structure is provided between the extension part and the pixel definition body layer. The undercut structure may be located in the first pixel definition layer, or may further extend into the pixel definition body layer.

For example, the pixel definition body layer 112z may include a first body part 112z1 located between the first sub-pixel SP1 and the second sub-pixel SP2, and a second body part 112z2 located between the second sub-pixel SP2 and the third sub-pixel SP3. A portion of the pixel definition structure PS serves as an isolation structure, and the isolation structure may include a first isolation part IS1 and a second isolation part IS2 located on the first body part 112z1 and the second body part 112z2, respectively.

In some embodiments, the first isolation part IS1 may include portions of the first pixel definition layer 112a and the second pixel definition layer 112b that are located on the first body part 112z1. For example, in the first isolation part IS1, the second pixel definition layer 112b has an extension part ex1 protruding from an edge of the first pixel definition layer 112a in a direction parallel to the main surface of the base substrate, and an undercut structure uc1 is provided between the extension part ex1 of the second pixel definition layer 112b and the first body part 112z1 of the pixel definition body layer.

In some embodiments, an edge portion of the first isolation part IS1 is close to a corresponding sub-pixel opening, and the undercut structure uc1 of the edge portion is in spatial communication with the corresponding sub-pixel opening, and the edge portion may also be used to partially define the sub-pixel opening. In some embodiments, the first isolation part IS1 may include a single isolation part, or may include a plurality of isolation sub-parts, and an isolation opening is provided between adjacent isolation sub-parts. For example, the first isolation part IS1 may include an isolation sub-part IS11 and an isolation sub-part IS12, and an isolation opening IO1 is provided between the isolation sub-parts IS11 and IS12. In each isolation sub-part, the second pixel definition layer has an extension part, and an undercut structure is provided between the extension part and the pixel definition body layer. Similar to the previous embodiment, the isolation opening IO1 includes a first sub-opening in the first pixel definition layer 112a and a second sub-opening in the second pixel definition layer 112b, and the first sub-opening includes a portion of the undercut structure uc1 in the isolation sub-parts IS11 and IS12. The isolation opening IO1 may expose a portion of a surface of the pixel definition body layer 112z1. In some embodiments, a plurality of isolation sub-parts of the first isolation part IS1 may be arranged along an arrangement direction of corresponding adjacent sub-pixels.

In some embodiments, in the first body part 112z1, a surface of the pixel definition body layer 112z1 that is in contact with the first pixel definition layer 112a and a surface of the pixel definition body layer 112z1 that is exposed by the isolation opening IO1 may be substantially level with each other in a direction parallel to the main surface of the base substrate. The first isolation part IS1 can be used as a pixel region isolation part and/or an inter-pixel isolation part of an isolation structure, and has a first isolation height H1, which may be defined by the sum of the thickness of the extension part ex1 of the second pixel definition layer 112b and the depth of the undercut structure uc1, that is, defined by the depth of the isolation opening IO1; in this example, the depth of the undercut structure uc1 may be substantially equal to the thickness of the first pixel definition layer 112a; that is, the first isolation height H1 may be substantially equal to the sum of the thicknesses of the second pixel definition layer 112b and the first pixel definition layer 112a.

In some embodiments, the second isolation part IS2 may include portions of the first pixel definition layer 112a and the second pixel definition layer 112b that are located on the second body part 112z2. For example, the second body part 112z2 has a recess rc (or may be referred to as a body recess), and may include a body sub-part z21 and a protruding part z22, the protruding part z22 protrudes from a surface of the body sub-part z21 at a side away from the base substrate, in a direction perpendicular to the main surface of the base substrate, towards the first pixel definition layer; in other words, the body sub-part z21 is recessed towards the base substrate relative to the protruding part z22 in the direction perpendicular to the main surface of the base substrate, and the recess rc is defined by the surface of the body sub-part z21 at the side away from the base substrate and the sidewall of the protruding part z22. In some embodiments, the protruding part z22 of the second body part 112z2, and the second isolation parts IS2 of the first and second pixel definition layers located on the protruding part, together, constitute a pixel region isolation part and/or an inter-pixel isolation part of an isolation structure.

For example, in the second isolation part IS2, the second pixel definition layer 112b has an extension part ex2 extending beyond the first pixel definition layer 112a in a direction parallel to the main surface of the base substrate, and an undercut structure uc2 is provided between the extension part ex2 of the second pixel definition layer 112b and the second body part 112z2. In some embodiments, the sidewall of the protruding part z22 of the second body part 112z2 may be substantially aligned with the corresponding sidewall of the first pixel definition layer 112a in the direction perpendicular to the main surface of the base substrate, that is, the protruding part z22 is also laterally recessed relative to the second pixel definition layer 112b in the direction parallel to the main surface of the base substrate, so that the undercut structure uc2 extends into the second body part 112z2, but the present disclosure is not limited thereto. In some other embodiments, the sidewall of the protruding part z22 may also not be aligned with the sidewall of the first pixel definition layer, and may or may not be aligned with the sidewall of the second pixel definition layer. The undercut structure uc2 is located at least in the first pixel definition layer and may further extend into the pixel definition body layer. In some examples, the depth of the undercut structure uc2 may be substantially equal to the sum of the thicknesses of the first pixel definition layer and the protruding part z22.

In some embodiments, an edge portion of the second isolation part IS2 is close to a corresponding sub-pixel opening, and the undercut structure uc2 of the edge portion is in spatial communication with the corresponding sub-pixel opening, and the edge portion may also be used to partially define the sub-pixel opening. In some embodiments, the second isolation part IS2 may include a single isolation part, or may include a plurality of isolation sub-parts, and an isolation opening is provided between adjacent isolation sub-parts. For example, the second isolation part IS2 may include an isolation sub-part IS21 and an isolation sub-part IS22, and an isolation opening IO2 is provided between the isolation sub-parts IS21 and IS22. In each isolation sub-part, the second pixel definition layer has an extension part, and an undercut structure is provided between the extension part and the pixel definition body layer. Similar to the previous embodiment, the isolation opening IO2 includes a first sub-opening in the first sub-pixel definition layer 112a and a second sub-opening in the second sub-pixel definition layer 112b; the recess rc in the second body part 112z2 of the pixel definition body layer is in spatial communication with the isolation opening IO2; for example, the undercut structure uc2 may include a portion of the first sub-opening and a portion of the recess rc. The isolation opening IO2 may expose a portion of a surface of thae pixel definition body layer 112z1. In some embodiments, a plurality of isolation sub-parts of the second isolation part IS2 may be arranged along an arrangement direction of corresponding adjacent sub-pixels (e.g., the second sub-pixel and the third sub-pixel).

In some embodiments, in the second body part 112z2, a surface (e.g., a first surface) of the second body part 112z2 that is in contact with the first pixel definition layer 112a is higher than a surface (e.g., a second surface) of the second body part 112z2 that is exposed by the isolation opening IO2; that is, in the direction perpendicular to the main surface of the base substrate, the distance between the first surface and the main surface of the base substrate is larger than the distance between the second surface and the main surface of the base substrate.

The second isolation part IS2 of the first and second pixel definition layers and the protruding part z2 of the pixel definition body layer together constitute a pixel region isolation part and/or an inter-pixel isolation part of an isolation structure, and may have a second isolation height H2, which may be defined by the sum of the depth of the isolation opening IO2 and the depth of the body recess rc, for example, substantially equal to the sum of the thickness of the extension part ex2 and the depth of the undercut structure uc2; the depth of the isolation opening IO2 is substantially equal to the sum of the thicknesses of the first and second pixel definition layers, and the depth of the recess rc is substantially equal to the thickness of the protruding part z22 of the second body part 112z2. That is, the second isolation height H2 may be substantially equal to the sum of the thickness of the second pixel definition layer 112a, the thickness of the first pixel definition layer 112a and the thickness of the protruding part z22.

In some embodiments, the first pixel region isolation part corresponding to the first sub-pixel SP1 may include a portion of the first isolation part IS1 (e.g., its isolation sub-part IS11) close to the sub-pixel opening PO1; the second pixel region isolation part corresponding to the second sub-pixel SP2 may include a portion of the first isolation part IS1 (e.g., its isolation sub-part IS12) close to the sub-pixel opening PO2 and a portion of the second isolation part IS2 (e.g., its isolation sub-part IS21) close to the sub-pixel opening PO2; the third pixel region isolation part corresponding to the third sub-pixel SP3 may include a portion of the second isolation part IS2 (e.g., its isolation sub-part IS22) close to the sub-pixel opening SP3. The first inter-pixel isolation part between the first sub-pixel and an adjacent sub-pixel (e.g., the second sub-pixel) may include portions of isolation sub-parts IS11 and IS12 of the first isolation part IS1 that define the isolation opening IO1; the second inter-pixel isolation part between the second sub-pixel and the third sub-pixel may include portions of isolation sub-parts IS21 and IS22 of the second isolation part IS2 that define the isolation opening IO2 and the protruding part z22 of the pixel definition body layer.

That is to say, in this embodiment, the first pixel region isolation part and the first inter-pixel isolation part have a first isolation height h1; a portion of the second pixel region isolation part has a first isolation height H1, and another portion of the second pixel region isolation part has a second isolation height H2; the third pixel region isolation part and the second inter-pixel isolation part have a second isolation height H2.

In this embodiment, the sub-pixel opening definition part of the pixel definition structure PS may include the pixel definition body layer as well as a portion of the first pixel definition layer and a portion of the second pixel definition layer; and the isolation opening definition part includes a portion of the first pixel definition layer and a portion of the second pixel definition layer.

Still referring to FIG. 9, the light-emitting stacked layer LE is disposed on a side of the pixel definition structure PS away from the base substrate, and includes light-emitting stack parts LS1, LS2, LS3 of a plurality of sub-pixels, a plurality of stack parts AS1, AS2, AS3, AS4 located on a side of the isolation structure IS away from the base substrate, and dummy stack parts DS1, DS2 located in the isolation openings. In some embodiments, the stack part located on the isolation structure is adjacent to the light-emitting stack part of the adjacent sub-pixel, and may border or be disconnected from the light-emitting stack part, and may also be referred to as a stack sub-part of the light-emitting stack part. The dummy charge generation layer of the dummy stack part located in the isolation opening is disconnected from the charge generation layer of the stack located on the adjacent isolation part, and is further disconnected from the charge generation layer in the light-emitting stack part of the sub-pixel.

In some embodiments, an included angle α between the sidewall of the pixel definition body layer 112z that defines the sub-pixel opening and a reference plane parallel to the main surface of the base substrate (e.g., the surface of the first electrode E1 at a side away from the base substrate) may range from 10° to 45° or 10° to 65°, which may be beneficial to avoiding leakage current from being occurred in the light-emitting region. In some embodiments, the light-emitting stack part of each sub-pixel may include a first stack sub-part located in the sub-pixel opening and a second stack sub-part located on the pixel definition body layer, and the charge generation layers of the first stack sub-part and the second stack sub-part may be connected to each other.

For example, the light-emitting stack part LS1 may include a light-emitting layer 115a, a charge generation layer 116a, and a light-emitting layer 117a stacked in sequence in a direction perpendicular to the main surface of the base substrate, and include a first stack sub-part located in the sub-pixel opening PO1 and a second stack sub-part located on the pixel definition body layer 112z. The respective material layers of the light-emitting stack part LS1 may extend continuously on the first electrode E1 and the pixel definition body layer 112z; that is, the respective layers in the first stack sub-part and the second stack sub-part may be connected to each other.

For example, the light-emitting stack part LS2 may include a light-emitting layer 115b, a charge generation layer 116b, and a light-emitting layer 117b stacked in sequence in a direction perpendicular to the main surface of the base substrate; the light-emitting stack part LS2 may include a first stack sub-part located in the sub-pixel opening PO2, and may further include a second stack sub-part located on the pixel definition body layer 112z. It should be understood that, although only the first stack sub-part of the light-emitting stack part LS2 is illustrated in the figure, the light-emitting stack part LS2 may also include a second stack sub-part connected to the first stack sub-part. For example, the respective material layers of the light-emitting stack part LS2 may extend continuously on the first electrode E1 and the pixel definition body layer 112z; that is, the respective layers in the first stack sub-part and the second stack sub-part may be connected to each other.

For example, the light-emitting stacked layer LS3 may include a light-emitting layer 115c, a charge generation layer 116c, and a light-emitting layer 117c stacked in sequence in the direction perpendicular to the main surface of the base substrate, and may include a first stack sub-part located in the sub-pixel opening PO3 and a second stack sub-part located on the pixel definition body layer 112z; and the respective layers in the first stack sub-part and the second stack sub-part may be connected to each other.

In some embodiments, a stack part AS1 and a stack part AS2 are located on the isolation sub-part IS11 and the isolation sub-part IS12 of the first isolation part IS1, respectively. The stack part AS1 may include a light-emitting layer 5a4, a charge generation layer 6a4 and a light-emitting layer 7a4 sequentially stacked; and the stack part AS2 may include a light-emitting layer 5a5, a charge generation layer 6a5 and a light-emitting layer 7a5 sequentially stacked. In some embodiments, the stack part AS1 may also be regarded as the second stack sub-part of the light-emitting stack part LS1. The dummy stack part DS1 is located in the isolation opening IO1 and is located between the stack parts AS1 and AS2; and the dummy stack part DS1 may include a dummy light-emitting layer 5a3, a dummy charge generation layer 6a3 and a dummy light-emitting layer 7a3 sequentially stacked.

In some embodiments, the charge generation layer 6a4 of the stack part AS1 and the charge generation layer 116a of the light-emitting stack part LS1 may be disconnected from each other by the first pixel region isolation part (i.e., a portion of the first isolation sub-part IS11 of the first isolation part IS1); the charge generation layer 6a5 of the stack part AS2 and the charge generation layer 116b of the light-emitting stack part LS2 are disconnected from each other by the second pixel region isolation part (i.e., a portion of the second isolation sub-part IS12 of the first isolation part IS1); the charge generation layer 6a4 of the stack part AS1, the charge generation layer 6a5 of the stack part AS2 and the dummy charge generation layer 6a3 of the dummy stack part DS1 are disconnected from each other by the first inter-pixel isolation part (i.e., portions of the first isolation sub-part IS11 and the second isolation sub-part IS12 of the first isolation part IS1 that define the isolation opening IO1). In some embodiments, the stack parts AS1 and AS2 may also be referred to as dummy stack parts.

In some embodiments, the light-emitting layer 5a4/5a5, the charge generation layer 6a4/6a5 and the light-emitting layer 7a4/7a5 in the stack part AS1/AS2, as well as the dummy light-emitting layer 5a3, the dummy charge generation layer 6a3 and the dummy light-emitting layer 7a3 in the dummy stack part DS1 may respectively have the same materials as and be formed in the same evaporation process as the light-emitting layer 115a, the charge generation layer 116a, and the light-emitting layer 117a in the light-emitting stack part LS1, but the present disclosure is not limited thereto. In some other embodiments, the respective material layers of the stack part AS1 have the same materials as and be formed in the same evaporation process as the respective material layers in the light-emitting staked layer LS1, respectively; the respective material layers of the stack part AS2 have the same materials as and be formed in the same evaporation process as the respective material layers in the light-emitting staked layer LS2, respectively; the respective material layers of the dummy stack part DS1 may have the same materials as and be formed in the same evaporation process as the respective material layers in the light-emitting stack part LS1 or LS2, respectively.

In some embodiments, the stack part AS3 and the stack part AS4 are located on the isolation sub-part IS21 and the isolation sub-part IS22 of the second isolation part IS2, respectively. The stack part AS3 may include a light-emitting layer 5b1, a charge generation layer 6b 1 and a light-emitting layer 7b1 sequentially stacked; and the stack part AS4 may include a light-emitting layer 5c1, a charge generation layer 6c1 and a light-emitting layer 7c1 sequentially stacked. The dummy stack part DS2 is located in the isolation opening IO2 and is located between the stack parts AS3 and AS4; and the dummy stack part DS2 may include a dummy light-emitting layer 5b2, a dummy charge generation layer 6b2 and a dummy light-emitting layer 7b2 sequentially stacked. In some embodiments, the stack part AS3 may be regarded as the second stack sub-part of the light-emitting stack part LS2, and the stack part AS4 may be regarded as the second stack sub-part of the light-emitting stack part LS3.

In some embodiments, the charge generation layer 6b1 of the stack part AS3 and the charge generation layer 116b of the light-emitting stack part LS2 may be disconnected from each other by the second pixel region isolation part (i.e., a portion of the isolation sub-part IS21 and a portion of the protruding part z22); the charge generation layer 6c1 of the stack part AS4 and the charge generation layer 116c of the light-emitting stack part LS3 are disconnected from each other by the third pixel region isolation part (i.e., a portion of the isolation sub-part IS22 and a portion of the protruding part z22); the charge generation layer 6b1 of the stack part AS3, the charge generation layer 6c1 of the stack part AS4 and the dummy charge generation layer 6b2 of the dummy stack part DS2 are disconnected from each other by the second inter-pixel isolation part (i.e., portions of the isolation sub-parts IS11, IS12 and the protruding part z22 that are close to the isolation opening IO2). In some embodiments, the stack parts AS3 and AS4 may also be referred to as dummy stack parts.

In some embodiments, the light-emitting layer 5b1, the charge generation layer 6b1 and the light-emitting layer 7b1 in the stack part AS3, as well as the dummy light-emitting layer 5b2, the dummy charge generation layer 6b2 and the dummy light-emitting layer 7b2 in the dummy stack part DS2 may have the same materials as and be formed in the same evaporation process as the light-emitting layer 115b, the charge generation layer 116b and the light-emitting layer 117b in the light-emitting stack part LS2, respectively; the light-emitting layer 5c1, the charge generation layer 6c1 and the light-emitting layer 7c1 in the stack part AS4 may have the same materials as and be formed in the same evaporation process as the light-emitting layer 115c, the charge generation layer 116c and the light-emitting layer 117c in the light-emitting stack part LS3, respectively; but the present disclosure is not limited thereto. In some other embodiments, the respective material layers in the stack parts AS3, AS4 and the dummy stack part DS2 may respectively have the same materials as the respective material layers in the light-emitting stack part LS2 or in the light-emitting stack part LS3; alternatively, the respective material layers in the stack part AS3 respectively have the same materials as the respective material layers in the light-emitting stack part LS2, while the respective material layers in the stack part AS4 and the dummy stack part DS2 have the same materials as the respective material layers in the light-emitting stack part LS3, respectively. That is to say, each of the stack part AS3, the stack part AS4, and the dummy stack part DS2 and one of the light-emitting stack parts of two adjacent sub-pixels may be formed in the same evaporation process and have the same materials.

Similar to the previous embodiment, the display panel 500d may further include a common electrode structure CE and an encapsulation layer 120, and the related features of the common electrode structure CE and the encapsulation layer 120 are similar to those of the previous embodiment and will not be repeated here.

FIGs. 10A to 10C illustrate schematic cross-sectional views of intermediate structures of various steps in a manufacturing method of a display panel 500d according to some embodiments of the present disclosure.

Referring to FIG. 10A, in some embodiments, after the pixel circuit layer CL, the planarization structure PL and the first electrodes E1 are formed on the base substrate 100, a pixel definition body layer 112z is formed on a side of the planarization structure PL and the first electrodes E1 away from the base substrate. For example, the pixel definition body layer 112z may include an organic insulating material, and may include a resin material, for example. A patterning process may be performed on the pixel definition body layer 112z to form a plurality of sub-pixel openings defining a plurality of light-emitting regions, and each sub-pixel opening exposes a portion of a surface of the corresponding first electrode E1. The edge portion of the first electrode E1 may be covered by the pixel definition body layer 112z, but the present disclosure is not limited thereto. In some embodiments, when the sub-pixel opening is formed by the patterning process, the included angle α between the sidewall of the pixel definition body layer 112z that defines the sub-pixel opening and the horizontal plane can be controlled within a suitable angle range, thereby ensuring that the light-emitting stacked layer subsequently formed in the light-emitting regions will not generate leakage current.

Referring to FIG. 10B, a first pixel definition layer 112a and a second pixel definition layer 112b are sequentially formed on a side of the pixel definition body layer 112z and the first electrodes E1 away from the base substrate 100; the first pixel definition layer 112a and the second pixel definition layer 112b include different materials, and the material selection for the pixel definition layer is similar to that described in the previous embodiment, which is not repeated here. In this step, the first pixel definition layer 112a and the second pixel definition layer 112b may extend along the surface of the pixel definition body layer 112z and be filled in a plurality of sub-pixel openings.

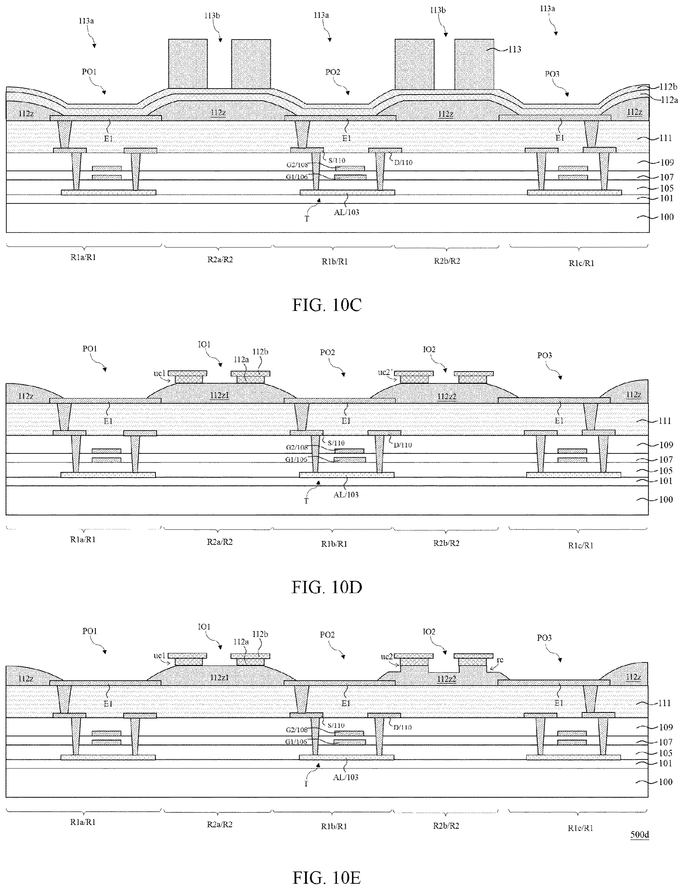

Referring to FIG. 10C, a mask layer 113 is formed on a side of the second pixel definition layer 112b away from the base substrate. In some embodiments, the mask layer 113 may cover a portion of the region between adjacent sub-pixels and expose regions where a plurality of sub-pixel openings is located. For example, the mask layer 113 may include a first mask opening 113a and a second mask opening 113b; the first mask opening 113a exposes the pixel definition layer located in the sub-pixel opening; the second mask opening 113b exposes a portion of the pixel definition layer located on the body part of the pixel definition body layer.

Referring to FIG. 10C and FIG. 10D, an etching process is performed on the second pixel definition layer 112b and the first pixel definition layer 112a by using the mask layer 113 as an etching mask, so as to remove portions of the second pixel definition layer and the first pixel definition layer exposed by a plurality of mask openings, and form a plurality of openings in the second pixel definition layer and the first pixel definition layer, the plurality of openings expose a portion of a surface of the pixel definition body layer, such that the plurality of sub-pixel openings are exposed again. The etching process is similar to that described in the previous embodiment; for example, portions of the second pixel definition layer and the first pixel definition layer located in the respective sub-pixel openings are removed by the etching process, thereby exposing the surfaces of the first electrodes E1 and the sidewalls of the pixel definition body layer that define the sub-pixel openings; and portions of the second pixel definition layer and the first pixel definition layer located on the body part of the pixel definition body layer are removed, and isolation openings IO1 and IO2 are formed. Similar to the previous embodiment, the first pixel definition layer 112a and the second pixel definition layer 112b are formed from different materials, and the etching process has a high etching selectivity ratio of the first pixel definition layer 112a to the second pixel definition layer 112b; and an undercut structure uc1 and an undercut structure uc2' can be formed, laterally aside the first pixel definition layer 112a, and between the second pixel definition layer 112b and the underlying material layers (e.g., body parts 112z1 and 112z2 of the pixel definition body layer). In some embodiments, in this step, the undercut structure uc1 and the undercut structure uc2' may have the same heights, for example, the heights thereof may both be substantially equal to the thickness of the first pixel definition layer 112a.

Referring to FIG. 10D and FIG. 10E, in some embodiments, a removal process may be further performed on the body part of the pixel definition body layer 112z to remove portions of the pixel definition body layer exposed by part of openings of the first and second pixel definition layers, and to form a recess in a partial region of the pixel definition body layer. For example, a portion of the second body part of the pixel definition body layer may be removed by an etching process to form a recess rc in the second body part 112z. In some embodiments, the recess rc extends to be below the extension part of the second pixel definition layer, so that the undercut structure uc2' further extends into the second body part and the undercut structure uc2 is formed; in this way, the height of the undercut structure uc2 is larger than the height of the undercut structure uc1. In an alternative embodiment, the recess rc may not extend to be below the extension part of the pixel definition layer, and the formed protruding part of the second body part 112z2 also extends beyond the edge of the first pixel definition layer in the direction parallel to the main surface of the base substrate, and the undercut structure uc2 is located between the extension part of the second pixel definition layer 112b and the protruding part of the second body part.

In some embodiments, in the etching process, the first body part 112z1 of the pixel definition body layer 112z may not be removed; for example, when the etching process is performed on the pixel definition body layer 112z, a mask may be used to cover the region in the pixel definition body layer that does not need to form a recess, and the mask exposes the region that needs to form a recess. For example, the mask may include a new mask formed by filling part of the mask openings of the mask layer 113 with a mask material, or may be a mask formed after the mask layer 113 is removed.

Referring to FIG. 10E and FIG. 9, thereafter, a light-emitting stacked layer LE and a common electrode structure CE are formed on a side of the pixel definition structure away from the base substrate. For example, forming the light-emitting stacked layer LE may include performing multiple times of evaporation processes, including, for example, a first evaporation process, a second evaporation process, and a third evaporation process. The evaporation regions of the first evaporation process, the second evaporation process and the third evaporation process may at least include corresponding sub-pixel regions, or may further include spacing regions between adjacent sub-pixels. For example, at least the light-emitting stack parts LS1, LS2 and LS3 are formed by the first evaporation process, the second evaporation process and the third evaporation process, respectively. In some embodiments, the first evaporation process further forms the stack parts AS1, AS2 and the dummy stack part DS1; the second evaporation process further forms the stack part AS3 and the dummy stack part DS2; and the third evaporation process further forms the stack part AS4. However, the present disclosure is not limited thereto.

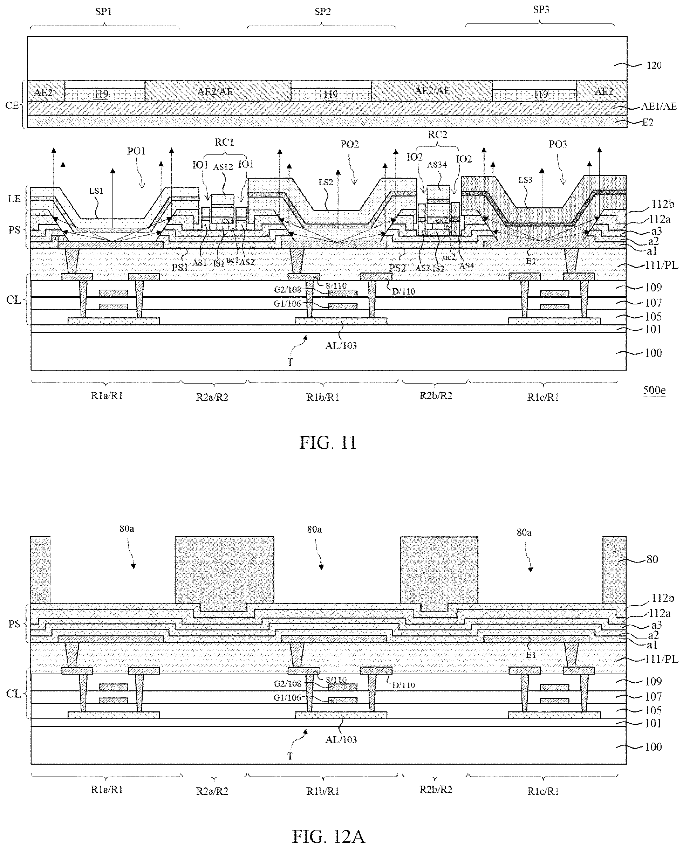

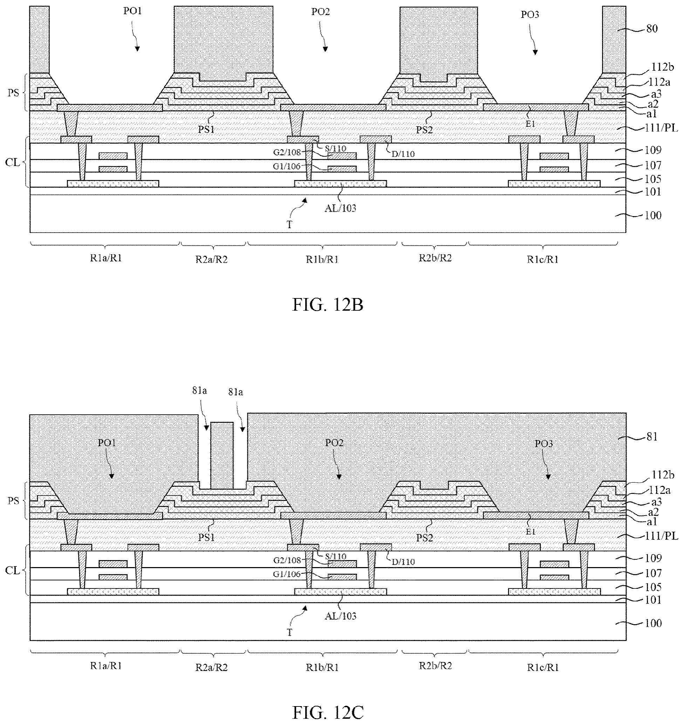

FIG. 11 illustrates a schematic cross-sectional view of a display panel 500e according to some other embodiments of the present disclosure. FIG. 12B illustrates a schematic cross-sectional view of part of structures including a pixel definition structure of the display panel 500e.

In some embodiments, the pixel definition structure PS of the display panel may include a plurality of pixel definition layers stacked in sequence in the direction perpendicular to the main surface of the base substrate, and the second pixel definition layer is the farthest one from the base substrate among the plurality of pixel definition layers, and the first pixel definition layer is the one adjacent to the second pixel definition layer among the plurality of pixel definition layers. In some embodiments, the pixel definition structure includes a sub-pixel opening definition part and an isolation opening definition part. In the sub-pixel opening definition part, the sidewalls of a plurality of pixel definition layers are connected to each other and together constitute the sidewall defining the sub-pixel opening; the isolation opening definition part includes an extension part and an undercut structure that constitute an isolation structure.

For example, referring to FIG. 11, the pixel definition structure PS may include a plurality of pixel definition layers a1, a2, a3, 112a, 112b stacked in sequence in the direction perpendicular to the main surface of the base substrate. In some embodiments, the pixel definition layers 112a and 112b may be referred to as a first pixel definition layer and a second pixel definition layer, respectively; and one or more of the pixel definition layers a1, a2 and a3 at the side of the pixel definition layer 112a close to the base substrate 100 may be collectively referred to as a pixel definition body layer.

In some embodiments, the plurality of pixel definition layers a1, a2, a3, 112a and 112b may all include inorganic materials, such as materials selected from SiO, SiN, SiON, SiCN, Al₂O₃, NbO, TiO and the like. In some embodiments, adjacent pixel definition layers among a plurality of pixel definition layers may have different materials. In some embodiments, the overall thickness of the pixel definition structure PS (i.e., the sum of the thicknesses of a plurality of pixel definition layers) may be set in the range from 0.1 µm to 3 µm, but the present disclosure is not limited thereto.

In some embodiments, the pixel definition structure PS has a plurality of sub-pixel openings PO1, PO2 and PO3, which respectively extend through a plurality of pixel definition layers and expose portions of surfaces of the corresponding first electrodes E1. In some embodiments, sidewalls of a plurality of pixel definition layers that define the same sub-pixel opening are connected to each other and together constitute a sidewall of the pixel definition structure that defines the sub-pixel opening. For example, the sidewall may be inclined, and the included angle α between the sidewall and a reference plane parallel to the main surface of the base substrate may be an acute angle, for example, the included angle may range from about 10° to about 40° or 45° or may be smaller than 20°; and the included angle may also be referred to as an inclination angle of the sidewall of the sub-pixel opening. In some embodiments, the included angles of sidewalls of a plurality of pixel definition layers that define the same sub-pixel opening may be substantially the same as or different from each other.

In some embodiments, the cross-sectional shape of the sub-pixel opening may be an inverted trapezoid shape or the like. For example, the width of the sub-pixel opening may gradually decrease as approaching the base substrate and the first electrode, and gradually increase as being away from the base substrate and the first electrode. Each sub-pixel opening includes a plurality of sub-openings respectively located in a plurality of pixel definition layers; and among the plurality of pixel definition layers, the sub-opening of the pixel definition layer that is closer to the first electrode has a smaller width, while the sub-opening of the pixel definition layer that is farther away from the first electrode has a larger width. For example, in the same sub-pixel opening, the sub-openings in the pixel definition layers a1, a2, a3, 112a and 112b gradually increase. In some embodiments, there may be no undercut structure provided at the side of the pixel definition structure close to the sub-pixel opening.

In some embodiments, the pixel definition structure PS may include a plurality of pixel definition stack parts located between different adjacent sub-pixels, and an edge portion of each pixel definition stack part is used to define a corresponding sub-pixel opening and may be referred to as a sub-pixel opening definition part; the pixel definition stack part may have a recess, which may include one or more isolation openings; a portion of the pixel definition stack part that defines the isolation opening may include extension parts of one or more pixel definition layers and one or more undercut structures, and serve as an inter-pixel isolation part of the isolation structure.

In some embodiment, the sub-pixel opening definition part has a first side and a second side which are opposite in a direction parallel to the main surface of the base substrate; the first side is used for defining a sub-pixel opening, and the second side is used for defining a recess and includes an extension part and an undercut structure. In other words, the second side of the sub-pixel opening definition part may also be referred to as an isolation part. In some embodiments, the pixel definition stack part includes an isolation part disposed in a recess, and the isolation part includes extension part(s) of one or more pixel definition layers and one or more undercut structures. The isolation part in the recess is spaced apart from the adjacent sub-pixel opening definition part, and an isolation opening is provided between the isolation part and the adjacent sub-pixel opening definition part. The isolation part in each recess may be a single isolation part, or may also include a plurality of isolation sub-parts, and an isolation opening is provided between adjacent isolation sub-parts. In some embodiments, different pixel definition stack parts may have different recess depths; the recess depth is used to define the isolation height of the inter-pixel isolation part; by setting different recess depths, isolation parts with different isolation heights can be formed. In some embodiments, the recess is formed in at least two pixel definition layers.

Referring to FIG. 11 and FIG. 12B, for example, the pixel definition structure PS may include a pixel definition stack part PS1 located between a first sub-pixel SP1 and a second sub-pixel SP2 and a pixel definition stack part PS2 located between a second sub-pixel SP2 and a third sub-pixel SP3. The pixel definition stack part PS1 may include sub-pixel opening definition parts OS1a and OS1b, and may have a recess RC1. A first side and a second side of the sub-pixel opening definition part OS1a define a portion of the sub-pixel opening PO1 and a portion of the recess RC1, respectively; a first side and a second side of the sub-pixel opening definition part OS1b define a portion of the sub-pixel opening PO2 and a portion of the recess RC1, respectively. In some embodiments, the second side of each sub-pixel opening definition part OS1a/OS1b has an extension part of one or more pixel definition layers that extend beyond the edge of an adjacent pixel definition layer in a direction parallel to the main surface of the base substrate, and has an undercut structure at a side of the extension part close to the base substrate, and the undercut structure is formed by the adjacent pixel definition layer being laterally recessed in the direction parallel to the main surface of the base substrate. For example, at the second side of the sub-pixel opening definition part OS1a/OS1b, the pixel definition layer 112b has an extension part ex1 that extends beyond the edge of the pixel definition layer 112a in the direction parallel to the main surface of the base substrate, so that an undercut structure uc1 is formed at a side of the pixel definition layer 112a away from the sub-pixel opening, for example, between the extension part ex1 and the underlying pixel definition layer a3.

In some embodiments, an isolation part IS1 is provided in the recess RC1; the isolation part IS1 is spaced apart from the sub-pixel opening definition parts OS1a and OS1b, and isolation openings IO1 are provided between the isolation part IS1 and the sub-pixel opening definition part OS1a and between the isolation part IS1 and the sub-pixel opening definition part OS1b. That is to say, the recess RC1 may include a plurality of isolation openings IO1. The plurality of isolation openings IO1 may be spaced apart from each other (i.e., not in communication with each other), but may also be in communication with each other. For example, the isolation opening IO1 may extend through the pixel definition layers 112b and 112a, and expose a portion of a surface of the pixel definition layer a3 at a side away from the base substrate.

In some embodiments, the isolation part IS1 includes an extension part ex1 of the pixel definition layer 112b that extends beyond opposite edges of the pixel definition layer 112b in a direction parallel to the main surface of the base substrate, and has an undercut structure uc1 located laterally aside the pixel definition layer 112a and between the pixel definition layer 112b and the pixel definition layer a3. The isolation part IS1 has a first side and a second side which are opposite in the direction parallel to the main surface of the base substrate. The first side and the second side of the isolation part IS1 respectively face the second side of the sub-pixel opening definition part OS1a and the sub-pixel opening definition part OS1b, and define the isolation openings IO1 together with the sub-pixel opening definition parts OS1a and OS1b, respectively. That is, the second sides of the sub-pixel opening definition parts OS1a, OS1b and the isolation part IS1 all serve as isolation opening definition part. Similar to the previous embodiment, each isolation opening IO1 includes sub-openings in a plurality of pixel definition layers, for example, including a first sub-opening in the pixel definition layer 112a and a second sub-opening in the pixel definition layer 112b, and the width of the first sub-opening is larger than that of the second sub-opening; and each isolation opening IO1 includes the undercut structure.

In some embodiments, the isolation part IS1 may be a single isolation part, or may include a plurality of isolation sub-parts; each isolation sub-part has a structure of the isolation part IS1 as illustrated in FIG. 12B, and an isolation opening IO1 is provided between adjacent isolation sub-parts. In some embodiments, the height of each isolation part is defined by the thickness of the extension part of the corresponding pixel definition layer and the height of the undercut structure.

In this embodiment, the isolation parts at the second sides of the sub-pixel opening definition parts OS1a and OS1b and the isolation part IS1 located in the recess RC1 together constitute an inter-pixel isolation part between the first sub-pixel SP1 and the second sub-pixel SP2. The inter-pixel isolation part has an isolation height defined by the sum of the thickness of the extension part ex1 of the pixel definition layer 112b and the height of the undercut structure uc1.

In some embodiments, since the plurality of pixel definition layers are formed on the first electrodes and may have a morphology conformal with the underlying material layers (e.g., part of the regions may have a step shape), the plurality of pixel definition layers may have a portion extending along a direction parallel to the main surface of the base substrate (e.g., horizontal direction), and may also have a portion extending in a direction intersecting with (e.g., perpendicular to) the main surface of the base substrate (e.g., vertical direction). For each of the isolation parts at the second sides of the sub-pixel opening definition parts OS1a, OS1b and the isolation part IS1 located in the recess RC1, the extension part ex1 thereof may include a horizontally extending portion and/or a vertically extending portion of the pixel definition layer 112b. Therefore, the extension parts or the undercut structures in different regions of the same pixel definition layer may have different thicknesses/heights. For example, in the example illustrated in FIG. 12B, the extension part ex1 of the isolation parts at the second sides of the sub-pixel opening definition parts OS1a, OS1b includes a portion of the pixel definition layer 112b extending in the direction intersecting with the main surface of the base substrate, while the extension part ex1 of the isolation part IS1 includes a portion of the pixel definition layer 112b extending in the direction parallel to the main surface of the base substrate, and the thickness of the extension part ex1 of the isolation part IS1 may be smaller than the thickness of the extension part ex1 of the sub-pixel opening definition parts OS1a, OS1b, so that the isolation height of the isolation part IS1 is smaller than the isolation height of the isolation part at the second side of the sub-pixel opening definition part. In some embodiments, the isolation height of the isolation part IS1 is substantially equal to the sum of the thicknesses of the pixel definition layers 112a and 112b, while the isolation height at the second sides of the sub-pixel opening definition parts OS1a, OS1b is larger than the sum of the thicknesses of the pixel definition layers 112a and 112b. That is to say, in this example, the isolation height of the inter-pixel isolation part between the first sub-pixel and the second sub-pixel may be larger than or equal to the sum of the thicknesses of the pixel definition layers 112b and 112a. In the present disclosure, a thickness of a material layer refers to a thickness in a direction perpendicular to an extending direction of the material layer. Here, the thickness of the pixel definition layer is defined in terms of a portion (i.e., a horizontally extending portion) of the pixel definition layer extending in a direction parallel to the main surface of the base substrate, and the thickness refers to a thickness of the horizontally extending portion in a direction perpendicular to the main surface of the base substrate.

In some other embodiments, the isolation part IS1 may not be provided in the recess RC1 of the pixel definition part PS1, that is, the recess RC1 is a single isolation opening defined by the second sides of the sub-pixel opening definition parts OS1a and OS1b, and the inter-pixel isolation part located between the first sub-pixel and the second sub-pixel may only include an isolation part formed by the second sides of the sub-pixel opening definition parts OS1a and OS1b.

Still referring to FIG. 12B, the pixel definition stack part PS2 may include sub-pixel opening definition parts OS2a and OS2b, and have a recess RC2. The pixel definition stack part PS2 has a structure similar to that of the pixel definition stack part PS1, except that the recess RC2 has a different depth. In some embodiments, the recess RC2 is formed in more than two pixel definition layers, for example, the recess RC may be formed in the pixel definition layers 112b, 112a and a3.

For example, a first side and a second side of the sub-pixel opening definition part OS2a define a portion of the sub-pixel opening PO2 and a portion of the recess RC2, respectively; a first side and a second side of the sub-pixel opening definition part OS2b define a portion of the sub-pixel opening PO3 and a portion of the recess RC2, respectively. In some embodiments, the second side of each of the sub-pixel opening definition parts OS2a and OS2b has an extension part of one or more pixel definition layers that extend beyond the edge of an adjacent pixel definition layer in a direction parallel to the main surface of the base substrate, and has an undercut structure at a side of the extension part close to the base substrate; and the undercut structure is formed by the adjacent pixel definition layer being laterally recessed in the direction parallel to the main surface of the base substrate. For example, at the second sides of the sub-pixel opening definition parts OS2a and OS2b, the pixel definition layers 112b and a3 have extension parts ex2 that extend beyond the edge of the pixel definition layer 112a in a direction parallel to the main surface of the base substrate, so that an undercut structure uc2 is formed at a side of the pixel definition layer 112a away from the sub-pixel opening, for example, between the extension part ex1 and the underlying pixel definition layer a3. That is to say, the second sides of the sub-pixel opening definition parts OS2a and OS2b also serve as an isolation part.

In some embodiments, an isolation part IS2 is provided in the recess RC2, the isolation part IS2 is spaced apart from the sub-pixel opening definition parts OS2a, OS2b, and isolation openings IO2 are provided between the isolation part IS2 and the sub-pixel opening definition part OS2a and between the isolation part IS2 and the sub-pixel opening definition part OS2b. That is to say, the recess RC2 may include a plurality of isolation openings IO2. The plurality of isolation openings IO2 may be spaced apart from each other (i.e., not in communication with each other), but may also be in communication with each other. The isolation opening IO2 extends through the pixel definition layers 112b, 112a, and a3, and may expose a portion of a surface of the pixel definition layer a2 at a side away from the base substrate.

In some embodiments, the isolation part IS2 includes extension parts ex2 of the pixel definition layers 112b and a3 that extend beyond opposite edges of the pixel definition layer 112a in a direction parallel to the main surface of the base substrate, and has an undercut structure uc2 laterally aside the pixel definition layer 112a and between the extension parts ex2 of the pixel definition layer 112b and the pixel definition layer a3. The isolation part IS2 has a first side and a second side which are opposite in the direction parallel to the main surface of the base substrate. The first side and the second side of the isolation part IS2 respectively face the second side of the sub-pixel opening definition part OS2a and the second side of the sub-pixel opening definition part OS2b, and define the isolation openings IO2 together with the sub-pixel opening definition parts OS2a and OS2b, respectively. That is, the second sides of the sub-pixel opening definition parts OS2a and OS2b and the isolation part IS2 all serve as an isolation opening definition part.

In some embodiments, the isolation part IS2 may be a single isolation part, or may also include a plurality of isolation sub-parts; each isolation sub-part has a structure of the isolation part IS2 as illustrated in FIG. 12B, and an isolation opening IO2 is provided between adjacent isolation sub-parts. In some embodiments, the height of each isolation part is defined by the thickness of the extension part(s) of the corresponding pixel definition layer(s) and the depth of the undercut structure.

In this embodiment, the isolation parts at the second sides of the sub-pixel opening definition parts OS2a and OS2b and the isolation part IS2 located in the recess RC2 together constitute an inter-pixel isolation part between the second sub-pixel SP2 and the third sub-pixel SP3. The inter-pixel isolation part has an isolation height defined by the sum of the thicknesses of the extension parts ex2 of the pixel definition layers 112b and a3 and the depth of the undercut structure uc2. The isolation height is defined in a manner similar to that discussed above with respect to the isolation height between the first and second sub-pixels. For example, the isolation height of the inter-pixel isolation part between the second sub-pixel SP2 and the third sub-pixel SP3 may be larger than or equal to the sum of the thicknesses of the pixel definition layers 112b, 112a and a3, and may be larger than the isolation height of the inter-pixel isolation part between the first sub-pixel and an adjacent sub-pixel.

It should be understood that, in some other embodiments, the isolation part IS2 may not be provided in the recess RC2 of the pixel definition stack part PS2, that is, the recess RC2 is a single isolation opening defined by the second sides of the sub-pixel opening definition parts OS2a and OS2b, and an inter-pixel isolation part located between the second sub-pixel and the third sub-pixel may only include the isolation part constituted by the second sides of the sub-pixel definition parts OS2a and OS2b.

It should be understood that, the number of pixel definition layers and the depths of the respective isolation openings in the pixel definition structure illustrated in FIGs. 11 and 12B are merely for illustration, and the present disclosure is not limited thereto. In some other embodiments, the pixel definition structure may also include more or fewer pixel definition layers, and isolation parts with different isolation heights can be formed by forming recesses with different depths between different adjacent sub-pixels. Each isolation part may include an extension part of one or more pixel definition layers and one or more undercut structures. In some embodiments, recesses with different depths may be formed by removing different number of pixel definition layers through etching process.

Referring to FIG. 11, in some embodiments, the light-emitting stacked layer LE may include light-emitting stack parts LS1, LS2 and LS3 located in a plurality of sub-pixel openings and stack parts AS1, AS2, AS12, AS3, AS4 and AS34 located in the recesses of pixel stack parts. In this embodiment, the isolation structure may not include an pixel region isolation part; and in each light-emitting stack part of the light-emitting stack parts LS1, LS2 and LS3 of a plurality of sub-pixels, the respective material layers in the first stack sub-part located in the sub-pixel opening and the second stack sub-part located at the side of the sub-pixel opening definition part away from the base substrate are connected to each other, that is, are continuous layers without being disconnected. That is, the charge generation layers in the first stack sub-part and the second stack sub-part of each light-emitting stack part are connected to each other. In this embodiment, the material layers included in each light-emitting stack are similar to those described in the previous embodiment, and will not be repeated here.

In some embodiments, the charge generation layers of adjacent light-emitting stack parts among a plurality of light-emitting stack parts may be disconnected from each other by inter-pixel isolation parts located between adjacent sub-pixels, and the inter-pixel isolation parts between different adjacent sub-pixels may have different isolation heights. For example, the charge generation layers of the light-emitting stack parts LS1 and LS2 may be disconnected from each other by a first inter-pixel isolation part (i.e., an isolation part defining an isolation opening IO1) located between the first and second sub-pixels; the first inter-pixel isolation part has a first isolation height; the charge generation layers of the light-emitting stack parts LS2 and LS3 may be disconnected from each other by a second inter-pixel isolation part (i.e., an isolation part defining an isolation opening IO2) located between the second and third sub-pixels; the second inter-pixel isolation part has a second isolation height, and the second isolation height is larger than the first isolation height.

In some embodiments, the stack part AS1 and the stack part AS2 are located in the isolation openings IO1, respectively, and the stack part AS12 is located at a side of the isolation part IS1 away from the base substrate. In some embodiments, the respective material layers such as the charge generation layers and the light-emitting layers in the stack parts AS1, AS2 and AS12 may have the same materials as the respective material layers in the light-emitting stack part LS1, respectively; and the charge generation layers of adjacent stack parts among the light-emitting stack part LS1, the stack parts AS1, AS2, AS12 and the light-emitting stack part LS2 are all disconnected from each other by the first inter-pixel isolation part, but the present disclosure is not limited thereto. In some other embodiments, the respective material layers in the stack part AS2 or the stack parts AS2 and AS12 may also have the same materials as the corresponding material layers in the light-emitting stack part LS2, respectively; and the charge generation layers in the stacks AS2 and AS12 and the light-emitting stack part LS2 may be disconnected from each other or may be not disconnected from each other; at least the respective material layers in the stack part AS1 have the same materials as the respective material layers in the light-emitting stack part LS1, and the charge generation layers of the stack part AS1 and the light-emitting stack part LS1 are disconnected from each other. In some embodiments, among the light-emitting stack parts LS1 and LS2 as well as one or more stack parts AS1, AS12 and AS2 between the stack parts LS1 and LS2, at least the charge generation layers in one group of adjacent stack parts are disconnected from each other, thereby ensuring that the charge generation layers of the light-emitting stack parts LS1 and LS2 are disconnected from each other. In some embodiments, one or more of the stack parts AS1, AS12 and AS2 are dummy stack parts.

In some embodiments, the stack part AS3 and the stack part AS4 are located in the isolation openings IO2, respectively, and the stack part AS34 is located on a side of the isolation part IS2 away from the base substrate. In some embodiments, the respective material layers such as the charge generation layers and the light-emitting layers in the stack parts AS3, AS4 and AS34 have the same materials as the respective material layers in the light-emitting stack part LS2 or LS3, respectively. In some embodiments, among the light-emitting stack parts LS2 and LS3 and one or more stack parts AS3, AS34 and AS4 between the stack parts LS2 and LS3, at least the charge generation layers in one group of adjacent stack parts are disconnected from each other, thereby ensuring that the charge generation layers of the light-emitting stack parts LS2 and LS3 are disconnected from each other. One or more of the stack parts AS3, AS34 and AS4 may be dummy stack part(s). For example, the charge generation layers of adjacent stack parts among the light-emitting stack part LS2, the stack parts AS3, AS34 and AS4, and the light-emitting stack part LS3 are all disconnected from each other, and the stack parts AS3, AS34 and AS4 may all be dummy stack parts.

Still referring to FIG. 11, a common electrode structure CE and an encapsulation layer 120 are disposed on a side of the light-emitting stacked layer LE away from the base substrate. The related features of these layers are similar to those of the previous embodiment, which will not be described again here.

In this embodiment, the pixel definition structure is formed by stacking a plurality of pixel definition layers, which is beneficial to controlling the inclination angle of the sidewall of the sub-pixel opening within a small angle range, thereby ensuring that the second electrode layer above the light-emitting region is continuous, and the light extraction efficiency of the light-emitting device is improved. For example, a plurality of arrows in FIG. 11 schematically illustrate the light emitted from the light-emitting devices. As illustrated in FIG. 11, a plurality of stacked layers of the pixel definition structure has a converging effect on light at the light-emitting surface of the light-emitting device, so that the light extraction efficiency of the light-emitting device can be improved. In addition, an etching process is performed on part of the plurality of pixel definition layers to form an isolation opening including an undercut structure, thereby forming an isolation structure to realize disconnection of the charge generation layers of adjacent sub-pixels; disposing a plurality of stacked layers can facilitate controlling the isolation height, improving the process stability of the isolation structure, and easily forming an isolation part including a plurality of undercut structures, thereby ensuring the disconnection of the charge generation layers of adjacent sub-pixels.

FIGs. 12A to 12C illustrate schematic cross-sectional views of intermediate structures of various steps in a manufacturing method of a display panel 500e according to some embodiments of the present disclosure.

Referring to FIG. 12A, in some embodiments, after the pixel circuit layer CL, the planarization structure PL and the first electrodes E1 are formed on the display panel 100, a plurality of pixel definition layers a1, a2, a3, 112a and 112b are sequentially formed on a side of the planarization structure PL and the first electrodes E1 away from the base substrate. Thereafter, a mask layer 80 is formed on a side of the plurality of pixel definition layers away from the base substrate. The mask layer 80 may have a plurality of mask openings 80a for defining sub-pixel openings, respectively. For example, the plurality of mask openings 80a respectively expose portions of a plurality of pixel definition layers located above the first electrodes E1.

Referring to FIG. 12A to FIG. 12B, in some embodiments, an etching process is performed on a plurality of pixel definition layers by using the mask layer 80 as an etching mask, so as to form a plurality of sub-pixel openings PO1, PO2 and PO3 in the plurality of pixel definition layers. The etching process may be an anisotropic etching process, and the material compositions of the respective pixel definition layers and the etching process can be adjusted and controlled, such that the formed sub-pixel openings have inclined sidewalls, and the inclination angles of the sidewalls are controlled within a small angle range, thereby ensuring that the second electrode layer subsequently formed above the light-emitting regions are continuous and improving the light extraction efficiency of the light-emitting devices.

After the sub-pixel openings are formed, an etching process may be performed on the pixel definition stack part of the plurality of pixel definition layers located between adjacent sub-pixel openings, so as to form a recess (i.e., an isolation opening) in the pixel definition stack part, with a portion defining the recess has an undercut structure, thereby forming an isolation part. In some embodiments, recesses with different depths can be formed in different pixel definition stack parts through multiple etching processes, thereby forming isolation parts with different isolation heights. The depth of the recess can be controlled by controlling the number of the pixel definition layers removed by the etching process.

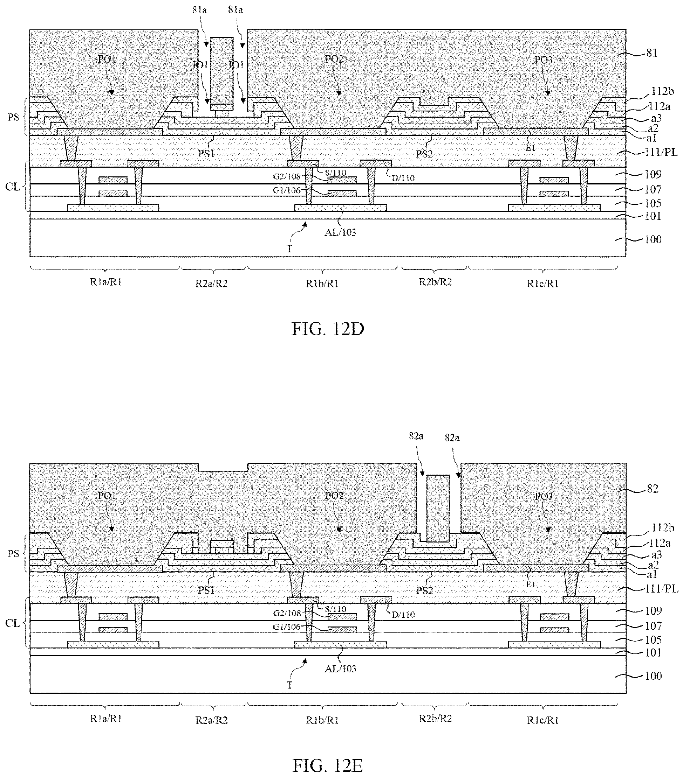

For example, referring to FIG. 12B and FIG. 12C, the mask layer 80 is removed, and a mask layer 81 is formed on the pixel definition structure. The mask layer 81 may have one or more mask openings 81a to expose a portion of a surface of the pixel definition stack part PS1 located between the sub-pixel openings PO1 and PO2. Thereafter, as illustrated in FIG. 12C and FIG. 12D, an etching process is performed on at least two pixel definition layers (e.g., pixel definition layers 112b and 112a) among the plurality of pixel definition layers by using the mask layer 81 as an etching mask, so as to remove portions of the pixel definition layers, and form a recess including one or more isolation openings IO1 in the pixel definition stack part PS1. In the etching process, portions of the pixel definition structure that define the sub-pixel openings and other pixel definition stack parts may be covered by the mask layer 81.

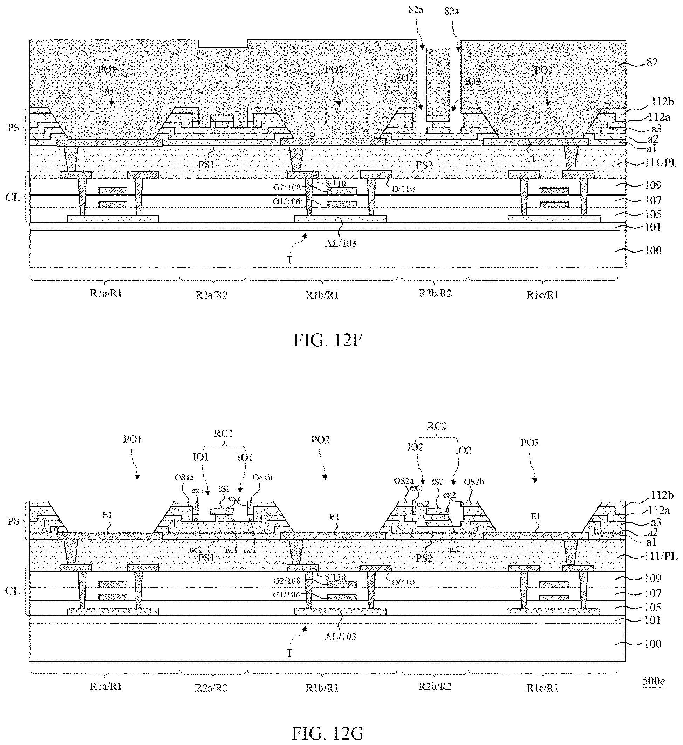

Referring to FIG. 12D and FIG. 12E, the mask layer 81 is removed, and a mask layer 82 is formed on the pixel definition structure PS. The mask layer 82 may have one or more mask openings 82a to expose a portion of a surface of the pixel definition stack part PS2 located between the sub-pixel openings PO2 and PO3. As illustrated in FIG. 12E and FIG. 12F, thereafter, an etching process is performed on a plurality of pixel definition layers (e.g., the pixel definition layers 112b, 112a and a3) by using the mask layer 82 as an etching mask, so as to remove portions of the pixel definition layers, and form a recess including one or more isolation openings IO2 in the pixel definition stack part PS2. In the etching process, the portions of the pixel definition structure that define the sub-pixel openings and other pixel definition stack parts may be covered by the mask layer 82.

In some embodiments, in order to form isolation parts with different isolation heights, the number of the pixel definition layers removed by the etching process (e.g., a first etching process) performed on the pixel definition stack part PS1 is different from the number of the pixel definition layers removed by the etching process (e.g., a second etching process) performed on the pixel definition stack part PS2. For example, the number of the pixel definition layers removed by the second etching process (e.g., at least three layers) is larger than the number of the pixel definition layers removed by the first etching process (e.g., at least two layers). In some embodiments, forming a stack of multiple pixel definition layers can be beneficial to controlling the number and thickness of etched material layers in related etching process, and hence can be beneficial to accurately controlling the isolation height of the isolation structure. In some embodiments, the number of the pixel definition layers removed by the etching process may be smaller than or equal to the total number of the pixel definition layers in the pixel definition structure, and the number of removed layers is not limited in the present disclosure, as long as isolation parts with different isolation heights can be formed in various pixel definition stack parts. In some embodiments, the etching process may not remove the planarization structure, but the present disclosure is not limited thereto. In some other embodiments, the etching process for one or more pixel definition stack parts may also further etch and remove a portion of the planarization structure after forming an isolation opening penetrating through all the pixel definition layers, thereby forming a recess in the planarization structure.

Referring to FIG. 12F and FIG. 12G, the mask layer 82 is removed, thereby obtaining a pixel definition structure PS having a plurality of sub-pixel openings and isolation openings. Thereafter, subsequent processes may be performed on the pixel definition structure PS to form the light-emitting stacked layer LE, the common electrode structure CE, the encapsulation layer 120, and the like, thereby forming the display panel 500e as illustrated in FIG. 11.

In the above embodiments, the pixel definition structure and/or a portion of an adjacent material layer (e.g., the material layer in the planarization structure) located at a side of the pixel definition structure close to the base substrate may be used as the isolation structure. The respective layers used to form the isolation structure may be referred to as isolation layers. The isolation structure includes a plurality of stacked isolation layers (e.g., at least two isolation layers), and among the plurality of stacked layers, a first part of isolation layers (e.g., one or more layers) extends beyond the edge of a second part of isolation layers (one or more layers) in a direction parallel to the main surface of the base substrate, that is, the second part of isolation layers is laterally recessed relative to the first part of isolation layers in a direction parallel to the main surface of the base substrate, thereby forming one or more undercut structures. In the display panels 500a to 500e of the above embodiments, each of the isolation parts of the isolation structure as illustrated only include one undercut structure, but this is only for illustration, and the present disclosure is not limited thereto. In various embodiments, the isolation part of the isolation structure may also have a plurality of undercut structures, and different isolation parts may have different numbers of undercut structures, and the present disclosure does not limit the number of undercut structures included in each isolation part.

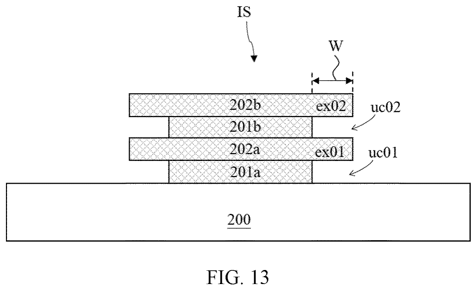

FIG. 13 illustrates a schematic cross-sectional view of an isolation structure having a plurality of undercut structures in a display panel according to some other embodiments of the present disclosure. It should be understood that for simplicity of illustration, only a plurality of isolation layers of the isolation structure is schematically illustrated in FIG. 13, and other components in the display panel are not specifically illustrated.

Referring to FIG. 13, in some embodiments, an isolation structure IS is formed on a bottom structure 200, which may be a planarization structure, an electrode layer or the like on a base substrate. The isolation structure IS may include a plurality of isolation layers stacked in sequence in a direction perpendicular to the main surface of the base substrate. The plurality of isolation layers may include two or more types of inorganic insulating materials and/or organic insulating materials, and the number of the plurality of stacked layers may be larger than or equal to two, or larger than or equal to three. For example, the isolation structure IS may include three stacked layers, four stacked layers, six stacked layers, etc. For example, the isolation structure IS may include four stacked layers of SiO/SiN/SiO/SiN, or six stacked layers of SiO/SiN/SiO/SiN/Al₂O₃/SiCN, etc. In some embodiments, the materials of the plurality of isolation layers in the isolation structure IS may be selected from inorganic materials such as SiO, SiN, SiON, SiCN, metal oxides such as Al₂O₃, NbO, TiO, and organic adhesives. In some embodiments, the materials of every two adjacent isolation layers among the plurality of isolation layers are different from each other.

For example, the isolation structure IS may include one or more first isolation layers and one or more second isolation layers alternately stacked in a direction perpendicular to the main surface of the base substrate, and may include, for example, a first isolation layer 201a, a second isolation layer 202a, a first isolation layer 201b and a second isolation layer 202b stacked in sequence. In some embodiments, a plurality of first isolation layers 201a and 201b may include the same or different materials, and the materials of these two layers have low etching selectivity ratio in the etching process of forming an isolation opening; a plurality of second isolation layers 202a and 202b may include the same or different materials, and the materials of these two layers have low etching selectivity ratio in the etching process of forming an isolation opening. The material(s) of the first isolation layers 201a and 201b is/are different from the material(s) of the second isolation layers 202a and 202b, and the first isolation layer and the second isolation layer have high etching selectivity ratio in the etching process of forming the isolation opening.

In some embodiments, the plurality of second isolation layers 202a and 202b respectively have extension parts ex01 and ex02 extending beyond the edges of the plurality of first isolation layers 201a and 201b in a direction parallel to the main surface of the base substrate. That is to say, the plurality of first isolation layers 201a and 201b are laterally recessed relative to the adjacent second isolation layers 202a and 202b, respectively, and an undercut structure uc01 and an undercut structure uc02 are formed respectively. The undercut structure uc01 is located between the second isolation layer 202a and the bottom structure 200 in the direction perpendicular to the main surface of the base substrate, and the undercut structure uc02 is located between the adjacent second isolation layers 202a and 202b in the direction perpendicular to the main surface of the base substrate.

In some embodiments, the dimensions of the plurality of undercut structures uc01 and uc02 may be the same as or different from each other, for example, the widths of the plurality of undercut structures uc01 and uc02 in the direction parallel to the main surface of the base substrate may be the same or different from each other, and the heights of the plurality of undercut structures uc01 and uc02 in the direction perpendicular to the main surface of the base substrate may also be the same or different from each other.

In some embodiments, the isolation height of the corresponding isolation part in the isolation structure IS may be defined by the sum of the thickness of the extension part of the isolation layer and the height of the undercut structure. For instance, in this example, the isolation height of the isolation structure IS may be defined by the sum of the thicknesses of the extension parts ex01 and ex02 of the second isolation layers 202a and 202b and the heights of the undercut structures uc01 and uc02. For example, the heights of the undercut structures uc01 and uc02 may be substantially equal to the thicknesses of the first isolation layers 201a and 201b, respectively.

In the example illustrated in FIG. 13, the second isolation layer has the extension part at both of two opposite sides in the direction parallel to the main surface of the base substrate, and has the undercut structure at both of two opposite sides of the first isolation layer, but the present disclosure is not limited thereto. In some other embodiments, one or more isolation parts in the isolation structure may only have the extension part and the undercut structure at one side, and may not have the extension part and the undercut structure at the other one side.

It should be understood that, the isolation structure illustrated in FIG. 13 can be applied to one or more isolation parts of the isolation structure in any one of the display panels 500a to 500e, so that the one or more isolation parts each have a plurality of undercut structures, which can be beneficial to further ensuring that the charge generation layers in the light-emitting stack parts of adjacent sub-pixels are disconnected from each other through the isolation part.

In some embodiments, for the undercut structure of the isolation structure, if the width of the undercut structure is too small, the isolation of adjacent sub-pixels may not be effectively realized; if the width of the undercut structure is too large, the isolation structure (e.g., the extension part) may be collapsed or damaged in the subsequent process. In some embodiments, the width of the undercut structure can be controlled within an appropriate range by adjusting relevant process parameters (e.g., parameters for the etching process), so as to ensure the effective isolation of adjacent sub-pixels while avoiding the collapse or damage of the isolation structure in the subsequent process. For example, the width W of each undercut structure in the isolation structure may be set in the range of about 0.05 µm to 0.5 µm, so that the structural stability of the isolation structure can be ensured while effectively isolating adjacent sub-pixels. It should be understood that the undercut structures in the isolation parts of various embodiments of the present disclosure can be set within the above range.

In the isolation structure of various embodiments of the present disclosure, the first isolation height may be set in the range of about 300 angstroms to 1250 angstroms, about 300 angstroms to 750 angstroms, or about 750 angstroms to 1250 angstroms; the second isolation height may be set in the range of about 600 angstroms to 1650 angstroms, about 700 angstroms to 1650 angstroms, or about 1000 angstroms to 1650 angstroms.

The present disclosure provides a display device, including the display panel described in any one of the above embodiments, and the display device has the corresponding technical effects described above with respect to the display panel, which will not be repeated here. For example, the display device may be any product or component with display function, such as a mobile phone, a tablet computer, a television, a displayer, a notebook computer, a digital photo frame, a navigator, or the like, which is not limited in the embodiments of the present disclosure.

The following statements should be noted:
(1) The drawings of the present disclosure involve only the structure(s) in connection with the embodiment(s) of the present disclosure, and other structure(s) can be referred to common design(s).
(2) In case of no conflict, features in one embodiment or in different embodiments can be combined to obtain new embodiments.

What have been described above are only specific implementations of the present disclosure, the protection scope of the present disclosure is not limited thereto. Any modifications or substitutions easily occur to those skilled in the art within the technical scope of the present disclosure should be within the protection scope of the present disclosure. Therefore, the protection scope of the present disclosure should be based on the protection scope of the claims.

## Claims

1. A display panel, having a pixel region comprising a plurality of sub-pixel regions and a pixel spacing region between adjacent sub-pixel regions, and comprising:
a base substrate;
a plurality of sub-pixels, disposed on the base substrate and located in the plurality of sub-pixel regions respectively, wherein each of the plurality of sub-pixels comprises a light-emitting device and a sub-pixel circuit configured to drive the light-emitting device to emit light, each light-emitting device comprises a first electrode, a charge generation layer and a second electrode which are sequentially stacked, and the plurality of sub-pixels comprise a first sub-pixel, a second sub-pixel and a third sub-pixel which are adjacent to each other and configured to display different colors;
a pixel definition structure, disposed on the base substrate and having a plurality of sub-pixel openings to define light-emitting regions of the plurality of sub-pixels, wherein each of the light-emitting devices has at least a portion located in a corresponding one of the plurality of sub-pixel openings; and
an isolation structure, located in at least one of the pixel region and the pixel spacing region, and comprising a portion with a first isolation height and a portion with a second isolation height, wherein the second isolation height is larger than the first isolation height, and wherein charge generation layers of adjacent sub-pixels among the plurality of sub-pixels are disconnected from each other by at least one of the portion with the first isolation height and the portion with the second isolation height in the isolation structure.

2. The display panel according to claim 1, wherein the light-emitting device of the first sub-pixel further comprises a first light-emitting layer located on a side of the charge generation layer thereof close to the base substrate, the light-emitting device of the second sub-pixel further comprises a second light-emitting layer located on a side of the charge generation layer thereof close to the base substrate, and the light-emitting device of the third sub-pixel further comprises a third light-emitting layer located on a side of the charge generation layer thereof close to the base substrate;
a thickness of the second light-emitting layer and a thickness of the third light-emitting layer are larger than a thickness of the first light-emitting layer; and
the charge generation layer of the first sub-pixel and the charge generation layer of the second sub-pixel or the third sub-pixel adjacent to the first sub-pixel are disconnected from each other at least by the portion with the first isolation height in the isolation structure, and the charge generation layer of the second sub-pixel and the charge generation layer of the third sub-pixel are disconnected from each other by the portion with the second isolation height in the isolation structure.

3. The display panel according to claim 1 or 2, wherein
the portion with the first isolation height in the isolation structure comprises an isolation part, which is disposed in at least one of a first sub-pixel region where the first sub-pixel is located and the pixel spacing region between the first sub-pixel and an adjacent sub-pixel;
the portion with the second isolation height in the isolation structure at least comprises an isolation part, which is disposed in the pixel spacing region between the second sub-pixel and the third sub-pixel.

4. The display panel according to claim 3, wherein the portion with the second isolation height in the isolation structure further comprises an isolation part, which is disposed in the pixel spacing region between the second sub-pixel and the first sub-pixel or disposed in the pixel spacing region between the third sub-pixel and the first sub-pixel.

5. The display panel according to any one of claims 1-4, wherein the isolation structure comprises a plurality of pixel region isolation parts respectively located in the plurality of sub-pixel regions, and at least a first pixel region isolation part located in a first sub-pixel region among the plurality of pixel region isolation parts has the first isolation height.

6. The display panel according to claim 5, wherein
the plurality of pixel region isolation parts comprise a second pixel region isolation part and a third pixel region isolation part, which are respectively located in sub-pixel regions where the second sub-pixel and the third sub-pixel are located; and
the second pixel region isolation part and the third pixel region isolation part each have the first isolation height, or at least a portion of the second pixel region isolation part and at least a portion of the third pixel region isolation part have the second isolation height.

7. The display panel according to any one of claims 1-6, wherein the isolation structure comprises inter-pixel isolation parts located between adjacent sub-pixels, and the inter-pixel isolation parts comprise:
a first inter-pixel isolation part, located between the first sub-pixel and the second sub-pixel or located in the pixel spacing region between the first sub-pixel and the third sub-pixel; and
a second inter-pixel isolation part, located in the pixel spacing region between the second sub-pixel and the third sub-pixel.

8. The display panel according to claim 7, wherein the first inter-pixel isolation part and the second inter-pixel isolation part have a same isolation height which is the second isolation height.

9. The display panel according to claim 7, wherein the first inter-pixel isolation part has the first isolation height, and the second inter-pixel isolation part has the second isolation height.

10. The display panel according to claim 7, wherein the first inter-pixel isolation part and the second inter-pixel isolation part are connected to each other or disconnected from each other, and the inter-pixel isolation parts comprise an annular portion in a closed ring shape or an open ring shape, and the light-emitting regions of one or more sub-pixels among the plurality of sub-pixels are surrounded by the annular portion in a direction parallel to a main surface of the base substrate.

11. The display panel according to any one of claims 7-10, wherein at least one of the first inter-pixel isolation part and the second inter-pixel isolation part each comprises a plurality of isolation sub-parts arranged side by side between adjacent sub-pixels along an arrangement direction of the adjacent sub-pixels.

12. The display panel according to any one of claims 1-11, wherein the isolation structure comprises:
a first annular part, surrounding the light-emitting region of a corresponding one sub-pixel among the plurality of sub-pixels in a direction parallel to a main surface of the base substrate; and
a second annular part, located on a side of the first annular part away from the corresponding one sub-pixel and surrounding the first annular part and the corresponding one sub-pixel in a direction parallel to the main surface of the base substrate.

13. The display panel according to any one of claims 1-12, wherein the plurality of sub-pixels comprise a plurality of pixel units arranged in an array and comprise:
a first pixel column, comprising a plurality first sub-pixels arranged in a first direction; and
a second pixel column, comprising a plurality of second sub-pixels and a plurality of third sub-pixels alternately arranged along the first direction, wherein one or more first pixel columns and one or more second pixel columns are alternately arranged along a second direction intersecting with the first direction, wherein each first sub-pixel in the first pixel column as well as one second sub-pixel and one third sub-pixel in the second pixel column are adjacent to each other and constitute one pixel unit,
wherein each of the light-emitting regions of the plurality of sub-pixels is surrounded by a corresponding isolation part in the isolation structure in an arrangement direction of the plurality of sub-pixels.

14. The display panel according to claim 13, wherein
the isolation structure comprises at least one of a plurality of pixel region isolation parts and inter-pixel isolation parts;
the plurality of pixel region isolation parts respectively surround the light-emitting regions of the plurality of sub-pixels in a direction parallel to a main surface of the base substrate;
the inter-pixel isolation parts comprise:
a first inter-pixel isolation part, extending along the first direction and located, in the second direction, between the first pixel column and second pixel column that are adjacent to each other; and
a second inter-pixel isolation part, extending along the second direction and located, in the first direction, between a second sub-pixel and a third sub-pixel that are adjacent to each other.

15. The display panel according to claim 14, wherein the first inter-pixel isolation part continuously extends along the first direction and is connected to a plurality of second inter-pixel isolation parts; or
the first inter-pixel isolation part and the second inter-pixel isolation part are disconnected from each other, and the first inter-pixel isolation part has an opening and comprises a plurality of first inter-pixel isolation sub-parts disconnected from each other, and each first inter-pixel isolation sub-part is located between a corresponding first sub-pixel and an adjacent second sub-pixel and/or between the corresponding first sub-pixel and an adjacent third sub-pixel.

16. The display panel according to claim 15, wherein an orthographic projection of the first sub-pixel on a first reference plane extending along the first direction and an orthographic projection of the second sub-pixel on the first reference plane have a first overlapping portion, and the orthographic projection of the first sub-pixel on the first reference plane and an orthographic projection of the third sub-pixel on the first reference plane have a second overlapping portion;
an orthographic projection of the opening of the first inter-pixel isolation part on the first reference plane is offset from the first overlapping portion and the second overlapping portion, and the first overlapping portion and the second overlapping portion are respectively located in orthographic projections of corresponding first inter-pixel isolation sub-parts on the first reference plane.

17. The display panel according to any one of claims 14-16, wherein an overlapping portion of orthographic projections, on a second reference plane extending along the second direction, of adjacent second and third sub-pixels located in a same second pixel column, is located within an orthographic projection of the second inter-pixel isolation part on the second reference plane.

18. The display panel according to any one of claims 1-17, further comprising a common electrode structure, and the second electrodes of the plurality of sub-pixels share the common electrode structure, wherein the common electrode structure comprises:
a second electrode layer, disposed on a side of the charge generation layer away from the base substrate; and
an auxiliary electrode layer, disposed on a side of the second electrode layer away from the base substrate and electrically connected to the second electrode layer, wherein an orthographic projection of the auxiliary electrode layer on the base substrate overlaps with an orthographic projection of the isolation structure on the base substrate.

19. The display panel according to claim 18, wherein an orthographic projection of at least a portion of the isolation structure on the base substrate is located within the orthographic projection of the auxiliary electrode layer on the base substrate.

20. The display panel according to claim 18 or 19, wherein the second electrode layer comprises portions disconnected at the isolation structure, and the portions of the second electrode layer that are disconnected are electrically connected to each other through the auxiliary electrode layer.

21. The display panel according to any one of claims 18-20, wherein
the auxiliary electrode layer comprises at least one of a first auxiliary electrode layer and a second auxiliary electrode layer;
the first auxiliary electrode layer extends in the pixel region and the pixel spacing region, and an orthographic projection of the second electrode layer on the base substrate is located within an orthographic projection of the first auxiliary electrode layer on the base substrate; and
an orthographic projection of the second auxiliary electrode layer on the base substrate overlaps with an orthographic projection of at least a portion of the isolation structure on the base substrate, and is offset from an orthographic projection of at least a portion of the light-emitting regions of the plurality of sub-pixels on the base substrate.

22. The display panel according to any one of claims 1-21, comprising a light-emitting stacked layer, the light-emitting stacked layer comprising:
a first light-emitting stack part, at least comprising the charge generation layer of the first sub-pixel;
a second light-emitting stack part, at least comprising the charge generation layer of the second sub-pixel;
a third light-emitting stack part, at least comprising the charge generation layer of the third sub-pixel; and
a dummy stack part, located between adjacent light-emitting stack parts among the first light-emitting stack part, the second light-emitting stack part and the third light-emitting stack part,
wherein the first light-emitting stack part, the second light-emitting stack part and the third light-emitting stack part each comprise a first stack sub-part and a second stack sub-part; in each light-emitting stack part, the first stack sub-part is located in the light-emitting region defined by a sub-pixel opening of the pixel definition structure, and the second stack sub-part is located on a side, away from the base substrate, of a portion of the pixel definition structure that defines the sub-pixel opening.

23. The display panel according to claim 22, wherein the charge generation layers of the first stack sub-part and the second stack sub-part of the first light-emitting stack part are disconnected from each other by a first pixel region isolation part of the isolation structure.

24. The display panel according to claim 23, wherein a height difference between the charge generation layers of the first stack sub-part and the second stack sub-part of the first light-emitting stack part in a direction perpendicular to a main surface of the base substrate is defined by the first isolation height.

25. The display panel according to claim 22, wherein the charge generation layers of the first stack sub-part and the second stack sub-part of the first light-emitting stack part are connected to each other.

26. The display panel according to claim 22, wherein
the charge generation layers of the first stack sub-part and the second stack sub-part of the second light-emitting stack part are connected to each other or disconnected from each other;
the charge generation layers of the first stack sub-part and the second stack sub-part of the third light-emitting stack part are connected to each other or disconnected from each other.

27. The display panel according to any one of claims 22-26, wherein the dummy stack part comprises:
a first dummy stack part, located in the pixel spacing region between the first sub-pixel and the second sub-pixel adjacent to each other and comprising a first dummy charge generation layer, wherein the first dummy charge generation layer is disconnected from the charge generation layers in the first light-emitting stack part and the second light-emitting stack part by a first inter-pixel isolation part of the isolation structure.

28. The display panel according to claim 27, wherein a height difference between the first dummy charge generation layer and the charge generation layer of the second stack sub-part in the first light-emitting stack part or in the second light-emitting stack part in a direction perpendicular to a main surface of the base substrate is defined by the first isolation height or the second isolation height.

29. The display panel according to any one of claims 22-28, wherein the dummy stack part comprises:
a second dummy stack part, located in the pixel spacing region between the second sub-pixel and the third sub-pixel adjacent to each other and comprising a second dummy charge generation layer, wherein the second dummy charge generation layer is disconnected from the charge generation layers in the second light-emitting stack part and the third light-emitting stack part by a second inter-pixel isolation part of the isolation structure.

30. The display panel according to claim 29, wherein a height difference between the second dummy charge generation layer and the charge generation layer of the second stack sub-part in the second light-emitting stack part or in the third light-emitting stack part in a direction perpendicular to a main surface of the base substrate is defined by the second isolation height.

31. The display panel according to any one of claims 22-30, wherein at least one dummy stack part is connected to a dummy electrode, and the dummy electrode and the first electrode are arranged in a same electrode layer and are electrically isolated from each other.

32. The display panel according to any one of claims 1-31, wherein
the pixel definition structure at least comprises a first pixel definition layer and a second pixel definition layer, wherein the second pixel definition layer is located on a side of the first pixel definition layer away from the base substrate and comprises an extension part which extends beyond an edge of the first pixel definition layer in a direction parallel to a main surface of the base substrate, and an undercut structure is disposed between the extension part and a material layer located at a side of the first pixel definition layer close to the base substrate,
the isolation structure at least comprises the extension part and the undercut structure.

33. The display panel according to claim 32, further comprising:
a planarization structure, disposed on the base substrate, wherein a plurality of first electrodes of the plurality of sub-pixels are located on a side of the planarization structure away from the base substrate; the pixel definition structure is located on a side of the planarization structure and the plurality of first electrodes away from the base substrate, and the plurality of sub-pixel openings respectively expose portions of the plurality of first electrodes,
wherein the pixel definition structure further comprises an isolation opening, which is located in the pixel spacing region between adjacent sub-pixels and exposes a portion of a surface of the planarization structure.

34. The display panel according to claim 33, wherein the pixel definition structure comprises:
a sub-pixel opening definition part, defining a sub-pixel opening and serving as a pixel region isolation part of the isolation structure, wherein the sub-pixel opening definition part comprises a first extension part, and a first undercut structure is disposed between the first extension part and the first electrode; and
an isolation opening definition part, defining the isolation opening and serving as an inter-pixel isolation part of the isolation structure, wherein the isolation opening definition part comprises a second extension part, and a second undercut structure is disposed between the second extension part and the planarization structure.

35. The display panel according to claim 34, wherein the planarization structure has a recess which is in spatial communication with the isolation opening, and the second isolation height is defined by a sum of a depth of the isolation opening and a depth of the recess.

36. The display panel according to claim 34 or 35, further comprising a dummy electrode, located between the planarization structure and the isolation opening definition part, wherein the dummy electrode has an electrode opening which is in spatial communication with the isolation opening, and the second isolation height is defined by a sum of a depth of the isolation opening and a depth of the electrode opening.

37. The display panel according to claim 32, wherein the pixel definition structure further comprises:
a pixel definition body layer, located at a side of the first pixel definition layer close to the base substrate, defining the plurality of sub-pixel openings, and comprising a first body part located between the first sub-pixel and the second sub-pixel adjacent to the first sub-pixel or between the first sub-pixel and the third sub-pixel adjacent to the first sub-pixel, and a second body part located between the second sub-pixel and the third sub-pixel,
wherein the first pixel definition layer and the second pixel definition layer comprise a first isolation part and a second isolation part respectively located on the first body part and the second body part, each of the first isolation part and the second isolation part comprises the extension part of the second pixel definition layer, and the undercut structure is disposed between the extension part and the pixel definition body layer.

38. The display panel according to claim 37, wherein
the first isolation part has a first isolation opening which exposes a portion of a surface of the first body part, and the first isolation height is defined by a depth of the first isolation opening; and
the second isolation part has a second isolation opening which exposes a portion of a surface of the second body part, and the second body part has a body recess which is in spatial communication with the second isolation opening, and the second isolation height is defined by a sum of a depth of the second isolation opening and a depth of the body recess.

39. the display panel according to claim 32, wherein the pixel definition structure comprises a plurality of pixel definition layers stacked in sequence in a direction perpendicular to a main surface of the base substrate, and the second pixel definition layer is a farthest layer from the base substrate among the plurality of pixel definition layers, and the pixel definition structure comprises a sub-pixel opening definition part and an isolation opening definition part;
in the sub-pixel opening definition part, sidewalls of the plurality of pixel definition layers are connected to each other and together constitute a sidewall defining the sub-pixel opening;
the isolation opening definition part comprises the extension part and the undercut structure that constitute the isolation structure.

40. The display panel according to claim 39, wherein the pixel definition structure comprises:
a first pixel stack part, located between the first sub-pixel and the second sub-pixel and having a first recess, wherein the first recess comprises one or more first isolation openings; and
a second pixel stack part, located between the second sub-pixel and the third sub-pixel and having a second recess, wherein the second recess comprises one or more second isolation openings;
wherein each of the first pixel stack part and the second pixel stack part has an edge portion being served as a sub-pixel opening definition part to define a portion of a corresponding sub-pixel opening, and has a portion defining a recess being served as an isolation opening definition part, and the isolation opening definition part comprises an extension part of one or more pixel definition layers and one or more undercut structures.

41. The display panel according to claim 40, wherein a depth of the first recess is smaller than a depth of the second recess.

42. The display panel according to claim 32, wherein the pixel definition structure comprises a plurality of first pixel definition layers and a plurality of second pixel definition layers alternately stacked in a direction perpendicular to a main surface of the base substrate, and comprises a plurality of undercut structures, and wherein each of the plurality of undercut structures is located at a side of an extension part of a corresponding second pixel definition layer close to the base substrate.

43. The display panel according to claim 32, wherein the first pixel definition layer and the second pixel definition layer comprise different materials.

44. The display panel according to claim 43, wherein at least one of the first pixel definition layer and the second pixel definition layer comprises an inorganic material.

45. The display panel according to claim 43 or 44, wherein
one of the first pixel definition layer and the second pixel definition layer comprises aluminum oxide, and the other one of the first pixel definition layer and the second pixel definition layer comprises silicon nitride or silicon oxide; or
one of the first pixel definition layer and the second pixel definition layer comprises silicon oxide, and the other one of the first pixel definition layer and the second pixel definition layer comprises silicon carbonitride; or
one of the first pixel definition layer and the second pixel definition layer comprises titanium oxide, and the other one of the first pixel definition layer and the second pixel definition layer comprises niobium oxide.

46. The display panel according to claim 32, wherein a width of the undercut structure in a direction parallel to a main surface of the base substrate ranges from 0.05 µm to 0.5 µm.

47. The display panel according to any one of claims 1-46, wherein the first isolation height ranges from 300 angstroms to 1250 angstroms, and the second isolation height ranges from 600 angstroms to 1650 angstroms.

48. A display device, comprising the display panel according to any one of claims 1-47.

49. A manufacturing method of a display panel, wherein the display panel has a pixel region comprising a plurality of sub-pixel regions and a pixel spacing region located between adjacent sub-pixel regions, and the manufacturing method comprises:
providing a base substrate;
forming a plurality of sub-pixels on the base substrate, wherein the plurality of sub-pixels are respectively located in the plurality of sub-pixel regions, each of the plurality of sub-pixels comprises a light-emitting device and a sub-pixel circuit configured to drive the light-emitting device to emit light, each light-emitting device comprises a first electrode, a charge generation layer and a second electrode which are sequentially stacked, and the plurality of sub-pixels comprise a first sub-pixel, a second sub-pixel and a third sub-pixel which are adjacent to each other and configured to display different colors;
forming a pixel definition structure having a plurality of sub-pixel openings to define light-emitting regions of the plurality of sub-pixels, wherein each of the light-emitting devices has at least a portion located in a corresponding one of the plurality of sub-pixel openings; and
forming an isolation structure in at least one of the pixel region and the pixel spacing region, wherein the isolation structure comprises a portion with a first isolation height and a portion with a second isolation height, and the second isolation height is larger than the first isolation height, and wherein charge generation layers of adjacent sub-pixels among the plurality of sub-pixels are disconnected from each other by the isolation structure.

50. The manufacturing method of the display panel according to claim 49, wherein forming the pixel definition structure and the isolation structure comprises:
sequentially forming a first pixel definition layer and a second pixel definition layer on a side of a planarization structure on the base substrate;
performing a first removal process to remove a portion of the second pixel definition layer, and forming an opening in the second pixel definition layer, wherein the opening is defined by an extension part of the second pixel definition layer and exposes a portion of a surface of the first pixel definition layer; and
performing a second removal process to remove a portion of the first pixel definition layer exposed by the opening and a portion of the first pixel definition layer covered by the extension part of the second pixel definition layer, and an undercut structure is formed at a side of the extension part close to the base substrate, wherein the isolation structure comprises the extension part and the undercut structure.

51. The manufacturing method of the display panel according to claim 50, wherein after performing the second removal process, an isolation opening that exposes a portion of a surface of the planarization structure is formed in the first pixel definition layer and the second pixel definition layer.

52. The manufacturing method of the display panel according to claim 51, further comprising:
performing a third removal process to remove a portion of the planarization structure exposed by the isolation opening, and forming a recess in the planarization structure.

53. The manufacturing method of the display panel according to claim 50, wherein forming the pixel definition structure further comprises:
forming a pixel definition body layer before forming the first pixel definition layer, wherein after performing the second removal process, a plurality of openings in the first pixel definition layer and the second pixel definition layer expose a portion of a surface of the pixel definition body layer; and
performing a third removal process to remove a portion of the pixel definition body layer exposed by part of the plurality of openings, so as to form a recess in a partial region of the pixel definition body layer.

54. The manufacturing method of the display panel according to claim 50, wherein forming the pixel definition structure and the isolation structure comprises:
sequentially forming a plurality of pixel definition layers on the base substrate;
performing a first removal process on a first pixel stack part of the plurality of pixel definition layers located in a first pixel spacing region, so as to remove portions of at least two pixel definition layers among the plurality of pixel definition layers, and forming a first recess comprising one or more first isolation openings in the first pixel stack part; and
performing a second removal process on a second pixel stack part of the plurality of pixel definition layers located in a second pixel spacing region, so as to remove portions of at least three pixel definition layers among the plurality of pixel definition layers, and forming a second recess comprising one or more second isolation openings in the second pixel stack part.
